# EUROPEAN PATENT APPLICATION

(11) **EP 4 481 824 A1**
(43) Date of publication of application: **25.12.2024**
(21) Application number: 22926122.7
(22) Date of filing: 27.12.2022
(51) Int. Cl.: H01L 27/146, H04N 25/76

(54) **SOLID-STATE IMAGING DEVICE**

(30) Priority: 14.02.2022 JP 2022020875
(71) Applicant: Sony Semiconductor Solutions Corporation, Atsugi-shi, Kanagawa 243-0014 (JP)
(72) Inventor: KITANO, Yoshiaki, Atsugi-shi, Kanagawa 243-0014 (JP); OISHI, Hidetoshi, Atsugi-shi, Kanagawa 243-0014 (JP); TAKAHASHI, Naohiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/048317
(87) International publication number: WO 2023/153108

(57) **Abstract**

A solid-state imaging device includes: a pixel including a photoelectric conversion element that is disposed on a side of a first surface of a base and converts light into electric charge, the side of the first surface being a light incident side; a pixel separation region formed in a thickness direction of the base, the pixel separation region extending in a first direction and a second direction to surround a periphery of a side surface of the pixel as viewed from a side of a second surface of the base, the pixel separation region separating the pixel from another region; a transistor disposed on the side of the second surface of the base at a position corresponding to the pixel, the base having a periphery surrounded by the pixel separation region, the transistor having a direction of a gate length being oblique to the first direction or the second direction; and a FD region, a transfer gate electrode, or a base coupling section disposed at the position corresponding to the pixel, the FD region, the transfer gate electrode, or the base coupling section being disposed in a direction of a gate width of the transistor that is on the side of the second surface of the base, the transfer gate electrode being of a transfer transistor.

## Description

### Technical Field

The present disclosure relates to a solid-state imaging device.

### Background Art

PTL 1 discloses a solid-state imaging device. In the solid-state imaging device, one pixel is formed in a region of which a periphery is surrounded by an inter-pixel light-blocking wall. At a position corresponding to the one pixel, a photodiode is formed on a side of a back surface of a semiconductor substrate, and a pixel circuit is formed on a side of a front surface of the semiconductor substrate. The pixel circuit is constructed by an amplification transistor, a selection transistor, a floating diffusion conversion gain switching transistor, and a reset transistor.

### Citation List

### Patent Literature

PTL 1: Japanese Unexamined Patent Application Publication No. 2018-148116

### Summary of the Invention

A solid-state imaging device involves, at a position corresponding to one pixel, a large area of an element separator that separates a plurality of transistors, a floating diffusion region, a transfer transistor, and a well contact from each other. The plurality of transistors constructs a pixel circuit. This makes it difficult, in line with miniaturization of a pixel, to secure an area in which the transistors are disposed. Therefore, a solid-state imaging device is desired to have an increased area in which a transistor is disposed and have improved performance of the transistor.

A solid-state imaging device according to a first embodiment of the present disclosure includes: a first pixel including a first photoelectric conversion element that is disposed on a side of a first surface of a base and converts light into electric charge, the side of the first surface being a light incident side; a pixel separation region formed in a thickness direction of the base, the pixel separation region extending in a first direction and a second direction intersecting the first direction to surround a periphery of a side surface of the first pixel as viewed from a side of a second surface of the base, the pixel separation region electrically and optically separating the first pixel from another region, the side of the second surface being a side opposite to the first surface; a first transistor disposed on the side of the second surface of the base at a position corresponding to the first pixel, the base having a periphery surrounded by the pixel separation region, the first transistor having a direction of a gate length being oblique to the first direction or the second direction; and a first floating diffusion region, a first transfer gate electrode, or a first base coupling section disposed at the position corresponding to the first pixel, the first floating diffusion region, the first transfer gate electrode, or the first base coupling section being disposed in a direction of a gate width of the first transistor that is on the side of the second surface of the base, the first transfer gate electrode being of a first transfer transistor that transfers the electric charge from the first pixel to the first floating diffusion region, the first base coupling section supplying the base with a voltage.

A solid-state imaging device according to a second embodiment of the present disclosure includes: a first pixel including a first photoelectric conversion element that is disposed on a side of a first surface of a base and converts light into electric charge, the side of the first surface being a light incident side; a pixel separation region formed in a thickness direction of the base, the pixel separation region extending in a first direction and a second direction intersecting the first direction to surround a periphery of a side surface of the first pixel as viewed from a side of a second surface of the base, the pixel separation region electrically and optically separating the first pixel from another region, the side of the second surface being a side opposite to the first surface; a first transistor disposed on the side of the second surface of the base at a position corresponding to the first pixel, the base having a periphery surrounded by the pixel separation region, the first transistor having a direction of a gate length being oblique to the first direction or the second direction; a second transistor disposed on the side of the second surface of the base at the position corresponding to the first pixel, the base having the periphery surrounded by the pixel separation region, the second transistor having a direction of a gate length being oblique to the first direction or the second direction, the second transistor being electrically coupled in series to the first transistor; and a first floating diffusion region, a first transfer gate electrode, or a first base coupling section disposed at the position corresponding to the first pixel, the first floating diffusion region, the first transfer gate electrode, or the first base coupling section being disposed in a direction of a gate width of the first transistor and the second transistor that are on the side of the second surface of the base, the first transfer gate electrode being of a first transfer transistor that transfers the electric charge from the first pixel to the first floating diffusion region, the first base coupling section supplying the base with a voltage.

A solid-state imaging device according to a third embodiment of the present disclosure includes: a plurality of pixels each arranged to include a photoelectric conversion element that is disposed on a side of a first surface of a base and converts light into electric charge, the side of the first surface being a light incident side; a pixel separation region formed in a thickness direction of the base and surrounding a periphery of a side surface of each of the plurality of pixels, the pixel separation region electrically and optically separating the plurality of pixels from each other; a transistor disposed on a side of the second surface of the base at a position corresponding to each of the pixels, the base having a periphery surrounded by the pixel separation region, the transistor having a direction of a gate length being oblique to an arrangement direction of the pixels; and a floating diffusion region, a transfer gate electrode, or a first base coupling section disposed at the position corresponding to each of the pixels, the floating diffusion region, the transfer gate electrode, or the first base coupling section being disposed in a direction of a gate width of the transistor that is on the side of the second surface of the base, the transfer gate electrode being of a transfer transistor that transfers the electric charge from each of the pixels to the floating diffusion region, the first base coupling section supplying the base with a voltage.

A solid-state imaging device according to a fourth embodiment of the present disclosure includes: a first pixel including a first photoelectric conversion element that is disposed on a side of a first surface of a base and converts light into electric charge, the side of the first surface being a light incident side; a second pixel being adjacent to the first pixel, and including a second photoelectric conversion element that is disposed on the side of the first surface of the base and converts light into electric charge; a pixel separation region disposed between the first pixel and the second pixel, and formed in a thickness direction of the base, the pixel separation region electrically and optically separating the first pixel and the second pixel from each other; a first transistor disposed on a side of the second surface of the base at a position corresponding to the first pixel, the first transistor having a direction of a gate length being oblique to an arrangement direction of the first pixel and the second pixel; a second transistor disposed on the side of the second surface of the base at a position corresponding to the second pixel, the second transistor having a direction of a gate length being oblique to the arrangement direction of the first pixel and the second pixel; and a shared coupling section electrically coupled directly to one of a pair of main electrodes of the first transistor and one of a pair of main electrodes of the second transistor, the shared coupling section supplying a power supply voltage to the one of the pair of main electrodes of the first transistor and the one of the pair of main electrodes of the second transistor.

### Brief Description of the Drawings

[FIG. 1] FIG. 1 is a circuit diagram illustrating pixels and a pixel circuit of a solid-state imaging device according to a first embodiment of the present disclosure.
[FIG. 2] FIG. 2 is an explanatory planar configuration diagram of a basic configuration of a transistor constructing the pixel circuit illustrated in FIG. 1.
[FIG. 3] FIG. 3 is a specific planar configuration diagram of the pixel circuit illustrated in FIG. 1.
[FIG. 4] FIG. 4 is a vertical cross-sectional configuration diagram of a portion of the pixels and the pixel circuit illustrated in FIG. 1 (a cross-sectional view sectioned along a section line A-A illustrated in FIG. 3).
[FIG. 5] FIG. 5 is an explanatory specific planar configuration diagram of a coupling state of wiring of the pixel circuit illustrated in FIG. 3.
[FIG. 6] FIG. 6 is an explanatory first step cross-sectional view corresponding to FIG. 4 of a manufacturing method of the solid-state imaging device according to the first embodiment.
[FIG. 7] FIG. 7 is a second step cross-sectional view.
[FIG. 8] FIG. 8 is a third step cross-sectional view.
[FIG. 9] FIG. 9 is a fourth step cross-sectional view.
[FIG. 10] FIG. 10 is a fifth step cross-sectional view.
[FIG. 11] FIG. 11 is a sixth step cross-sectional view.
[FIG. 12] FIG. 12 is a specific planar configuration diagram corresponding to FIG. 3 of a pixel circuit of a solid-state imaging device according to a second embodiment of the present disclosure.
[FIG. 13] FIG. 13 is a vertical cross-sectional configuration diagram of a portion of pixels and the pixel circuit illustrated in FIG. 12 (a cross-sectional view sectioned along a section line B-B illustrated in FIG. 12).
[FIG. 14] FIG. 14 is a circuit diagram corresponding to FIG. 1 illustrating pixels and a pixel circuit of a solid-state imaging device according to a third embodiment of the present disclosure.
[FIG. 15] FIG. 15 is a specific planar configuration diagram corresponding to FIG. 3 of the pixel circuit illustrated in FIG. 14.
[FIG. 16] FIG. 16 is a specific planar configuration diagram corresponding to FIG. 3 of a portion of a pixel circuit of a solid-state imaging device according to a fourth embodiment of the present disclosure.
[FIG. 17] FIG. 17 is a vertical cross-sectional configuration diagram of a portion of the pixel circuit illustrated in FIG. 16 (a cross-sectional view sectioned along a section line C-C illustrated in FIG. 16).
[FIG. 18] FIG. 18 is a vertical cross-sectional configuration diagram of a portion of the pixel circuit illustrated in FIG. 16 (a cross-sectional view sectioned along a section line D-D illustrated in FIG. 16).
[FIG. 19] FIG. 19 is a specific planar configuration diagram corresponding to FIG. 16 of a portion of a pixel circuit of a solid-state imaging device according to a first modification example of the fourth embodiment.
[FIG. 20] FIG. 20 is a vertical cross-sectional configuration diagram of a portion of the pixel circuit illustrated in FIG. 19 (a cross-sectional view sectioned along a section line E-E illustrated in FIG. 19).
[FIG. 21] FIG. 21 is a vertical cross-sectional configuration diagram of a portion of the pixel circuit illustrated in FIG. 19 (a cross-sectional view sectioned along a section line F-F illustrated in FIG. 19).
[FIG. 22] FIG. 22 is a specific planar configuration diagram corresponding to FIG. 16 of a portion of a pixel circuit of a solid-state imaging device according to a second modification example of the fourth embodiment.
[FIG. 23] FIG. 23 is a vertical cross-sectional configuration diagram of a portion of the pixel circuit illustrated in FIG. 22 (a cross-sectional view sectioned along a section line G-G illustrated in FIG. 22).
[FIG. 24] FIG. 24 is a vertical cross-sectional configuration diagram of a portion of the pixel circuit illustrated in FIG. 22 (a cross-sectional view sectioned along a section line H-H illustrated in FIG. 22).
[FIG. 25] FIG. 25 is a specific planar configuration diagram corresponding to FIG. 3 of a portion of a pixel circuit of a solid-state imaging device according to a fifth embodiment of the present disclosure.
[FIG. 26] FIG. 26 is a vertical cross-sectional configuration diagram of a portion of the pixel circuit illustrated in FIG. 25 (a cross-sectional view sectioned along a section line I-I illustrated in FIG. 25).
[FIG. 27] FIG. 27 is an explanatory specific planar configuration diagram corresponding to FIG. 5 of a coupling state of wiring of a pixel circuit of a solid-state imaging device according to a sixth embodiment of the present disclosure.
[FIG. 28] FIG. 28 is an explanatory specific planar configuration diagram corresponding to FIG. 5 of a pixel circuit and a coupling state of wiring of a solid-state imaging device according to a seventh embodiment of the present disclosure.
[FIG. 29] FIG. 29 is a specific planar configuration diagram corresponding to FIG. 3 of a pixel circuit of a solid-state imaging device according to an eighth embodiment of the present disclosure.
[FIG. 30] FIG. 30 is a vertical cross-sectional configuration diagram of a portion of pixels and the pixel circuit illustrated in FIG. 29 (a cross-sectional view sectioned along a section line J-J illustrated in FIG. 29).
[FIG. 31] FIG. 31 is an explanatory specific planar configuration diagram corresponding to FIG. 5 of a coupling state of wiring of the pixel circuit illustrated in FIG. 29.
[FIG. 32] FIG. 32 is a specific planar configuration diagram corresponding to FIG. 3 of a pixel circuit of a solid-state imaging device according to a ninth embodiment of the present disclosure.
[FIG. 33] FIG. 33 is a vertical cross-sectional configuration diagram of a portion of pixels and the pixel circuit illustrated in FIG. 32 (a cross-sectional view sectioned along a section line K-K illustrated in FIG. 32).
[FIG. 34] FIG. 34 is an explanatory planar configuration diagram corresponding to FIG. 33 of an arrangement layout of pixels and pixel circuits of a solid-state imaging device according to a first modification example of a tenth embodiment.
[FIG. 35] FIG. 35 is an explanatory planar configuration diagram corresponding to FIG. 33 of an arrangement layout of pixels and pixel circuits of a solid-state imaging device according to a second modification example of the tenth embodiment.
[FIG. 36] FIG. 36 is an explanatory planar configuration diagram corresponding to FIG. 33 of an arrangement layout of pixels and pixel circuits of a solid-state imaging device according to a third modification example of the tenth embodiment.
[FIG. 37] FIG. 37 is an explanatory planar configuration diagram corresponding to FIG. 33 of an arrangement layout of pixels and pixel circuits of a solid-state imaging device according to a fourth modification example of the tenth embodiment.
[FIG. 38] FIG. 38 is a vertical cross-sectional configuration diagram corresponding to FIG. 4 of a portion of pixels and a pixel circuit according to an eleventh embodiment of the present disclosure.
[FIG. 39] FIG. 39 is a circuit diagram illustrating pixels and pixel circuits of a solid-state imaging device according to a twelfth embodiment of the present disclosure.
[FIG. 40] FIG. 40 is a specific planar configuration diagram of the pixel circuits illustrated in FIG. 39.
[FIG. 41] FIG. 41 is a vertical cross-sectional configuration diagram of a portion of the pixels and the pixel circuits illustrated in FIG. 40 (a cross-sectional view sectioned along a section line L-L illustrated in FIG. 40).
[FIG. 42] FIG. 42, which schematically illustrates FIG. 41, is an explanatory first step cross-sectional view of a manufacturing method of the solid-state imaging device according to the twelfth embodiment.
[FIG. 43] FIG. 43 is a second step cross-sectional view.
[FIG. 44] FIG. 44 is a third step cross-sectional view.
[FIG. 45] FIG. 45 is a fourth step cross-sectional view.
[FIG. 46] FIG. 46 is a fifth step cross-sectional view.
[FIG. 47] FIG. 47 is a sixth step cross-sectional view.
[FIG. 48] FIG. 48 is a seventh step cross-sectional view.
[FIG. 49] FIG. 49 is a vertical cross-sectional configuration diagram corresponding to FIG. 42 of a portion of pixels and a pixel circuit of a solid-state imaging device according to a thirteenth embodiment of the present disclosure.
[FIG. 50] FIG. 50 is an explanatory first step cross-sectional view corresponding to FIG. 42 of a manufacturing method of the solid-state imaging device according to the thirteenth embodiment.
[FIG. 51] FIG. 51 is a second step cross-sectional view.
[FIG. 52] FIG. 52 is a specific planar configuration diagram corresponding to FIG. 40 of pixel circuits of a solid-state imaging device according to a fourteenth embodiment of the present disclosure.
[FIG. 53] FIG. 53 is a specific planar configuration diagram corresponding to FIG. 40 of pixel circuits of a solid-state imaging device according to a fifteenth embodiment of the present disclosure.
[FIG. 54] FIG. 54 is a specific planar configuration diagram corresponding to FIG. 40 of pixel circuits of a solid-state imaging device according to a sixteenth embodiment of the present disclosure.
[FIG. 55] FIG. 55 is a planar configuration diagram corresponding to FIG. 40 illustrating a basic arrangement configuration of pixel circuits of a solid-state imaging device according to a seventeenth embodiment of the present disclosure.
[FIG. 56] FIG. 56 is a planar configuration diagram corresponding to FIG. 55 illustrating a specific arrangement configuration of the pixel circuits of the solid-state imaging device according to the seventeenth embodiment.
[FIG. 57] FIG. 57 is a planar configuration diagram corresponding to FIG. 55 illustrating a specific arrangement configuration of pixel circuits of a solid-state imaging device according to a modification example of the seventeenth embodiment.
[FIG. 58] FIG. 58 is a planar configuration diagram illustrating a specific arrangement configuration of pixels, color filters, and optical lenses of a solid-state imaging device according to an eighteenth embodiment of the present disclosure.
[FIG. 59] FIG. 59 is a planar configuration diagram illustrating the pixels, pixel circuits, and a coupling state of wiring of the solid-state imaging device according to the eighteenth embodiment.
[FIG. 60] FIG. 60 is a planar configuration diagram illustrating the coupling state of the wiring, the pixel circuits, and the pixels at which the color filter of a particular color is disposed in the solid-state imaging device according to the eighteenth embodiment.
[FIG. 61] FIG. 61 is a block diagram depicting an example of schematic configuration of a vehicle control system.
[FIG. 62] FIG. 62 is a diagram of assistance in explaining an example of installation positions of an outside-vehicle information detecting section and an imaging section.

### Modes for Carrying Out the Invention

Hereinafter, detailed description is given of embodiments of the present disclosure with reference to the drawings. It is to be noted that the description is given in the following order.

### 1. First Embodiment

A first embodiment describes an example in which the present technology is applied to a solid-state imaging device. The first embodiment describes, in detail, a circuit configuration, a planar configuration, a vertical cross-sectional configuration of pixels and a pixel circuit of the solid-state imaging device, and a manufacturing method of the solid-state imaging device.

### 2. Second Embodiment

A second embodiment describes a first example in which a configuration of transistors of the pixel circuit is changed in the solid-state imaging device according to the first embodiment.

### 3. Third Embodiment

A third embodiment describes a second example in which the configuration of the transistors of the pixel circuit is changed in the solid-state imaging device according to the first embodiment.

### 4. Fourth Embodiment

A fourth embodiment describes an example in which a configuration of a gate electrode of a transfer transistor of the pixel is changed in the solid-state imaging device according to any of the first embodiment to the third embodiment. The fourth embodiment further describes some modification examples.

### 5. Fifth Embodiment

A fifth embodiment describes a first example in which a planar layout configuration of the transistors of the pixel circuit is changed in the solid-state imaging device according to any of the first embodiment to the fourth embodiment.

### 6. Sixth Embodiment

A sixth embodiment describes a second example in which the planar layout configuration of the transistors of the pixel circuit is changed in the solid-state imaging device according to any of the first embodiment to the fourth embodiment.

### 7. Seventh Embodiment

A seventh embodiment describes a third example in which the planar layout configuration of the transistors of the pixel circuit is changed in the solid-state imaging device according to any of the first embodiment to the fourth embodiment.

### 8. Eighth Embodiment

An eighth embodiment describes an example in which a configuration of shared coupling sections of the pixel circuit is changed in the solid-state imaging device according to any of the first embodiment to the seventh embodiment.

### 9. Ninth Embodiment

A ninth embodiment describes an example in which a coupling configuration of wiring of the pixel circuit is changed in the solid-state imaging device according to any of the first embodiment to the seventh embodiment.

### 10. Tenth Embodiment

A tenth embodiment describes a fourth example in which the planar layout configuration of the transistors of the pixel circuit is changed in the solid-state imaging device according to the fifth embodiment. The tenth embodiment further describes some modification examples.

### 11. Eleventh Embodiment

An eleventh embodiment describes an example in which a configuration of an element separation region of the pixel circuit is changed in the solid-state imaging device according to any of the first embodiment to the tenth embodiment.

### 12. Twelfth Embodiment

A twelfth embodiment describes an example in which a configuration of supply of a power supply voltage is changed in the solid-state imaging device according to any of the first embodiment to the eleventh embodiment. The twelfth embodiment describes, in detail, the circuit configuration, the planar configuration, and the vertical cross-sectional configuration of the pixels and the pixel circuit of the solid-state imaging device, and the manufacturing method of the solid-state imaging device.

### 13. Thirteenth Embodiment

A thirteenth embodiment describes an example in which the configuration of the shared coupling sections of the pixel circuit is changed in the solid-state imaging device according to the twelfth embodiment. The thirteenth embodiment also describes the manufacturing method of the solid-state imaging device.

### 14. Fourteenth Embodiment

A fourteenth embodiment describes a first example in which an arrangement layout configuration of the shared coupling sections of the pixel circuit is changed in the solid-state imaging device according to the twelfth embodiment or the thirteenth embodiment.

### 15. Fifteenth Embodiment

A fifteenth embodiment describes a second example in which the arrangement layout configuration of the shared coupling sections of the pixel circuit is changed in the solid-state imaging device according to the twelfth embodiment or the thirteenth embodiment.

### 16. Sixteenth Embodiment

A sixteenth embodiment describes a third example in which the arrangement layout configuration of the shared coupling sections of the pixel circuit is changed in the solid-state imaging device according to the twelfth embodiment or the thirteenth embodiment.

### 17. Seventeenth Embodiment

A seventeenth embodiment describes a fourth example in which the arrangement layout configuration of the shared coupling sections of the pixel circuit is changed in the solid-state imaging device according to the twelfth embodiment or the thirteenth embodiment. Further, the seventeenth embodiment also describes a modification example.

### 18. Eighteenth Embodiment

An eighteenth embodiment describes a practical application example of the solid-state imaging device according to the twelfth embodiment or the thirteenth embodiment. The eighteenth embodiment describes a planar layout configuration of the pixels and the pixel circuit, a planar layout configuration of color filters, and a planar layout configuration of optical lenses.

### 19. Example of Practical Application to Mobile Body

Description is given of an example in which the present technology is applied to a vehicle control system that is an example of a mobile body control system.

### 20. Other Embodiments

### <1. First Embodiment>

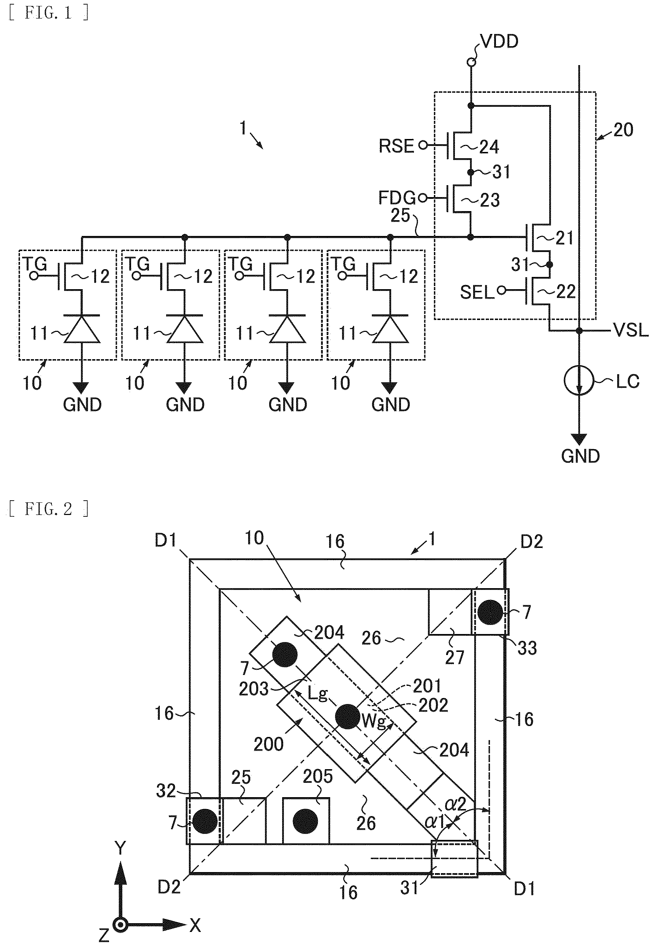

Description is given of a solid-state imaging device 1 according to the first embodiment of the present disclosure with reference to FIGs. 1 to 11.

Here, an arrow-X direction illustrated as appropriate in the drawings indicates one planar direction of the solid-state imaging device 1 placed on a plane for convenience. An arrow-Y direction indicates another planar direction orthogonal to the arrow-X direction. In addition, an arrow-Z direction indicates an upward direction orthogonal to the arrow-X direction and the arrow-Y direction. That is, the arrow-X direction, the arrow-Y direction, and the arrow-Z direction exactly coincide with an X-axis direction, a Y-axis direction, and a Z-axis direction, respectively, of a three-dimensional coordinate system.

It is to be noted that these directions are each illustrated to aid understanding of description, and are not intended to limit directions used in the present technology.

### [Configuration of Solid-State Imaging Device 1]

### (1) Circuit Configuration of Pixel 10 and Pixel Circuit 20 of Solid-State Imaging Device 1

FIG. 1 illustrates an example of a circuit configuration of pixels 10 and a pixel circuit 20 constructing the solid-state imaging device 1 according to the first embodiment.

One pixel 10 includes a series circuit of a photoelectric conversion element (a photodiode) 11 and a transfer transistor 12. Here, four pixels 10 are configured as a unit pixel (BP).

The photoelectric conversion element 11 converts, into electric charge (an electric signal), light incident from the outside of the solid-state imaging device 1.

The transfer transistor 12 includes a transfer gate electrode and a pair of main electrodes. One main electrode of the pair of main electrodes is coupled to the photoelectric conversion element 11. Another main electrode thereof is coupled to the pixel circuit 20 through a floating diffusion region (hereinafter, simply referred to as an "FD region") 25. The transfer gate electrode is coupled to an unillustrated horizontal signal line. A control signal TG is inputted to the transfer gate electrode from the horizontal signal line.

Here, the pixel circuit 20 is disposed for every unit pixel. That is, one pixel circuit 20 is disposed for four pixels 10. The pixel circuit 20 performs signal processing on the electric charge converted from the light in the pixel 10.

In the first embodiment, the pixel circuit 20 is constructed to include four transistors, i.e., a first transistor to a fourth transistor.

Here, the first transistor is an amplification transistor 21 including a gate electrode and a pair of main electrodes. The second transistor is a selection transistor 22 including a gate electrode and a pair of main electrodes. The third transistor is a floating diffusion conversion gain switching transistor (hereinafter, simply referred to as an "FD conversion gain switching transistor") 23 including a gate electrode and a pair of main electrodes. In addition, the fourth transistor is a reset transistor 24 including a gate electrode and a pair of main electrodes.

The gate electrode of the amplification transistor 21 is coupled to the FD region 25. One of the main electrodes of the amplification transistor 21 is coupled to a power supply voltage terminal VDD, and another one of the main electrodes thereof is coupled to one of the main electrodes of the selection transistor 22. Here, a power supply voltage is, for example, 2.8 [V]. In addition, the power supply voltage may be, for example, 2.2 [V].

The gate electrode of the selection transistor 22 is coupled to a selection signal line SEL. Another one of the main electrodes of the selection transistor 22 is coupled to a vertical signal line VSL and a current source load LC. The current source load LC is coupled to a reference voltage terminal GND.

The gate electrode of the FD conversion gain switching transistor 23 is coupled to a floating diffusion control signal line FDG. One of the main electrodes of the FD conversion gain switching transistor 23 is coupled to the FD region 25, and another one of the main electrodes thereof is coupled to one of the main electrodes of the reset transistor 24.

The gate electrode of the reset transistor 24 is coupled to a reset signal line RST. Another one of the main electrodes of the reset transistor 24 is coupled to the power supply voltage terminal VDD.

In the solid-state imaging device 1, the pixel circuit 20 is further coupled to an unillustrated image processing circuit. The image processing circuit includes, for example, an analog/digital converter (ADC) and a digital signal processor (DSP).

The electric charge converted from the light by the pixel 10 is an analog signal. The analog signal is subjected to amplification processing in the pixel circuit 20. The ADC converts into a digital signal the analog signal outputted from the pixel circuit 20. The DSP performs functional processing on the digital signal. That is, the image processing circuit performs signal processing adapted to create an image.

### (2) Basic Layout Configuration of Pixel 10 and Transistor 200 Constructing Pixel Circuit 20

FIG. 2 illustrates an example of a basic configuration of the pixel 10 and a transistor 200 constructing the pixel circuit 20.

One pixel 10 and the transistor 200 constructing the pixel circuit 20 are disposed in a region of which a periphery is surrounded by a pixel separation region 16, as viewed in the arrow-Z direction (hereinafter, simply referred to as "in a plan view"). An opposite side in the arrow-Z direction is configured as a light incident surface. The photoelectric conversion element 11 constructing the pixel 10 is disposed on a side of the light incident surface.

The pixel separation region 16 is extended in the arrow-X direction with a constant width dimension, and the plurality of pixel separation regions 16 is arranged in the arrow-Y direction with a constant spaced dimension. Further, the pixel separation region 16 is similarly extended in the arrow-Y direction with a constant width dimension, and the plurality of pixel separation regions 16 is arranged in the arrow-X direction with a constant spaced dimension. That is, the pixel separation region 16 is disposed in a grid shape in a plan view, and the pixel 10 and the transistor 200 are disposed in a region partitioned by the pixel separation region 16.

Although not particularly limited, the pixel 10 and the transistor 200 are disposed in a region partitioned into a square shape by the pixel separation region 16 in a plan view in the first embodiment. Here, one pixel 10 is disposed in one region partitioned by the pixel separation region 16. In addition, one transistor 200 constructing the pixel circuit 20 is disposed in the one region partitioned by the pixel separation region 16.

It is to be noted that description is given later of a vertical cross-sectional structure of each of the pixel separation region 16 and the transistor 200.

The transistor 200 is the first transistor, the second transistor, the third transistor, or the fourth transistor. That is, the transistor 200 is one of the amplification transistor 21, the selection transistor 22, the FD conversion gain switching transistor 23, or the reset transistor 24.

A periphery of the transistor 200 is surrounded by an element separation region 26. This allows the transistor 200 to be electrically and optically separated from another region. The transistor 200 includes a channel formation region 201, a gate insulating film 202, a gate electrode 203, and a pair of main electrodes 204. The main electrodes 204 are each formed by an n-type semiconductor region of a first electrically conductive type, and are each used as a source electrode or a drain electrode.

Here, the transistor 200 is an n-channel insulated gate field effect transistor (IGFET: Insulated Gate Field Effect Transistor). The IGFET includes a metal body-oxide film-semiconductor field effect transistor (MOSFET: Metal Oxide Semiconductor Field Effect Transistor) and a metal body-insulator-semiconductor field effect transistor (MISFET: Metal Insulator Semiconductor Field Effect Transistor).

The transistor 200 is disposed in a region corresponding to the pixel 10 in an oblique direction with respect to an extending direction of the pixel separation region 16.

To give detailed description, the transistor 200 is disposed in the region partitioned by the pixel separation region 16 (a region having a square shape in a plan view) to allow a direction of a gate length Lg to coincide with a diagonal D1-D1 illustrated as an imaginary line. The diagonal D1-D1 is from an upper left side to a lower right side. The gate length Lg is an effective length of the gate electrode 203 between the pair of main electrodes 204. In addition, a gate width Wg is a length in a direction being orthogonal to the direction of the gate length Lg and coinciding with a diagonal D2-D2 illustrated as an imaginary line. The diagonal D2-D2 is from a lower left side to an upper right side.

Here, the smallest angle α1 formed between the diagonal D1-D1 and the pixel separation region 16 extended in the arrow-X direction is 45 degrees. The largest angle is 135 degrees. As a matter of course, the smallest angle α2 formed between the diagonal D1-D1 and the pixel separation region 16 extended in the arrow-Y direction is 45 degrees. Setting the angle α1 to 45 degrees enables a dimension of the gate length Lg and a dimension of the gate width Wg of the transistor 200 to take a maximum value.

It is to be noted that it is possible to appropriately set the angle α1 at an angle of 15 degrees or more and less than 75 degrees. In other words, disposing the transistor 200 obliquely makes it possible to increase the gate length Lg and the gate width Wg of the transistor 200, as compared with a case where the transistor 200 is not disposed obliquely.

Meanwhile, the FD region 25 and a base coupling section 27 are disposed to coincide with the diagonal D2-D2 in the region partitioned by the pixel separation region 16.

The FD region 25 is disposed at a corner on a lower left side where the pixel separation region 16 extended in the arrow-X direction and the pixel separation region 16 extended in the arrow-Y direction intersect each other. The FD region 25 is formed by an n-type semiconductor region. The FD region 25 is disposed with respect to the transistor 200 with the element separation region 26 interposed therebetween.

Further, a transfer gate electrode (a vertical gate electrode) 205 is disposed at a position spaced on a right side of the FD region 25. The transfer gate electrode 205 is a gate electrode of the transfer transistor 200, and is extended in a base 15 by having a direction of the gate length Lg in a thickness direction of the base 15.

The base coupling section 27 is disposed at a corner on an upper right side where the pixel separation region 16 extended in the arrow-X direction and the pixel separation region 16 extended in the arrow-Y direction intersect each other. The base coupling section 27 is formed by a p-type semiconductor region of a second electrically conductive type. In the first embodiment, the base 15 is formed as a p-type well region. That is, the base 15 is coupled to the reference voltage terminal GND with the base coupling section 27 interposed therebetween. The base coupling section 27 is disposed with respect to the transistor 200 with the element separation region 26 interposed therebetween, in a similar manner to the FD region 25.

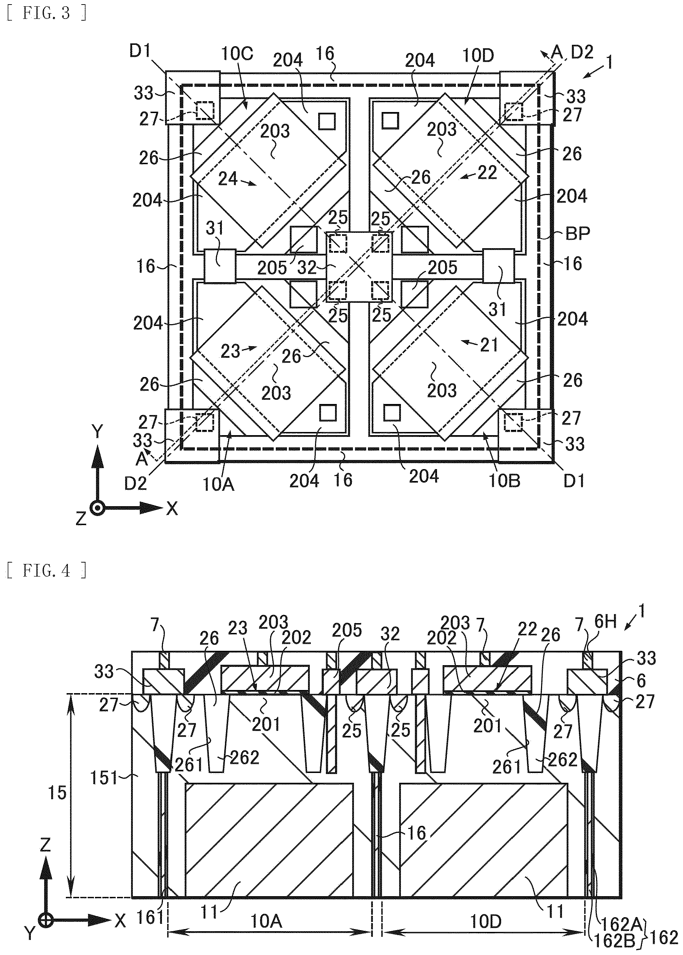

It is to be noted that a portion indicated by a black circle in FIG. 2 is a coupling region (a contact region) of the transistor 200 with wiring disposed in an upper layer on a side opposite to the photoelectric conversion element 11. The wiring is, for example, wiring 7 illustrated in FIG. 4. For example, copper (Cu) wiring is used as the wiring. The coupling region is, for example, a coupling hole 6H illustrated in FIG. 4.

### (3) Basic Layout Configuration of Shared Coupling Sections 31 to 33

A shared coupling (Shared Contact) section 31, a shared coupling section 32, and a shared coupling section 33 are disposed between or among the plurality of pixels 10.

Here, the shared coupling section 31 is disposed between the transistor 200 of the pixel 10 and the transistor 200 of another unillustrated pixel 10 adjacent thereto in the arrow-Y direction. To give detailed description, one end of the shared coupling section 31 is electrically coupled directly to one of the main electrodes 204 of the transistor 200, and another end of the shared coupling section 31 is electrically coupled, across the pixel separation region 16, directly to one of the main electrodes of another transistor 200. That is, the shared coupling section 31 directly couples the main electrodes 204 of the transistors 200 to each other over the pixel separation region 16 without forming wiring on the transistors 200 and a coupling hole formed in an interlayer insulating film between the transistors 200 and the wiring.

Here, the shared coupling section 32 is disposed among the FD region 25 of the pixel 10 and the FD regions 25 of other unillustrated pixels 10 adjacent thereto in the arrow-X direction and the arrow-Y direction. To give detailed description, the shared coupling section 32 is formed across the FD regions 25 of a total of four pixels 10 adjacent to each other in the arrow-X direction and the arrow-Y direction, and is electrically coupled directly to a total of four FD regions 25.

Here, the shared coupling section 33 is disposed among the base coupling section 27 of the pixel 10 and the base coupling sections 27 of other unillustrated pixels 10 adjacent thereto in the arrow-X direction and the arrow-Y direction. The shared coupling section 33 is formed across the base coupling sections 27 of a total of four pixels 10 adjacent to each other in the arrow-X direction and the arrow-Y direction, and is electrically coupled directly to a total of four base coupling sections 27, in a similar manner to the shared coupling section 32.

### (4) Layout Configuration and Vertical Cross-Sectional Configuration of Pixel 10 and Pixel Circuit 20

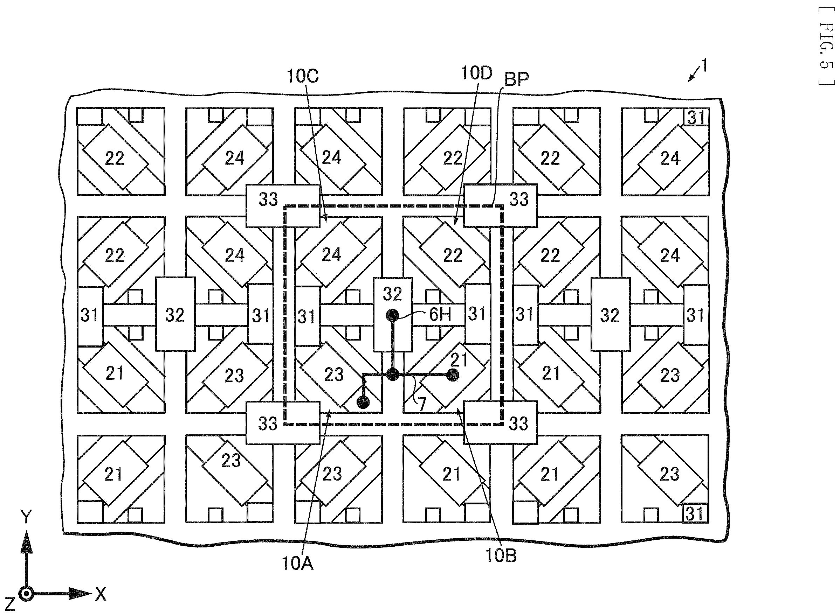

FIG. 3 illustrates an example of a specific planar configuration of the pixels 10 and the pixel circuit 20. FIG. 4 illustrates a vertical cross-sectional configuration of a portion of the pixels 10 and the pixel circuit 20 (a cross-section sectioned along a section line A-A illustrated in FIG. 3). FIG. 5 illustrates an arrangement layout configuration of the unit pixel BP illustrated in FIG. 3 and the pixels 10 (or the unit pixel BP) at a periphery thereof.

In the first embodiment, one pixel circuit 20 is disposed for four pixels 10, as illustrated in FIGs. 3 and 5. To give detailed description, the four pixels 10 are two pixels, i.e., a pixel 10A and a pixel 10B, and two pixels, i.e., a pixel 10C and a pixel 10D. The pixel 10A and the pixel 10B are adjacent to each other in the arrow-X direction. The pixel 10C and the pixel 10D are adjacent to the pixel 10A and the pixel 10B in the arrow-Y direction, and are adjacent to each other in the arrow-X direction. The four pixels, i.e., the pixel 10A, the pixel 10B, the pixel 10C, and the pixel 10D, configure the unit pixel BP.

First, the selection transistor 22 of the pixel circuit 20 is disposed at a position corresponding to the pixel 10D. The selection transistor 22 is disposed in the region partitioned by the pixel separation region 16 to allow a direction of the gate length Lg to coincide with the diagonal D1-D1.

The selection transistor 22 is disposed on a main surface part of the base 15 on a side opposite to a light incident side (a second surface serving as an upper surface of the base 15 in FIG. 4), as illustrated in FIG. 5.

Here, for example, a semiconductor substrate is used for the base 15. To give further detailed description, a monocrystalline silicon substrate including a p-type semiconductor region (or a p-type well region) 151 is used. The photoelectric conversion element 11 is disposed on the light incident side of the base 15 (a side of a first surface serving as a lower surface of the base 15 in FIG. 4). The photoelectric conversion element 11 is formed at a pn junction between the p-type semiconductor region 151 and an n-type semiconductor region with no reference numeral.

Here, the pixel separation region 16 has a first trench 161 and includes a first embedded member 162. The first trench 161 is formed as a deep trench penetrating in the thickness direction from the upper surface to the lower surface of the base 15. The first embedded member 162 is embedded in the first trench 161. Here, the first embedded member 162 includes an insulator 162A provided along an inner wall of the first trench 161, and an embedded member 162B embedded in the first trench 161 with the insulator 162A interposed therebetween. For example, a silicon oxide film or a silicon nitride film is used for the insulator 162A. For example, a silicon oxide film or a polycrystalline silicon film is used for the embedded member 162B. That is, the pixel separation region 16 has a trench isolation structure.

Further, although detailed illustration and description are omitted here, a pinning region is disposed in a region corresponding to the photoelectric conversion element 11 between the photoelectric conversion element 11 and the pixel separation region 16 inside the base 15.

The selection transistor 22 includes the channel formation region 201, the gate insulating film 202, the gate electrode 203, and the pair of main electrodes 204, as described above for the transistor 200.

The channel formation region 201 is formed by the p-type semiconductor region 151 of the base 15.

The gate insulating film 202 is formed on a surface of the channel formation region 201. For example, a single layer film such as a silicon oxide film, a silicon nitride film, or an oxynitride film, or a composite film thereof is used for the gate insulating film 202.

The gate electrode 203 is formed on a surface of the gate insulating film 202 on a side opposite to the channel formation region 201. For example, a single layer film of a gate electrode material such as a polycrystalline silicon film, a high-melting-point metal film, a high-melting-point metal silicide film of a compound of polycrystalline silicon and high-melting-point metal, or a composite film thereof is used for the gate electrode 203.

The pair of main electrodes 204 is disposed in the main surface part of the base 15 in the direction of the gate length Lg centering around the gate electrode 203, and is each formed by an n-type semiconductor region, as illustrated in FIGs. 2 and 3 described above.

The FD region 25 and the base coupling section 27 are disposed at respective positions coinciding with the diagonal D2-D2 and opposed to each other centering around the selection transistor 22, as illustrated in FIGs. 2, 3, and 5. Each element separation region 26 is formed between the FD region 25 and the selection transistor 22 and between the base coupling section 27 and the selection transistor 22.

The FD region 25 is disposed in the main surface part of the base 15, and is formed by an n-type semiconductor region, in a similar manner to the main electrodes 204 of the selection transistor 22.

The base coupling section 27 is disposed in the main surface part of the base 15, and is formed by a p-type semiconductor region having higher impurity density than the p-type semiconductor region 151 of the base 15.

The element separation region 26 has a second trench 261 and includes a second embedded member 262, as illustrated in FIG. 4. The second trench 261 is a trench formed in the thickness direction from the upper surface toward a side of the lower surface of the base 15. The second trench 261 is such a trench that does not reach the photoelectric conversion element 11, and a depth of the second trench 261 is shallower than a depth of the first trench 161. The second embedded member 262 is embedded in the second trench 261. The second embedded member 262 is formed by, for example, a silicon oxide film, in a similar manner to the insulator 162A.

Referring back to FIGs. 3 and 5, the amplification transistor 21 of the pixel circuit 20 is disposed at a position corresponding to the pixel 10B. The amplification transistor 21 is disposed in the region partitioned by the pixel separation region 16 to allow a direction of the gate length Lg to coincide with the diagonal D2-D2.

The amplification transistor 21 is disposed on the main surface part of the base 15, in a similar manner to the selection transistor 22. The amplification transistor 21 includes the channel formation region 201, the gate insulating film 202, the gate electrode 203, and the pair of main electrodes 204, in a similar manner to the selection transistor 22.

The FD region 25 and the base coupling section 27 are disposed at respective positions coinciding with the diagonal D1-D 1 and opposed to each other centering around the amplification transistor 21, as illustrated in FIGs. 3 and 5. Each element separation region 26 is formed between the FD region 25 and the amplification transistor 21 and between the base coupling section 27 and the amplification transistor 21.

The amplification transistor 21 is formed in a shape in line symmetry with the selection transistor 22 centering around the pixel separation region 16 extended in the arrow-X direction, in a plan view. This allows one of the main electrodes 204 of the selection transistor 22 to be disposed close to a position with respect to one of the main electrodes 204 of the amplification transistor 21 with the pixel separation region 16 interposed therebetween in the arrow-Y direction. The one of the main electrodes (an input electrode or a drain electrode) 204 of the selection transistor 22 and the one of the main electrodes (an output electrode or a source electrode) 204 of the amplification transistor 21 are electrically coupled to each other through the shared coupling section 31.

The FD conversion gain switching transistor 23 of the pixel circuit 20 is disposed at a position corresponding to the pixel 10A, as illustrated in FIGs. 3 and 5. The FD conversion gain switching transistor 23 is disposed in the region partitioned by the pixel separation region 16 to allow a direction of the gate length Lg to coincide with the diagonal D1-D1, in a similar manner to the selection transistor 22.

The FD conversion gain switching transistor 23 is disposed on the main surface part of the base 15, as illustrated in FIG. 4. The FD conversion gain switching transistor 23 includes the channel formation region 201, the gate insulating film 202, the gate electrode 203, and the pair of main electrodes 204, in a similar manner to the selection transistor 22.

The FD region 25 and the base coupling section 27 are disposed at respective positions coinciding with the diagonal D2-D2 and opposed to each other centering around the FD conversion gain switching transistor 23, as illustrated in FIGs. 3 and 5. Each element separation region 26 is formed between the FD region 25 and the FD conversion gain switching transistor 23 and between the base coupling section 27 and the FD conversion gain switching transistor 23.

The FD conversion gain switching transistor 23 is formed in a shape in line symmetry with the amplification transistor 21 centering around the pixel separation region 16 extended in the arrow-Y direction, in a plan view.

Further, the reset transistor 24 of the pixel circuit 20 is disposed at a position corresponding to the pixel 10C. The reset transistor 24 is disposed in the region partitioned by the pixel separation region 16 to allow a direction of the gate length Lg to coincide with the diagonal D2-D2, in a similar manner to the amplification transistor 21.

The reset transistor 24 is disposed on the main surface part of the base 15, in a similar manner to the selection transistor 22. The reset transistor 24 includes the channel formation region 201, the gate insulating film 202, the gate electrode 203, and the pair of main electrodes 204, in a similar manner to the selection transistor 22.

The FD region 25 and the base coupling section 27 are disposed at respective positions coinciding with the diagonal D1-D1 and opposed to each other centering around the reset transistor 24, as illustrated in FIGs. 3 and 5. Each element separation region 26 is formed between the FD region 25 and the reset transistor 24 and between the base coupling section 27 and the reset transistor 24.

The reset transistor 24 is formed in a shape in line symmetry with the FD conversion gain switching transistor 23 centering around the pixel separation region 16 extended in the arrow-X direction, in a plan view. This allows one of the main electrodes 204 of the reset transistor 24 to be disposed close to a position with respect to one of the main electrodes 204 of the FD conversion gain switching transistor 23 with the pixel separation region 16 interposed therebetween in the arrow-Y direction. The one of the main electrodes (an input electrode or a drain electrode) 204 of the reset transistor 24 and the one of the main electrodes (an output electrode or a source electrode) 204 of the FD conversion gain switching transistor 23 are electrically coupled to each other through the shared coupling section 31.

In addition, the reset transistor 24 is formed in a shape in line symmetry with the selection transistor 22 centering around the pixel separation region 16 extended in the arrow-Y direction, in a plan view.

### (5) Specific Vertical Cross-Sectional Configuration of Shared Coupling Sections 31 to 33

The total of four FD regions 25 disposed in respective ones of the pixel 10A, the pixel 10B, the pixel 10C, and the pixel 10D are gathered at a middle part of the unit pixel BP, and are electrically coupled to each other through the shared coupling section 32, as illustrated in FIGs. 3 to 5. For example, one end of the shared coupling section 32 is directly coupled to a front surface of the FD region 25 of the pixel 10A. Another end of the shared coupling section 32 is directly coupled, across the pixel separation region 16, to front surfaces of the respective FD regions 25 of the pixel 10B, the pixel 10C, and the pixel 10D. Here, the shared coupling section 32 is formed in a rectangular shape in a plan view. Specifically, the shared coupling section 32 is formed in a square shape.

The shared coupling section 32 is formed by a gate electrode material, e.g., a polycrystalline silicon film. The polycrystalline silicon film contains, at high impurity density, an impurity that reduces a resistance value. For example, it is possible to practically use, as the impurity, phosphorus that is an n-type impurity.

The shared coupling section 31 electrically couples to each other the one of the main electrodes 204 of the FD conversion gain switching transistor 23 of the pixel 10A and the one of the main electrodes 204 of the reset transistor 24 of the pixel 10C. That is, the one end of the shared coupling section 31 is directly coupled to a front surface of the one of the main electrodes 204 of the FD conversion gain switching transistor 23. The other end of the shared coupling section 31 is directly coupled, across the pixel separation region 16, to a front surface of the one of the main electrodes 204 of the reset transistor 24.

Moreover, the shared coupling section 31 electrically couples to each other the one of the main electrodes 204 of the amplification transistor 21 of the pixel 10B and the one of the main electrodes 204 of the selection transistor 22 of the pixel 10D. That is, the one end of the shared coupling section 31 is directly coupled to a front surface of the one of the main electrodes 204 of the amplification transistor 21. The other end of the shared coupling section 31 is directly coupled, across the pixel separation region 16, to a front surface of the one of the main electrodes 204 of the selection transistor 22.

Here, the shared coupling section 31 is formed in a rectangular shape in a plan view. Specifically, the shared coupling section 31 is formed in a rectangle.

The shared coupling section 31 includes, for example, a gate electrode material, in a similar manner to the shared coupling section 32.

The total of four base coupling sections 27 disposed in the respective ones of the pixel 10A, the pixel 10B, the pixel 10C, and the pixel 10D are disposed at respective four corners of the unit pixel BP. The base coupling section 27 is electrically coupled through the shared coupling section 33 to the base coupling sections 27 of other unit pixels BP adjacent to the unit pixel BP. The shared coupling section 33 is formed by a configuration similar to that of the shared coupling section 32 that couples the four FD regions 25 to each other.

The wiring 7 is disposed in an upper layer of the amplification transistor 21 and the like of the pixel circuit 20 with an interlayer insulating film 6 interposed therebetween, as illustrated in FIG. 4 and as illustrated in FIG. 5 in a simplified manner. The wiring 7 is coupled to the gate electrode 203, the main electrodes 204, the shared coupling section 31, the shared coupling section 32, the shared coupling section 33, and the like through the coupling hole 6H formed in the interlayer insulating film 6. For example, copper wiring is used as the wiring 7, as described above.

### [Manufacturing Method of Solid-State Imaging Device 1]

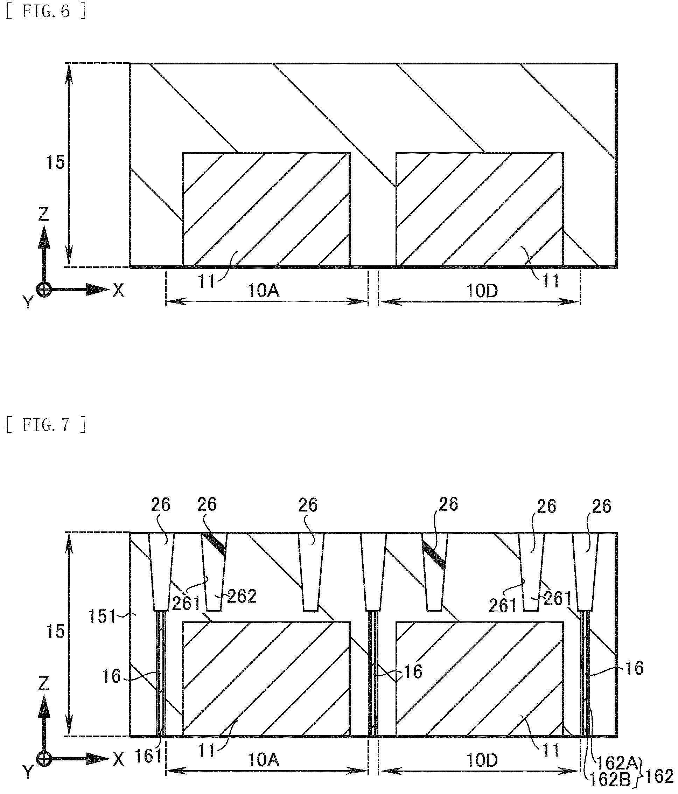

FIGs. 6 to 11 illustrate an example of a manufacturing method of the solid-state imaging device 1 for each of steps.

First, the base 15 is prepared.

The p-type semiconductor region (the p-type well region) 151 is formed in the base 15, and the photoelectric conversion element 11 is formed in a formation region of the pixel 10, as illustrated in FIG. 6. Each of the p-type semiconductor region 151 and the photoelectric conversion element 11 is formed by, for example, introducing an impurity and activating the introduced impurity.

The pixel separation region 16 and the element separation region 26 are formed, as illustrated in FIG. 7.

The pixel separation region 16 is formed in a region of the base 15 between the pixels 10. The pixel separation region 16 is formed by, for example, forming the first trench 161 penetrating from the upper surface to the lower surface of the base 15 and embedding the first embedded member 162 in the first trench 161. For example, anisotropic etching such as reactive ion etching (RIE: Reactive Ion Etching) is used to form the first trench 161. For example, a thermal oxidation method or a chemical vapor deposition (CVD: Chemical Vaper Deposition) method is used to form the insulator 162A of the first embedded member 162. For example, a CVD method is used to form the embedded member 162B of the first embedded member 162.

Meanwhile, the element separation region 26 is formed on a side of a main surface of the base 15 in a portion of the pixel separation region 16 and a portion of the p-type semiconductor region 151. The element separation region 26 is formed by forming the second trench 261 from the upper surface to the side of the lower surface of the base 15 and embedding the second embedded member 262 in the second trench 261. The second trench 261 is formed to be shallower than the first trench 161. For example, anisotropic etching such as RIE is used to form the second trench 261. For example, a CVD method is used to form the second embedded member 262.

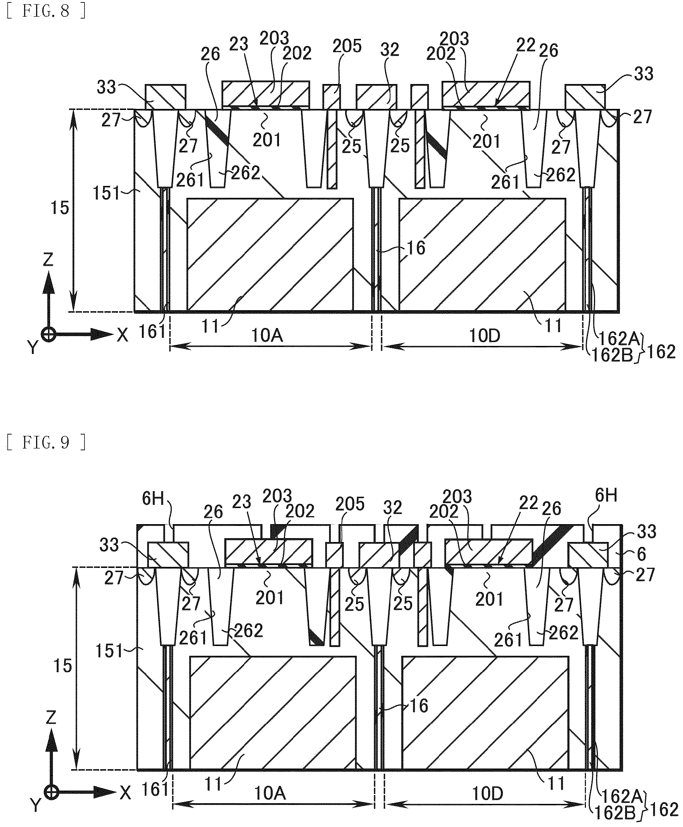

The transfer gate electrode 205 is formed in a formation region of the transfer transistor 12 in a region of which a periphery is surrounded by the pixel separation region 16 and the element separation region 26, as illustrated in FIG. 8. The transfer gate electrode 205 has a trench with no reference numeral formed from the upper surface to the side of the lower surface of the base 15, and includes an embedded member with no reference numeral embedded in the trench with a gate insulating film interposed therebetween, and a gate electrode coupled to the embedded member.

Further, the gate insulating film 202 and the gate electrode 203 are formed on a surface of the base 15 in a formation region of each of the amplification transistor 21, the selection transistor 22, the FD conversion gain switching transistor 23, and the reset transistor 24.

Each of the base coupling section 27 and the FD region 25 is formed in the region of which the periphery is surrounded by the pixel separation region 16 and the element separation region 26 to coincide with or along a direction of the gate width Wg of the amplification transistor 21, as illustrated in FIG. 9.

The base coupling section 27 is formed by implanting a p-type impurity through a photolithography technique and an ion implantation method. The FD region 25 is formed by implanting an n-type impurity through a photolithography technique and an ion implantation method.

Although illustration is omitted in FIG. 9, the main electrodes 204 of each of the amplification transistor 21, the selection transistor 22, the FD conversion gain switching transistor 23, and the reset transistor 24 are formed in the same step as the step of forming the FD region 25. The formation of the main electrodes 204 allows for formation of each of the amplification transistor 21, the selection transistor 22, the FD conversion gain switching transistor 23, and the reset transistor 24.

It is to be noted that the impurity may be introduced through a solid phase diffusion method.

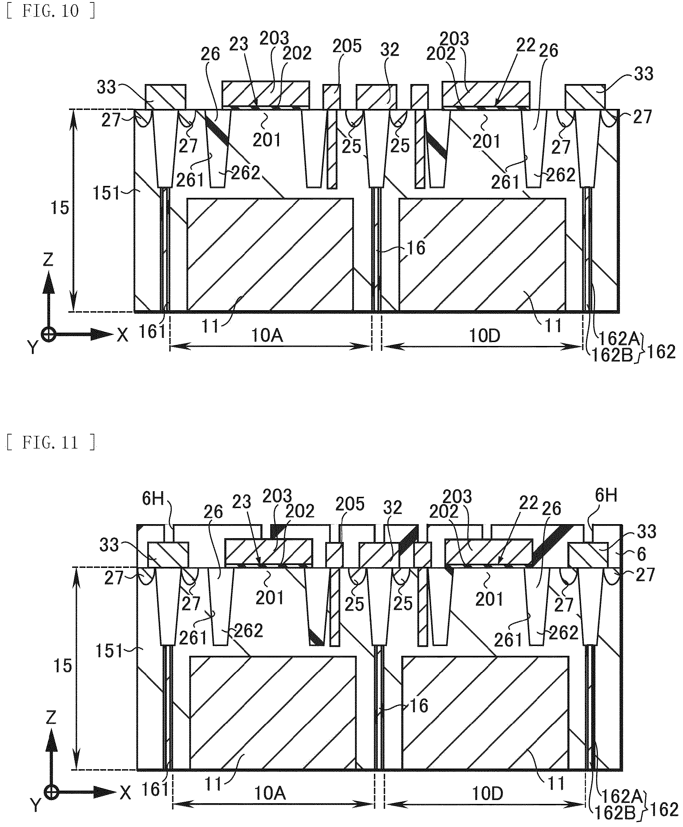

Each of the shared coupling section 33 that couples the base coupling sections 27 to each other and the shared coupling section 32 that couples the FD regions 25 to each other is formed, as illustrated in FIG. 10.

The shared coupling section 33 is formed by, for example, a polycrystalline silicon film as a gate electrode material. The polycrystalline silicon film is formed through, for example, a CVD method, and a p-type impurity is introduced into the polycrystalline silicon film. The p-type impurity is introduced through an ion implantation method or a solid phase diffusion method.

The shared coupling section 32 is formed through the same step as that of, for example, the polycrystalline silicon film of the shared coupling section 33. An n-type impurity is introduced into the polycrystalline silicon film.

Although illustration is omitted in FIG. 10, the shared coupling section 31 that couples the main electrodes 204 to each other is formed through the same step as the step of forming the shared coupling section 32.

The interlayer insulating film 6 is formed to cover each of the amplification transistor 21, the selection transistor 22, the FD conversion gain switching transistor 23, the reset transistor 24, the shared coupling section 31, the shared coupling section 32, and the shared coupling section 33 (see FIG. 11). Subsequently, the coupling hole 6H is formed in the interlayer insulating film 6, as illustrated in FIG. 11.

The wiring 7 is formed in the interlayer insulating film 6, as illustrated in FIGs. 4 and 5 described above. The wiring 7 is coupled through the coupling hole 6H to each of regions.

When the series of steps ends, the solid-state imaging device 1 according to the first embodiment is completed, and the manufacturing method ends.

It is to be noted that an impurity may be introduced into the shared coupling section 31 and the shared coupling section 32, or the shared coupling section 33, for example, during formation of the polycrystalline silicon film.

### [Workings and Effects]

The solid-state imaging device 1 according to the first embodiment includes the pixel 10, the pixel separation region 16, the transistor 200, and the FD region 25, the transfer gate electrode 205, or the base coupling section 27, as illustrated in FIGs. 2 to 5.

The pixel 10 includes the photoelectric conversion element 11 that is disposed on the side of the first surface of the base 15 and that converts light into electric charge. The side of the first surface is the light incident side. The pixel 10 is a "first pixel" according to the present technology, and is one of the pixel 10A, the pixel 10B, the pixel 10C, or the pixel 10D. In addition, the photoelectric conversion element is a "first photoelectric conversion element" according to the present technology.

The pixel separation region 16 is formed in the thickness direction of the base 15. The pixel separation region 16 extends in a first direction and a second direction intersecting the first direction to surround a periphery of a side surface of the pixel 10, as viewed from a side of the second surface of the base 15. The pixel separation region 16 electrically and optically separates the pixel 10 from another region. The side of the second surface is a side opposite to the first surface. The first direction is, for example, the arrow-X direction. The second direction is, for example, the arrow-Y direction. Each of the first direction and the second direction is the extending direction of the pixel separation region 16 or an arrangement direction of the pixels 10.

The transistor 200 is disposed on the side of the second surface of the base 15 at a position corresponding to the pixel 10. A periphery of the base 15 is surrounded by the pixel separation region 16. The transistor 200 is disposed to allow a direction of a gate length to be oblique to the first direction or the second direction. The transistor 200 processes the converted electric charge. The transistor 200 is the "first transistor" according to the present disclosure. The "first transistor" is the FD conversion gain switching transistor 23 disposed at the position corresponding to the pixel 10A in the first embodiment, but may be any of the amplification transistor 21, the selection transistor 22, or the reset transistor 24.

The FD region 25 is disposed in the direction of the gate width Wg of the transistor 200 that is on the second surface of the base 15, at the position corresponding to the pixel 10. The FD region 25 is a "first FD region" according to the present technology. Similarly, the transfer gate electrode 205 is disposed in the direction of the gate width Wg of the transistor 200 that is on the side of the second surface of the base 15, at the position corresponding to the pixel 10. The transfer gate electrode 205 is a gate electrode of the transfer transistor 12 that transfers the electric charge from the pixel 10 to the FD region 25. The transfer transistor 12 and the transfer gate electrode 205 are respectively a "first transfer transistor" and a "first transfer gate electrode" according to the present technology. The base coupling section 27 supplies the base 15 with a voltage. The base coupling section 27 is a "first base coupling section" according to the present technology. It is to be noted that the first base coupling section is a well contact region.

Such a configuration allows the transistor 200 to be disposed in a region that corresponds to the pixel 10 and of which a periphery is surrounded by the pixel separation region 16 with the direction of the gate length Lg being oblique. This makes it possible to sufficiently secure a disposition area of the transistor 200. To give detailed description, it is possible to sufficiently secure lengths of the transistor 200 in the direction of the gate length Lg and the direction of the gate width Wg. This enables the transistor 200 having excellent noise resistance to be constructed, thus making it possible to improve electrical reliability of the solid-state imaging device 1.

In addition, the pair of main electrodes 204 is not formed in the direction of the gate width Wg of the transistor 200. This region is utilizable as an unoccupied space. The FD region 25, the transfer gate electrode 205, or the base coupling section 27 is disposed in the unoccupied space. Although all of these components are disposed in the first embodiment, at least one of the components may be disposed. This makes it possible to effectively utilize the region corresponding to the pixel 10.

Further, in the solid-state imaging device 1, the FD region 25, the transfer gate electrode 205, or the base coupling section 27 is disposed with respect to the transistor 200 with the element separation region 26 interposed therebetween, as illustrated in FIGs. 2 and 3.

This makes it possible to improve capability of separation between the transistor 200 and the FD region 25, the transfer gate electrode 205, or the base coupling section 27, as compared with a case where the element separation region 26 is not interposed therebetween.

Furthermore, in the solid-state imaging device 1, the pixel separation region 16 has the first trench 161 formed from the second surface to the side of the first surface of the base 15, and includes the first embedded member 162 embedded in the first trench 161, as particularly illustrated in FIG. 4. In addition, the element separation region 26 has the second trench 261 formed from the second surface to the side of the first surface of the base 15 and being deeper than the first trench 161, and includes the second embedded member 262 embedded in the second trench 261.

This enables a separation distance between elements to be gained in the thickness direction of the base 15 in the element separation region 26. This makes it possible to even further improve the capability of the separation between the transistor 200 and the FD region 25, the transfer gate electrode 205, or the base coupling section 27.

In addition, in the solid-state imaging device 1, the pixel 10 is partitioned by the pixel separation region 16, and is formed in a rectangular shape as viewed from the side of the second surface, as illustrated in FIGs. 2, 3, and 5. The pair of main electrodes 204 of the transistor 200 is disposed to coincide with, for example, the diagonal D1-D1 of the rectangular shape of the pixel 10. The FD region 25, the transfer gate electrode 205, or the base coupling section 27 is disposed to coincide with another diagonal, e.g., the diagonal D2-D2 intersecting the diagonal D1-D1, or along the diagonal D2-D2.

This increases each of the gate length Lg and the gate width Wg of the transistor 200, as compared with a case where the direction of the gate length Lg coincides with the extending direction of the pixel separation region 16. This makes it possible to improve noise resistance performance, and improve an electrical property, in the transistor 200.

In particular, in the solid-state imaging device 1, the direction of the gate length Lg of the transistor 200 is inclined at 45 degrees with respect to the first direction or the second direction.

This allows each of the gate length Lg and the gate width Wg of the transistor 200 to be the largest.

Moreover, the solid-state imaging device 1 according to the first embodiment includes the pixel 10, the pixel separation region 16, the transistor 200, and the FD region 25, the transfer gate electrode 205, or the base coupling section 27, as illustrated in FIGs. 2 to 5.

The pixel 10 is adjacent to the "first pixel" according to the present technology in the first direction with the pixel separation region 16 interposed therebetween. The pixel 10 includes the photoelectric conversion element 11 that is disposed on the side of the first surface of the base 15 and that converts light into electric charge. The pixel 10 is a "second pixel" according to the present technology. For example, when the "first pixel" is the pixel 10A, the "second pixel" is the pixel 10B. The photoelectric conversion element is a "second photoelectric conversion element" according to the present technology.

The pixel separation region 16 is formed in the thickness direction of the base 15. The pixel separation region 16 extends in the first direction and the second direction intersecting the first direction to surround the periphery of the side surface of the pixel 10 as viewed from the side of the second surface of the base 15. The pixel separation region electrically and optically separates the pixel 10 from another region. The side of the second surface is the side opposite to the first surface.

The transistor 200 is disposed on the side of the second surface of the base 15 at the position corresponding to the pixel 10. The periphery of the base 15 is surrounded by the pixel separation region 16. The transistor 200 allows the direction of the gate length to be oblique to the first direction or the second direction. The transistor 200 processes the converted electric charge. The transistor 200 is the "second transistor" according to the present disclosure. In the first embodiment, for example, when the "first transistor" is the FD conversion gain switching transistor 23, the "second transistor" is the amplification transistor 21. The "second transistor" is formed in a shape in line symmetry with the "first transistor" centering around the pixel separation region 16 between the "first pixel" and the "second pixel".

The FD region 25 is disposed in the direction of the gate width Wg of the transistor 200 that is on the side of the second surface of the base 15, at the position corresponding to the pixel 10. The FD region 25 is a "second FD region" according to the present technology. Similarly, the transfer gate electrode 205 is disposed in the direction of the gate width Wg of the transistor 200 that is on the second surface of the base 15, at the position corresponding to the pixel 10. The transfer gate electrode 205 is a gate electrode of the transfer transistor 12 that transfers the electric charge from the pixel 10 to the FD region 25. The transfer transistor 12 and the transfer gate electrode 205 are respectively a "second transfer transistor" and a "second transfer gate electrode" according to the present technology. The base coupling section 27 supplies the base 15 with a voltage. The base coupling section 27 is a "second base coupling section" according to the present technology.

Such a configuration allows the transistor 200 to be disposed in the region that corresponds to the pixel 10 and of which the periphery is surrounded by the pixel separation region 16 with the direction of the gate length Lg being oblique. This makes it possible to sufficiently secure the disposition area of the transistor 200. To give detailed description, it is possible to sufficiently secure the lengths of the transistor 200 in the direction of the gate length Lg and the direction of the gate width Wg. This enables the transistor 200 having excellent noise resistance to be constructed, thus making it possible to improve the electrical reliability of the solid-state imaging device 1.

In addition, the pair of main electrodes 204 is not formed in the direction of the gate width Wg of the transistor 200. This region is utilizable as an unoccupied space. The FD region 25, the transfer gate electrode 205, or the base coupling section 27 is disposed in the unoccupied space. Although all of these components are disposed in the first embodiment, at least one of the components may be disposed. This makes it possible to effectively utilize the region corresponding to the pixel 10.

Moreover, the "second transistor" is formed in a shape in line symmetry with the "first transistor". This makes it possible to easily achieve an arrangement layout of the pixels 10 and the transistors 200. In particular, it is possible to dispose both the FD regions 25 close to each other or dispose both the base coupling sections 27 close to each other between the adjacent pixels 10. This enables shared coupling using the shared coupling section 32 or the shared coupling section 33, making it possible to sufficiently secure the area necessary to dispose the transistor 200 in the pixel 10.

It is to be noted that these workings and effects are also similarly achievable in each of a "third pixel", the "third transistor", a "fourth pixel", and the "fourth transistor" according to the present technology. The "third pixel" and the "third transistor" are, for example, the pixel 10C and the reset transistor 24, respectively. The "fourth pixel" and the "fourth transistor" are, for example, the pixel 10D and the selection transistor 22, respectively.

In addition, in the solid-state imaging device 1, one of the pair of main electrodes 204 of the transistor 200 and one of the pair of main electrodes 204 of another adjacent transistor 200 are shared by the shared coupling section 31, as illustrated in FIGs. 2 to 5. Specifically, the main electrode 204 of the FD conversion gain switching transistor 23 and the main electrode 204 of the reset transistor 24 are shared by the shared coupling section 31. Similarly, the main electrode 204 of the amplification transistor 21 and the main electrode 204 of the selection transistor 22 are shared by the shared coupling section 31. The shared coupling section 31 is directly coupled to the front surfaces of the main electrodes 204.

Such a configuration makes it possible to electrically couple the main electrodes 204 of the transistors 200 to each other through the shared coupling section 31 without forming a coupling hole and wiring over the pixel separation region 16. The shared coupling section 31 is disposed to overlap the main electrodes 204 in a plan view, making unnecessary an alignment margin dimension of the coupling hole or the like to couple both the shared coupling section 31 and the main electrodes 204 to each other. This does not increase the area that is on the main surface of the base 15 and couples the main electrodes 204 to each other. This makes it possible to secure the area sufficient to dispose the transistor 200 in the pixel 10.

In addition, the area sufficient to dispose the transistor 200 is secured in the pixel 10, thus making it possible to increase the dimension of the gate length Lg and the dimension of the gate width Wg of the transistor 200. This enables the transistor 200 having excellent noise resistance to be constructed, thus making it possible to improve the electrical reliability of the solid-state imaging device 1.

Moreover, in the solid-state imaging device 1, the adjacent FD regions 25 are shared by the shared coupling section 32, and the adjacent base coupling sections 27 are shared by the shared coupling section 33. The shared coupling section 32 is directly coupled to the front surfaces of the FD regions 25, and the shared coupling section 33 is directly coupled to front surfaces of the base coupling sections 27.

Such a configuration makes it possible to electrically couple the FD regions 25 to each other through the shared coupling section 32 without forming the coupling hole and the wiring over the pixel separation region 16. The shared coupling section 32 is disposed to overlap the FD regions 25 in a plan view, making unnecessary the alignment margin dimension of the coupling hole or the like to couple both the shared coupling section 32 and the FD regions 25 to each other. This does not increase the area that is on the main surface of the base 15 and couples the FD regions 25 to each other. In addition, coupling without the wiring 7 makes it possible to reduce parasitic capacitance to be added to the FD regions 25.

Similarly, it is possible to electrically couple the base coupling sections 27 to each other through the shared coupling section 33 without forming the coupling hole and the wiring over the pixel separation region 16. The shared coupling section 33 is disposed to overlap the base coupling sections 27 in a plan view, making unnecessary the alignment margin dimension of the coupling hole or the like to couple both the shared coupling section 33 and the base coupling sections 27 to each other. This does not increase the area that is on the main surface of the base 15 and couples the base coupling sections 27 to each other. Therefore, the area sufficient to dispose the transistor 200 is secured in the pixel 10, thus making it possible to increase the dimension of the gate length Lg and the dimension of the gate width Wg of the transistor 200. That is, it is possible to construct the transistor 200 having excellent noise resistance, thus enabling improvement in the electrical reliability of the solid-state imaging device 1.

Further, in the solid-state imaging device 1, one transistor 200 is disposed in one pixel 10, as illustrated in FIGs. 2 to 5. In addition, one FD region 25 is disposed for the plurality of pixels 10, and the FD region 25 is used in a shared manner (shared) by the plurality of pixels 10. Moreover, the same also applies to each of the transfer gate electrode 205 and the base coupling section 27.

Therefore, it is possible to decrease an area of the element separation region 26 that allows for separation between another region and the FD region 25, the transfer gate electrode 205, or the base coupling section 27. This makes it possible to achieve further miniaturization of the pixel 10.

### <2. Second Embodiment>

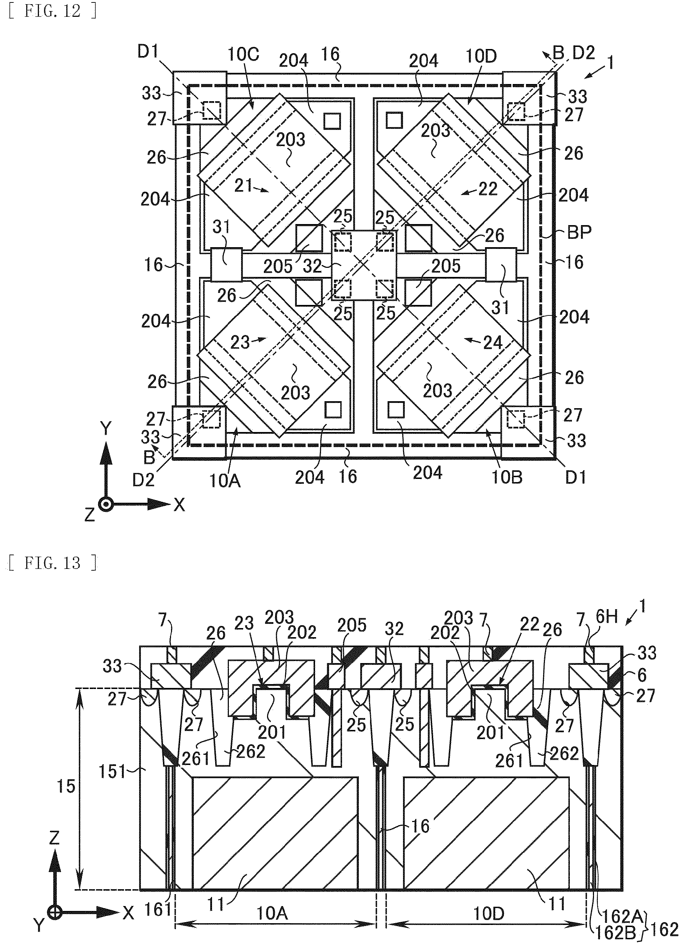

Description is given of the solid-state imaging device 1 according to the second embodiment of the present disclosure with reference to FIGs. 12 and 13. It is to be noted that, in the second embodiment and subsequent embodiments, components the same as or components substantially the same as the components of the solid-state imaging device 1 according to the first embodiment are denoted by the same reference numerals, and redundant description is omitted.

### [Configuration of Solid-State Imaging Device 1]

FIG. 12 illustrates an example of a specific planar configuration of the pixels 10 and the pixel circuit 20 of the solid-state imaging device 1 according to the second embodiment. FIG. 13 illustrates a vertical cross-sectional configuration of a portion of the pixels 10 and the pixel circuit 20 (a cross-section sectioned along a section line B-B illustrated in FIG. 12).

The solid-state imaging device 1 according to the second embodiment has a configuration in which a fin (FIN) structure is adopted for the transistor 200, in the solid-state imaging device 1 according to the first embodiment, as illustrated in FIGs. 12 and 13.

To give detailed description, the amplification transistor 21, the selection transistor 22, the FD conversion gain switching transistor 23, and the reset transistor 24 have the fin structure. The fin structure is a structure in which ends of the gate electrode 203 in the direction of the gate width Wg are extended from the second surface to the side of the first surface of the base 15. Here, both ends of the gate electrode 203 in the direction of the gate width Wg are embedded in a trench formed in the base 15, and are extended into the base 15. Both ends of the gate electrode 203 in the direction of the gate width Wg are formed exactly along the element separation region 26. The gate width Wg of the gate electrode 203 is defined by the element separation region 26.

Components other than the above-described components are components the same or substantially the same as the components of the solid-state imaging device 1 according to the first embodiment.

It is to be noted that the fin structure may be adopted for one selected from the amplification transistor 21, the selection transistor 22, the FD conversion gain switching transistor 23, and the reset transistor 24. For example, the fin structure may be adopted only for the amplification transistor 21.

### [Workings and Effects]

The solid-state imaging device 1 according to the second embodiment makes it possible to achieve workings and effects similar to the workings and effects achievable by the solid-state imaging device 1 according to the first embodiment.

Further, in the solid-state imaging device 1, the transistor 200 has the fin structure in which the ends of the gate electrode 203 in the direction of the gate width Wg are extended from the second surface to the side of the first surface of the base 15, as illustrated in FIGs. 12 and 13. Adoption of the fin structure makes it possible to secure the dimension of the gate width Wg of the transistor 200 in the thickness direction of the base 15.

Such a configuration allows the transistor 200 to be disposed with the direction of the gate length Lg being oblique, thus increasing the dimension of the gate length Lg. This makes it possible to effectively suppress or prevent generation of a short-channel effect or generation of noise. In particular, it is possible to effectively suppress or prevent generation of RTN (Random Telegraph Signal) noise in the transistor 200.

Furthermore, adoption of the fin structure makes it possible to expand the dimension of the gate width Wg of the transistor 200 and improve transconductance (gm). In addition, the improvement in the transconductance of the transistor 200 enables achievement of an increase in an operating speed of the pixel circuit 200.

### <3. Third Embodiment>

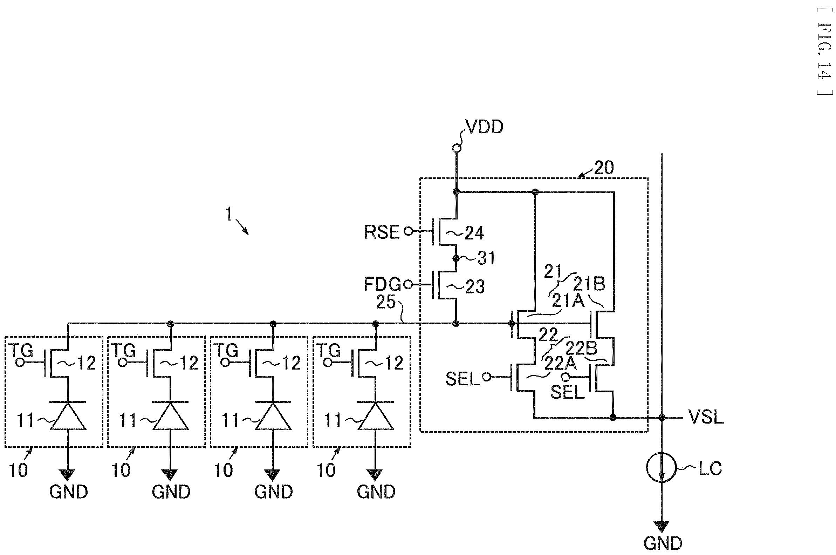

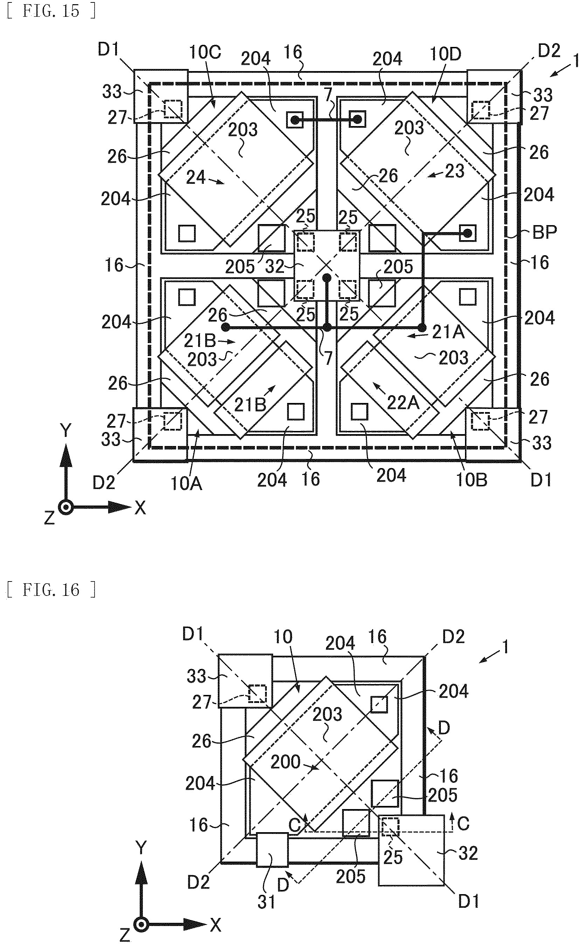

Description is given of the solid-state imaging device 1 according to the third embodiment of the present disclosure with reference to FIGs. 14 and 15.

### [Configuration of Solid-State Imaging Device 1]

### (1) Circuit Configuration of Pixel 10 and Pixel Circuit 20 of Solid-State Imaging Device 1

FIG. 14 illustrates an example of a circuit configuration of the pixels 10 and the pixel circuit 20 constructing the solid-state imaging device 1 according to the third embodiment.

In the pixel circuit 20 of the solid-state imaging device 1, the amplification transistor 21 includes an amplification transistor 21A and an amplification transistor 21B, and the selection transistor 22 includes a selection transistor 22A and a selection transistor 22B, as illustrated in FIG. 14. The amplification transistor 21A and the amplification transistor 21B are electrically coupled in parallel to each other. Similarly, the selection transistor 22A and the selection transistor 22B are electrically coupled in parallel to each other. The amplification transistor 21A and the selection transistor 22A are electrically coupled in series to each other. Similarly, the amplification transistor 21B and the selection transistor 22B are electrically coupled in series to each other.

### (2) Layout Configuration of Pixel 10 and Pixel Circuit 20

FIG. 15 illustrates an example of a specific planar configuration of the pixels 10 and the pixel circuit 20.

In the third embodiment, the amplification transistor 21B of the amplification transistor 21 and the selection transistor 22B of the selection transistor 22 are disposed at the position corresponding to the pixel 10A, as illustrated in FIG. 15. The amplification transistor 21B and the selection transistor 22B are disposed along the diagonal D1-D1 (see FIG. 2).

In addition, a dimension of the gate length Lg of the amplification transistor 21B is formed to be longer than a dimension of the gate length Lg of the selection transistor 22B.

Meanwhile, the amplification transistor 21A of the amplification transistor 21 and the selection transistor 22A of the selection transistor 22 are disposed at the position corresponding to the pixel 10B. The amplification transistor 21A and the selection transistor 22A are disposed to coincide with the diagonal D2-D2 (see FIG. 2).

In addition, a dimension of the gate length Lg of the amplification transistor 21A is formed to be longer than a dimension of the gate length Lg of the selection transistor 22A.

The amplification transistor 21A and the selection transistor 22A are formed in a shape in line symmetry with the amplification transistor 21B and the selection transistor 22B centering around the pixel separation region 16 disposed between the pixel 10A and the pixel 10B.

Moreover, the reset transistor 24 is disposed at the position corresponding to the pixel 10C. The reset transistor 24 is disposed to coincide with the diagonal D2-D2 (see FIG. 2).

The FD conversion gain switching transistor 23 is disposed at the position corresponding to the pixel 10D. The FD conversion gain switching transistor 23 is disposed to coincide with the diagonal D1-D1 (see FIG. 2).

The FD conversion gain switching transistor 23 is formed in a shape in line symmetry with the reset transistor 24 centering around the pixel separation region 16 disposed between the pixel 10C and the pixel 10D.

Further, the FD conversion gain switching transistor 23 is formed in a shape substantially in line symmetry with the amplification transistor 21B and the selection transistor 22B centering around the pixel separation region 16 disposed between the pixel 10A and the pixel 10C. Similarly, the reset transistor 24 is formed in a shape substantially in line symmetry with the amplification transistor 21A and the selection transistor 22A centering around the pixel separation region 16 disposed between the pixel 10B and the pixel 10D.

It is to be noted that, in the third embodiment, the main electrode 204 of the FD conversion gain switching transistor 23 and the main electrode 204 of the reset transistor 24 are coupled to each other through the wiring 7 (see FIG. 4). Here, parasitic capacitance due to the wiring 7 is actively formed.

Components other than the above-described components are components the same or substantially the same as the components of the solid-state imaging device 1 according to the first embodiment.

### [Workings and Effects]

The solid-state imaging device 1 according to the third embodiment makes it possible to achieve workings and effects similar to the workings and effects achievable by the solid-state imaging device 1 according to the first embodiment.

Moreover, in the solid-state imaging device 1, the amplification transistor 21 of the pixel circuit 20 is constructed by the amplification transistor 21A and the amplification transistor 21B electrically coupled in parallel to each other, as illustrated in FIGs. 14 and 15. In addition, the selection transistor 22 of the pixel circuit 20 is constructed by the selection transistor 22A and the selection transistor 22B electrically coupled in parallel to each other. The amplification transistor 21A and the selection transistor 22A are disposed at the position corresponding to the pixel 10B. The amplification transistor 21B and the selection transistor 22B are disposed at the position corresponding to the pixel 10A.

Here, the gate length Lg of the amplification transistor 21A and the amplification transistor 21B is formed to be longer than the gate length Lg of the selection transistor 22A and the selection transistor 22B. This makes it possible to improve a noise resistance property of the amplification transistor 21 constructed by the amplification transistor 21A and the amplification transistor 21B.

### <4. Fourth Embodiment>

Description is given of the solid-state imaging device 1 according to the fourth embodiment of the present disclosure with reference to FIGs. 16 to 18.

### [Configuration of Solid-State Imaging Device 1]

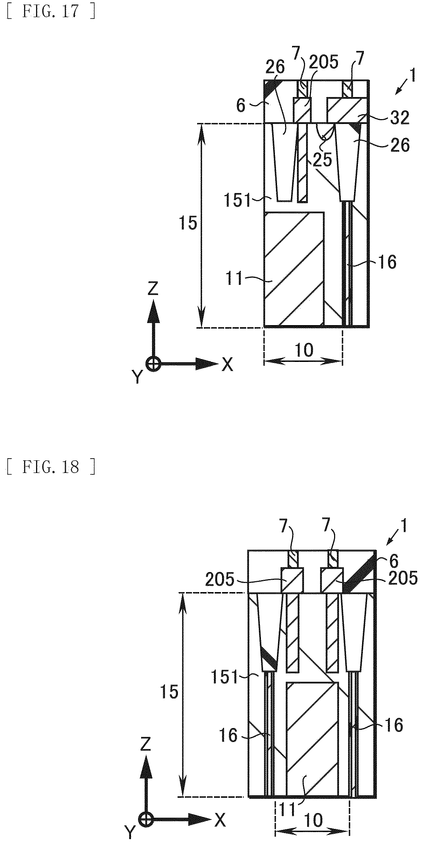

FIG. 16 illustrates an example of a specific planar configuration of the pixel 10 and the pixel circuit 20. FIG. 17 illustrates a vertical cross-sectional configuration of a portion of the pixel 10 and the pixel circuit 20 (a cross-section sectioned along a section line C-C illustrated in FIG. 16). FIG. 18 illustrates a vertical cross-sectional configuration of another portion of the pixel 10 and the pixel circuit 20 (a cross-section sectioned along a section line D-D illustrated in FIG. 16).

The plurality of transfer gate electrodes 205 of the transfer transistor 12 (see FIG. 1) is disposed in the solid-state imaging device 1 according to the fourth embodiment, as illustrated in FIGs. 16 to 18.

To give detailed description, the transistor 200 is disposed, and here, two transfer gate electrodes 205 are further disposed, at the position corresponding to one pixel 10. The two transfer gate electrodes 205 are disposed along the diagonal D2-D2 with the FD region 25 sandwiched therebetween, in a plan view. As for the planar shape, the transfer gate electrode 205 is formed in a rectangular shape, specifically, a square shape.

Here, the pixel 10 is the pixel 10A, the pixel 10B, the pixel 10C, or the pixel 10D. The transistor 200 is the amplification transistor 21, the selection transistor 22, the FD conversion gain switching transistor 23, or the reset transistor 24.

Components other than the above-described components are components the same or substantially the same as the components of the solid-state imaging device 1 according to the first embodiment.

### [Workings and Effects]

The solid-state imaging device 1 according to the fourth embodiment makes it possible to achieve workings and effects similar to the workings and effects achievable by the solid-state imaging device 1 according to the first embodiment.

Further, in the solid-state imaging device 1, the plurality of transfer gate electrodes 205 is disposed at the position corresponding to the pixel 10, as illustrated in FIGs. 16 to 18. This expands an effective dimension of the gate width Wg of the transfer gate electrodes 205 of the transfer transistor 12, thus making it possible to improve efficiency of reading the electric charge from the pixel 10 to the pixel circuit 20.

### [First Modification Example]

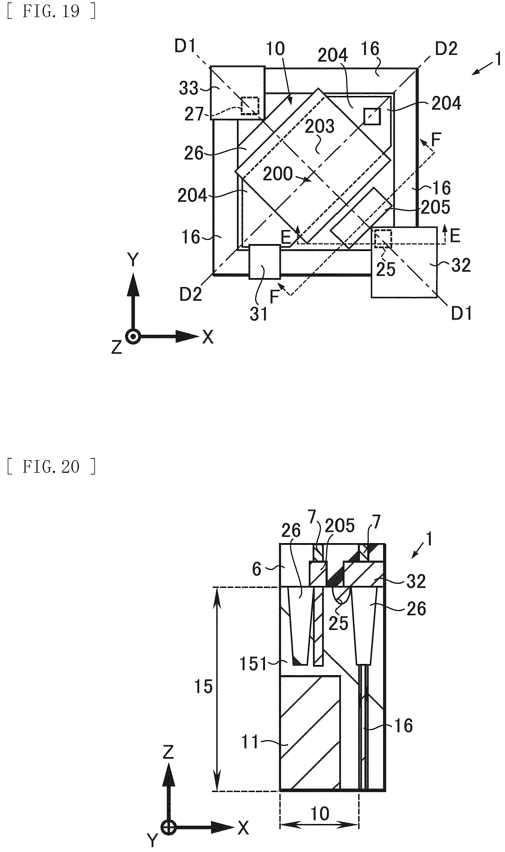

Description is given of the solid-state imaging device 1 according to a first modification example of the fourth embodiment with reference to FIGs. 19 to 21.

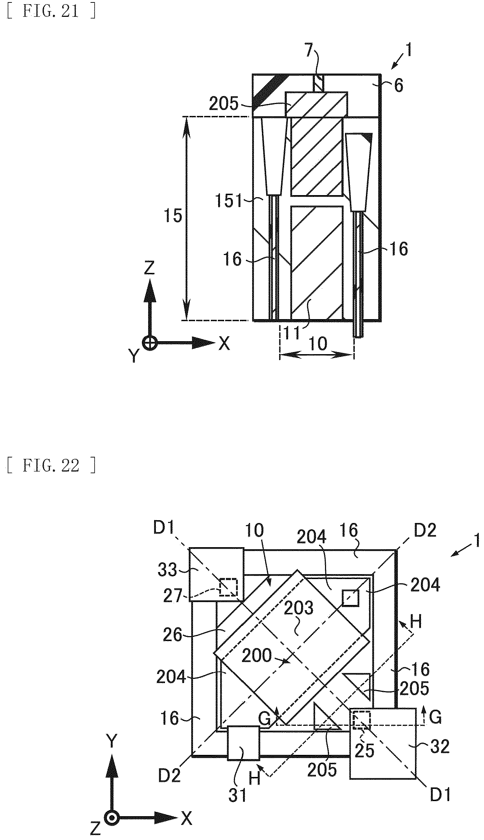

FIG. 19 illustrates an example of a specific planar configuration of the pixel 10 and the pixel circuit 20. FIG. 20 illustrates a vertical cross-sectional configuration of a portion of the pixel 10 and the pixel circuit 20 (a cross-section sectioned along a section line E-E illustrated in FIG. 19). FIG. 21 illustrates a vertical cross-sectional configuration of another portion of the pixel 10 and the pixel circuit 20 (a cross-section sectioned along a section line F-F illustrated in FIG. 19).

In the solid-state imaging device 1 according to the first modification example of the fourth embodiment, the transfer gate electrode 205 of the transfer transistor 12 (see FIG. 1) is formed in a rectangular shape in a plan view, as illustrated in FIGs. 19 to 21.

To give detailed description, the transistor 200 is disposed, and here, one transfer gate electrode 205 is further disposed, at the position corresponding to one pixel 10. The transfer gate electrode 205 is formed in a rectangle of which long sides are disposed along the diagonal D2-D2 and of which short sides are disposed along the diagonal D1-D1, in a plan view. The FD region 25 is disposed to be opposed to a middle part of the transfer gate electrode 205.

Components other than the above-described components are components the same or substantially the same as the components of the solid-state imaging device 1 according to the fourth embodiment.

### [Workings and Effects]

The solid-state imaging device 1 according to the first modification example of the fourth embodiment makes it possible to achieve workings and effects similar to the workings and effects achievable by the solid-state imaging device 1 according to the fourth embodiment.

In addition, in the solid-state imaging device 1, the transfer gate electrode 205 having a rectangular shape in a plan view is disposed at the position corresponding to the pixel 10, as illustrated in FIGs. 19 to 21. This expands the effective dimension of the gate width Wg of the transfer gate electrode 205 of the transfer transistor 12, thus making it possible to improve the efficiency of reading the electric charge from the pixel 10 to the pixel circuit 20.

### [Second Modification Example]

Description is given of the solid-state imaging device 1 according to a second modification example of the fourth embodiment with reference to FIGs. 22 to 24.

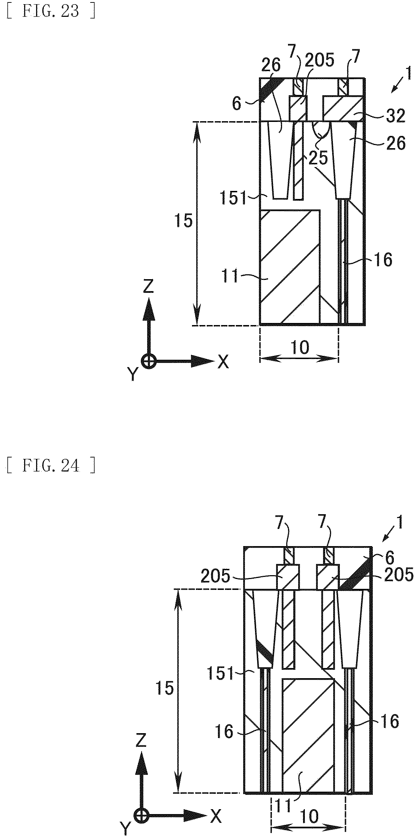

FIG. 22 illustrates an example of a specific planar configuration of the pixel 10 and the pixel circuit 20. FIG. 23 illustrates a vertical cross-sectional configuration of a portion of the pixel 10 and the pixel circuit 20 (a cross-section sectioned along a section line G-G illustrated in FIG. 22). FIG. 24 illustrates a vertical cross-sectional configuration of another portion of the pixel 10 and the pixel circuit 20 (a cross-section sectioned along a section line H-H illustrated in FIG. 22).

The plurality of transfer gate electrodes 205 of the transfer transistor 12 (see FIG. 1) is disposed in the solid-state imaging device 1 according to the second modification example of the fourth embodiment, as illustrated in FIGs. 22 to 24.

To give detailed description, the transistor 200 is disposed, and here, two transfer gate electrodes 205 are further disposed, at the position corresponding to one pixel 10. The two transfer gate electrodes 205 are disposed along the diagonal D2-D2 with the FD region 25 sandwiched therebetween, in a plan view. Here, as for the planar shape, the transfer gate electrode 205 is formed in a triangular shape. Moreover, one of the two transfer gate electrodes 205 is formed in a shape in line symmetry with another one of the transfer gate electrodes 205 centering around the diagonal D1-D1.

Components other than the above-described components are components the same or substantially the same as the components of the solid-state imaging device 1 according to the fourth embodiment.

It is to be noted that the planar shape of the transfer gate electrode 205 may be a circular shape, an elliptical shape, or a polygonal shape having five or more corners, in addition to the above shape.

### [Workings and Effects]

The solid-state imaging device 1 according to the second modification example of the fourth embodiment makes it possible to achieve workings and effects similar to the workings and effects achievable by the solid-state imaging device 1 according to the fourth embodiment.

Further, in the solid-state imaging device 1, the plurality of transfer gate electrodes 205 is disposed at the position corresponding to the pixel 10, as illustrated in FIGs. 22 to 24. This expands the effective dimension of the gate width Wg of the transfer gate electrodes 205 of the transfer transistor 12, thus making it possible to improve the efficiency of reading the electric charge from the pixel 10 to the pixel circuit 20.

### <5. Fifth Embodiment>

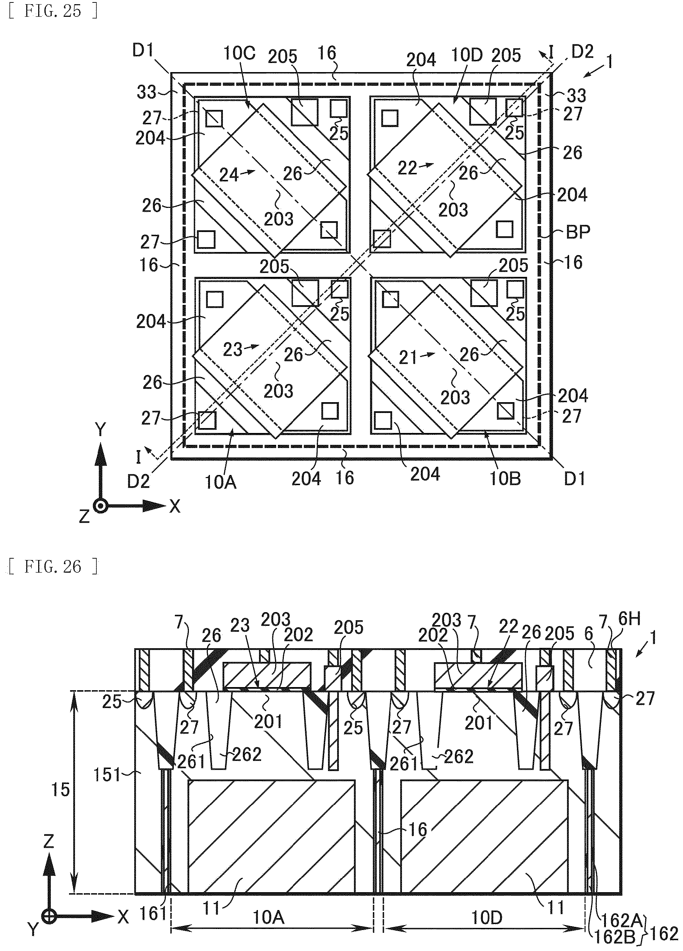

Description is given of the solid-state imaging device 1 according to the fifth embodiment of the present disclosure with reference to FIGs. 25 and 26.

### [Configuration of Solid-State Imaging Device 1]

FIG. 25 illustrates an example of a specific planar configuration of the pixels 10 and the pixel circuit 20. FIG. 26 illustrates a vertical cross-sectional configuration of a portion of the pixels 10 and the pixel circuit 20 (a cross-section sectioned along a section line I-I illustrated in FIG. 25).

In the solid-state imaging device 1 according to the fifth embodiment, the pixels 10 illustrated in FIG. 2 and described for the solid-state imaging device 1 according to the first embodiment are repeatedly disposed in the arrow-X direction and the arrow-Y direction, as illustrated in FIGs. 25 and 26.

To give detailed description, the pixels 10 are not formed in a shape in line symmetry with each other in the arrangement direction. That is, the transistors 200, of which the direction of the gate length Lg coincides with the diagonal D1-D1, are disposed in the plurality of arranged pixels 10. In other words, the respective transistors 200 of the plurality of arranged pixels 10 all have the direction of the gate length Lg in the same direction.

In addition, the respective wiring 7 allows for electrical coupling between the main electrodes 204 of the transistor 200, between the FD regions 25, and between the base coupling sections 27. Each of the shared coupling section 31, the shared coupling section 32, and the shared coupling section 33 of the solid-state imaging device 1 according to the first embodiment is not formed.

Components other than the above-described components are components the same or substantially the same as the components of the solid-state imaging device 1 according to the first embodiment.

It is to be noted that the plurality of pixels 10 including the transistors 200 of which the direction of the gate length Lg coincides with the diagonal D2-D2 may be arranged.

### [Workings and Effects]

The solid-state imaging device 1 according to the fifth embodiment makes it possible to achieve workings and effects similar to the workings and effects achievable by the solid-state imaging device 1 according to the first embodiment.

Further, in the solid-state imaging device 1, the transistors 200, of which the direction of the gate length Lg is aligned in the same direction, are disposed in respective ones of the plurality of arranged pixels 10, as illustrated in FIGs. 25 and 26. In addition, the respective wiring 7 allows for electrical coupling between the main electrodes 204 of the transistor 200, between the FD regions 25, and between the base coupling sections 27.

Such a configuration makes it possible to omit each of the components, i.e., the shared coupling section 31 that couples the main electrodes 204 to each other, the shared coupling section 32 that couples the FD regions 25 to each other, and the shared coupling section 33 that couples the base coupling sections 27 to each other. This makes it possible to simplify a manufacturing process of the shared coupling section 31, the shared coupling section 32, and the shared coupling section 33.

### <6. Sixth Embodiment>

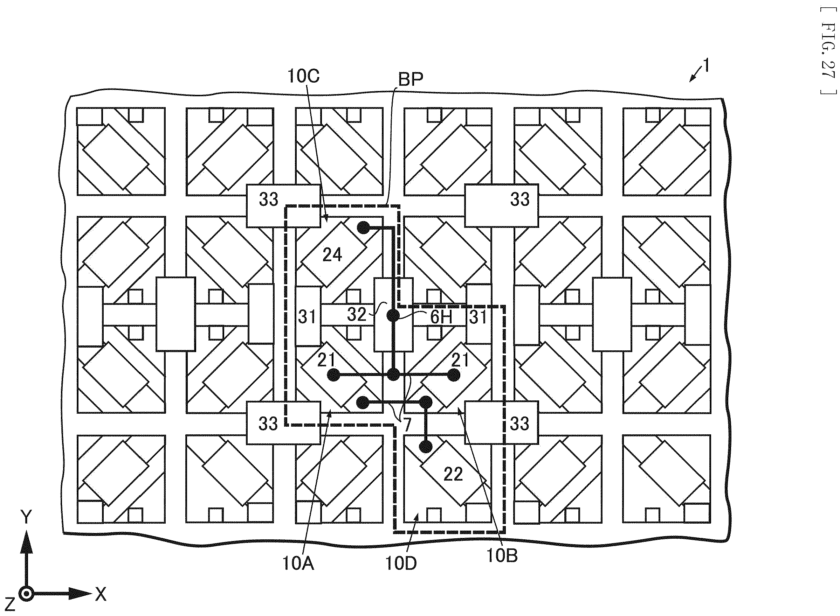

Description is given of the solid-state imaging device 1 according to the sixth embodiment of the present disclosure with reference to FIG. 27.

### [Configuration of Solid-State Imaging Device 1]

FIG. 27 illustrates an example of a specific planar configuration of the pixels 10 and the pixel circuits 20.

In the solid-state imaging device 1 according to the sixth embodiment, the pixel circuit 20 includes two amplification transistors 21 electrically coupled in parallel to each other, the selection transistor 22, and the reset transistor 24, as illustrated in FIG. 27.

One amplification transistor 21 of the two amplification transistors 21 is disposed at the position corresponding to the pixel 10A. Another amplification transistor 21 of the two amplification transistors 21 is disposed at the position corresponding to the pixel 10B adjacent to the pixel 10A in the arrow-X direction. The other amplification transistor 21 is formed in a shape in line symmetry with the one amplification transistor 21 centering around the pixel separation region 16 between the pixel 10A and the pixel 10B.

Meanwhile, the reset transistor 24 is disposed at the position corresponding to the pixel 10C adjacent to the pixel 10A in the arrow-Y direction. The reset transistor 24 is formed in a shape in line symmetry with the one amplification transistor 21 centering around the pixel separation region 16 between the pixel 10A and the pixel 10C.

The selection transistor 22 is disposed at the position corresponding to the pixel 10D adjacent to the pixel 10B in a direction opposite to the arrow-Y direction. The selection transistor 22 is formed in a shape in line symmetry with the other amplification transistor 21 centering around the pixel separation region 16 between the pixel 10B and the pixel 10D.

The wiring 7 allows for electrical coupling between the FD region 25 and the gate electrode 203 of the amplification transistor 21, between the main electrode 204 of the amplification transistor 21 and the main electrode 204 of the selection transistor 22, and so on.

Components other than the above-described components are components the same or substantially the same as the components of the solid-state imaging device 1 according to the first embodiment.

### [Workings and Effects]

The solid-state imaging device 1 according to the sixth embodiment makes it possible to achieve workings and effects similar to the workings and effects achievable by the solid-state imaging device 1 according to the first embodiment.

In addition, in the solid-state imaging device 1, the amplification transistors 21 electrically coupled in parallel to each other are disposed at the positions corresponding to the pixel 10A and the pixel 10B, as illustrated in FIG. 27. The reset transistor 24 is disposed at the position corresponding to the pixel 10C disposed to be adjacent to the pixel 10A. The selection transistor 22 is disposed at the position corresponding to the pixel 10D disposed to be adjacent to the pixel 10B.

This allows the pixels 10 and the transistors 200 to be disposed at positions suitable as wiring coupling locations, resulting in easy wiring coupling using the wiring 7. In addition, a wiring length of the wiring 7 is shortened, thus making it possible to reduce parasitic capacitance to be added to the wiring 7.

### <7. Seventh Embodiment>

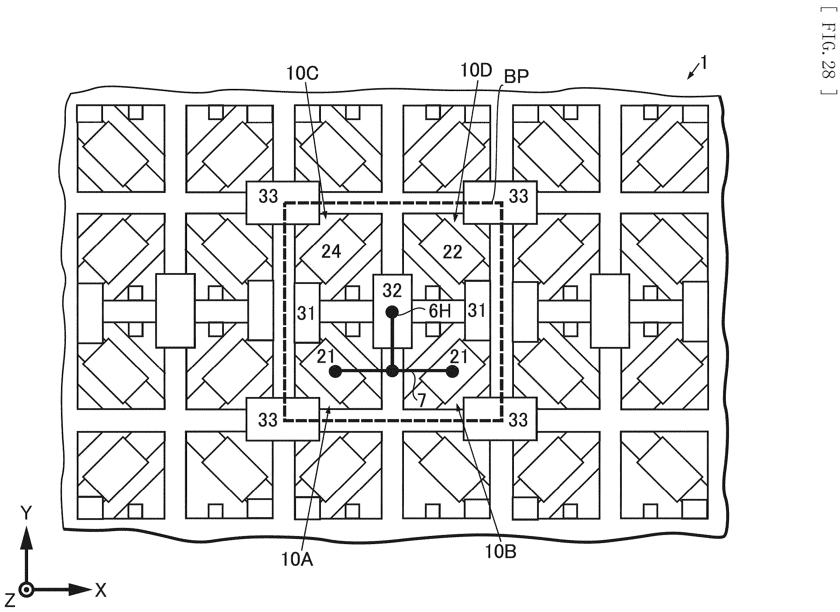

Description is given of the solid-state imaging device 1 according to the seventh embodiment of the present disclosure with reference to FIG. 28.

### [Configuration of Solid-State Imaging Device 1]

FIG. 28 illustrates an example of a specific planar configuration of the pixels 10 and the pixel circuits 20.

In the solid-state imaging device 1 according to the seventh embodiment, the pixel circuit 20 includes two amplification transistors 21 electrically coupled in parallel to each other, the selection transistor 22, and the reset transistor 24, in a similar manner to the solid-state imaging device 1 according to the sixth embodiment, as illustrated in FIG. 28.

One amplification transistor 21 of the two amplification transistors 21 is disposed at the position corresponding to the pixel 10A. Another amplification transistor 21 of the two amplification transistors 21 is disposed at the position corresponding to the pixel 10B adjacent to the pixel 10A in the arrow-X direction. The other amplification transistor 21 is formed in a shape in line symmetry with the one amplification transistor 21 centering around the pixel separation region 16 between the pixel 10A and the pixel 10B.

Meanwhile, the reset transistor 24 is disposed at the position corresponding to the pixel 10C adjacent to the pixel 10A in the arrow-Y direction. The reset transistor 24 is formed in a shape in line symmetry with the one amplification transistor 21 centering around the pixel separation region 16 between the pixel 10A and the pixel 10C.

The selection transistor 22 is disposed at the position corresponding to the pixel 10D adjacent to the pixel 10B in the arrow-Y direction. The selection transistor 22 is formed in a shape in line symmetry with the other amplification transistor 21 centering around the pixel separation region 16 between the pixel 10B and the pixel 10D.

The wiring 7 allows for electrical coupling between the FD region 25 and the gate electrode 203 of the amplification transistor 21, between the main electrode 204 of the amplification transistor 21 and the main electrode 204 of the selection transistor 22, and so on.

Components other than the above-described components are components the same or substantially the same as the components of the solid-state imaging device 1 according to the sixth embodiment.

### [Workings and Effects]

The solid-state imaging device 1 according to the seventh embodiment makes it possible to achieve workings and effects similar to the workings and effects achievable by the solid-state imaging device 1 according to the first embodiment.

### <8. Eighth Embodiment>

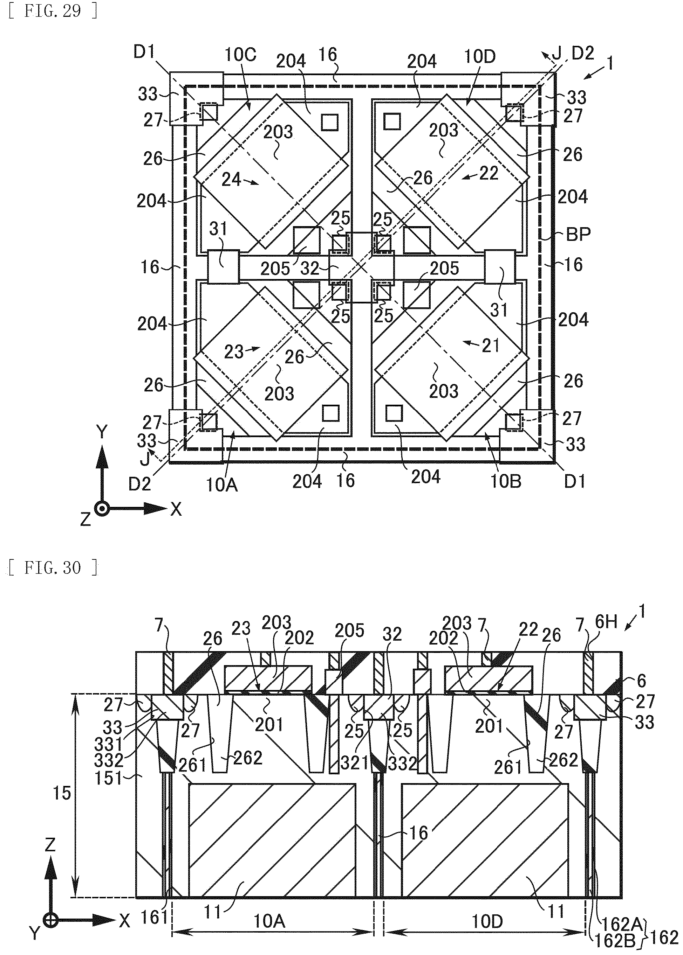

Description is given of the solid-state imaging device 1 according to the eighth embodiment of the present disclosure with reference to FIGs. 29 to 31.

### [Configuration of Solid-State Imaging Device 1]

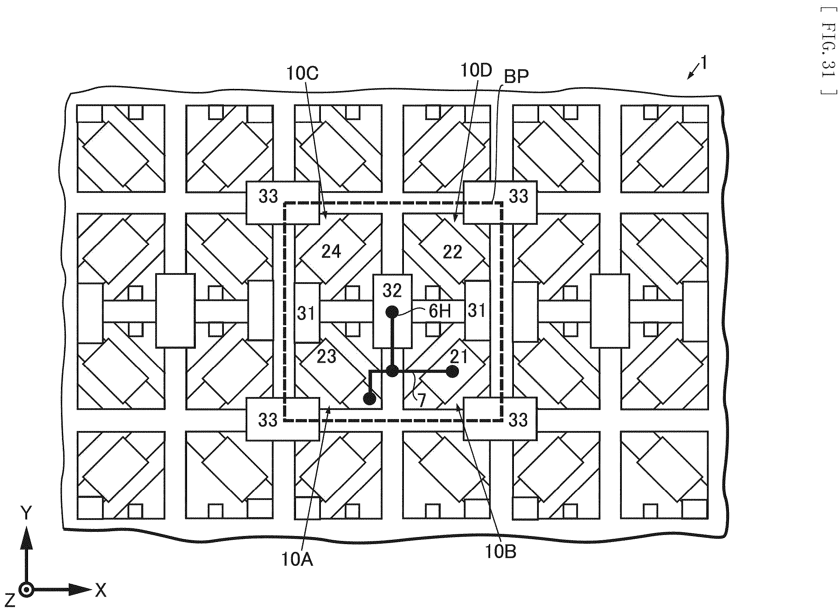

FIG. 29 illustrates an example of a specific planar configuration of the pixels 10 and the pixel circuit 20. FIG. 30 illustrates a vertical cross-sectional configuration of a portion of the pixels 10 and the pixel circuit 20 (a cross-section sectioned along a section line J-J illustrated in FIG. 29). FIG. 31 illustrates an arrangement layout configuration of the unit pixel BP illustrated in FIG. 29 and the pixels 10 (or the unit pixel BP) at a periphery thereof.

In the solid-state imaging device 1 according to the eighth embodiment, the unit pixel BP includes the pixel 10A, the pixel 10B, the pixel 10C, and the pixel 10D, in a similar manner to the solid-state imaging device 1 according to the first embodiment, as illustrated in FIGs. 29 to 31.

The FD conversion gain switching transistor 23 is disposed at the position corresponding to the pixel 10A. The amplification transistor 21 is disposed at the position corresponding to the pixel 10B. The reset transistor 24 is disposed at the position corresponding to the pixel 10C. The selection transistor 22 is disposed at the position corresponding to the pixel 10D.

In addition, the main electrode 204 of the amplification transistor 21 and the main electrode of the selection transistor 22 are electrically coupled to each other through the shared coupling section 31. The main electrode 204 of the FD conversion gain switching transistor 23 and the main electrode 204 of the reset transistor 204 are electrically coupled to each other through the shared coupling section 31.

The shared coupling section 31 has a shared trench 311 and includes a coupling conductor 312, as illustrated in FIG. 30.

The shared trench 311 is formed as a stop hole dug down from an upper surface (the second surface) of the pixel separation region 16 toward a side of a lower surface (the first surface) thereof. The stop hole is between the main electrodes 204. For example, the shared trench 311 is formed to have a depth about the same as a junction depth of the main electrode 204. Here, the shared trench 311 is formed to have a depth shallower than the depth of the second trench 261 of the element separation region 26.

The coupling conductor 312 is embedded in the shared trench 311. The coupling conductor 312 is directly coupled to side surfaces of the main electrodes 204.

The coupling conductor 312 is formed by a gate electrode material, e.g., a polycrystalline silicon film. The polycrystalline silicon film contains, at high impurity density, an impurity that reduces a resistance value. For example, it is possible to practically use, as the impurity, phosphorus that is an n-type impurity.

The shared coupling section 32 has a shared trench 321 and includes a coupling conductor 322, in a similar manner to the shared coupling section 31.

The shared coupling section 33 has a shared trench 331 and includes a coupling conductor 332, in a similar manner to the shared coupling section 31. Here, in a case where the coupling conductor 332 is formed by, for example, a polycrystalline silicon film, the polycrystalline silicon film contains, at high impurity density, a p-type impurity that reduces a resistance value.

Components other than the above-described components are components the same or substantially the same as the components of the solid-state imaging device 1 according to the first embodiment.

### [Workings and Effects]

The solid-state imaging device 1 according to the eighth embodiment makes it possible to achieve workings and effects similar to the workings and effects achievable by the solid-state imaging device 1 according to the first embodiment.

Moreover, the solid-state imaging device 1 includes the shared coupling section 31, as illustrated in FIGs. 29 to 31. The shared coupling section 31 has the shared trench 311 and includes the coupling conductor 312 embedded in the shared trench 311.

Such a configuration makes it possible to electrically couple the main electrodes 204 of the transistors 200 to each other without forming the coupling hole and the wiring over the pixel separation region 16. This results in effectively no area that is on the main surface of the base 15 and couples the main electrodes 204 to each other. This makes it possible to secure the area sufficient to dispose the transistor 200 in the pixel 10.

In addition, the shared coupling section 31 is directly coupled to the side surfaces of the main electrodes 204 of the transistors 200. That is, the area that couples the shared coupling section 31 and the main electrode 204 to each other is secured in the arrow-Z direction, and is substantially not necessary on the main surface of the base 15.

Further, the solid-state imaging device 1 includes the shared coupling section 32 that couples the FD regions 25 to each other, and the shared coupling section 33 that couples the base coupling sections 27 to each other, in a similar manner to the shared coupling section 31. This enables achievement of workings and effects similar to the workings and effects achievable by the shared coupling section 31.

### <9. Ninth Embodiment>

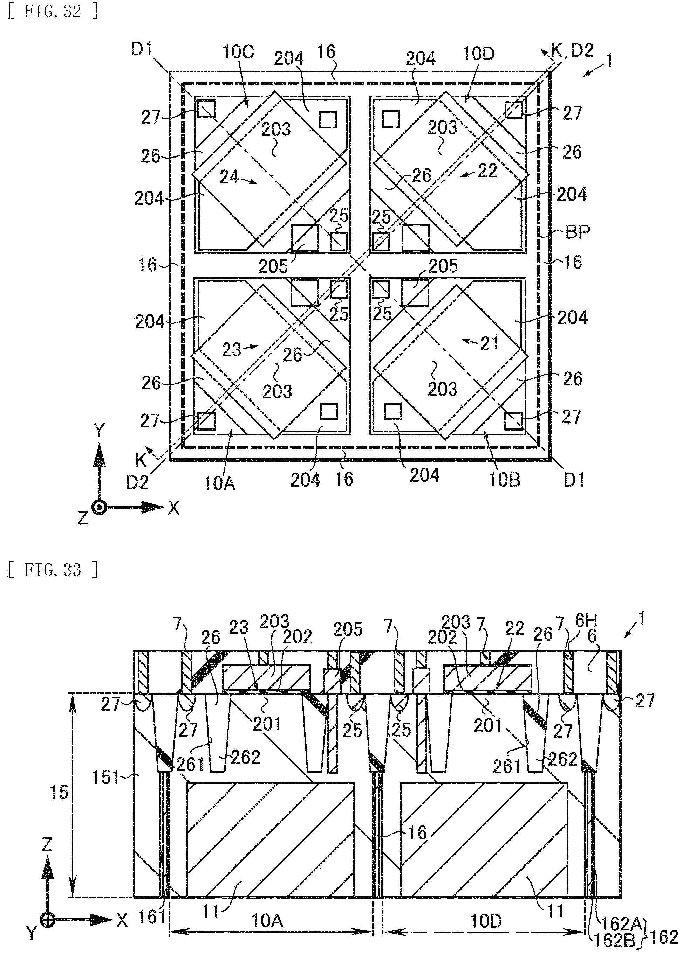

Description is given of the solid-state imaging device 1 according to the ninth embodiment of the present disclosure with reference to FIGs. 32 and 33.

### [Configuration of Solid-State Imaging Device 1]

FIG. 32 illustrates an example of a specific planar configuration of the pixels 10 and the pixel circuit 20. FIG. 33 illustrates a vertical cross-sectional configuration of a portion of the pixels 10 and the pixel circuit 20 (a cross-section sectioned along a section line K-K illustrated in FIG. 30).

The solid-state imaging device 1 according to the ninth embodiment does not include the shared coupling section 31, the shared coupling section 32, and the shared coupling section 33 included in the solid-state imaging device 1 according to the eighth embodiment, as illustrated in FIGs. 32 and 33. The wiring 7 is directly coupled to the base coupling section 27, the FD region 25, the main electrodes 204 of the transistor 200, and the like.

Components other than the above-described components are components the same or substantially the same as the components of the solid-state imaging device 1 according to the first embodiment.

### [Workings and Effects]

The solid-state imaging device 1 according to the ninth embodiment makes it possible to achieve workings and effects similar to the workings and effects achievable by the solid-state imaging device 1 according to the first embodiment.

In addition, in the solid-state imaging device 1, the wiring 7 is coupled to the base coupling section 27, the FD region 25, the main electrodes 204 of the transistor 200, and the like, as illustrated in FIGs. 32 and 33.

In particular, the respective FD regions 25 gathered in a middle of the plurality of pixels 10 are not shared and are individually coupled to the wiring 7 without disposing the shared coupling section 32 of the solid-state imaging device 1 according to the eighth embodiment.

This makes it possible to reduce parasitic capacitance to be generated between the FD region 25 and, for example, the transfer gate electrode 205, thus enabling improvement in the efficiency of reading the electric charge from the pixel 10 to the pixel circuit 20.

### <10. Tenth Embodiment>

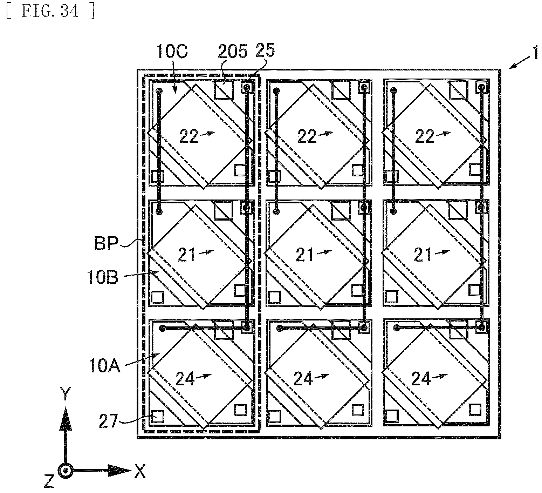

Description is given of the solid-state imaging device 1 according to the tenth embodiment of the present disclosure with reference to FIGs. 34 to 37. The tenth embodiment describes a construction example of the unit pixel BP of the solid-state imaging device 1.

### [Configuration of Solid-State Imaging Device 1]

FIG. 34 illustrates an example of a specific planar configuration of the pixels 10 and the pixel circuits 20.

The solid-state imaging device 1 according to the tenth embodiment has a configuration in which the unit pixel BP is constructed by a total of three pixels 10, i.e., the pixel 10A, the pixel 10B, and the pixel 10C arranged in the arrow-Y direction, in the solid-state imaging device 1 according to the fifth embodiment, as illustrated in FIG. 34.

The reset transistor 24 is disposed at the position corresponding to the pixel 10A. The amplification transistor 21 is disposed at the position corresponding to the pixel 10B. The selection transistor 22 is disposed at the position corresponding to the pixel 10C. Each of the reset transistor 24, the amplification transistor 21, and the selection transistor 22 is disposed to allow the direction of the gate length Lg to coincide with the diagonal D1-D1 (see FIG. 2).

That is, each of the pixel 10A, the pixel 10B, and the pixel 10C constructing the unit pixel BP is repeatedly disposed in the arrow-X direction. Moreover, the unit pixel BP is repeatedly disposed in the arrow-X direction and the arrow-Y direction.

Components other than the above-described components are components the same or substantially the same as the components of the solid-state imaging device 1 according to the fifth embodiment.

### [Workings and Effects]

The solid-state imaging device 1 according to the tenth embodiment makes it possible to achieve workings and effects similar to the workings and effects achievable by the solid-state imaging device 1 according to the fifth embodiment.

### [First Modification Example]

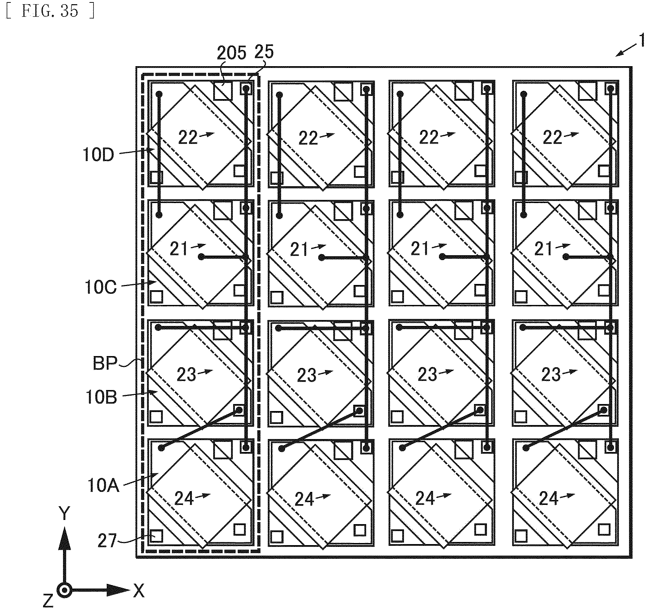

FIG. 35 illustrates an example of a specific planar configuration of the pixels 10 and the pixel circuits 20 of the solid-state imaging device 1 according to a first modification example of the tenth embodiment.

In the solid-state imaging device 1 according to the first modification example, the unit pixel BP is constructed by a total of four pixels 10, i.e., the pixel 10A, the pixel 10B, the pixel 10C, and the pixel 10D arranged in the arrow-Y direction, as illustrated in FIG. 35.

The reset transistor 24 is disposed at the position corresponding to the pixel 10A. The FD conversion gain switching transistor 23 is disposed at the position corresponding to the pixel 10B. The amplification transistor 21 is disposed at the position corresponding to the pixel 10C. The selection transistor 22 is disposed at the position corresponding to the pixel 10D. Each of the reset transistor 24, the FD conversion gain switching transistor 23, the amplification transistor 21, and the selection transistor 22 is disposed to allow the direction of the gate length Lg to coincide with the diagonal D1-D1 (see FIG. 2).

That is, each of the pixel 10A, the pixel 10B, the pixel 10C, and the pixel 10D constructing the unit pixel BP is repeatedly disposed in the arrow-X direction. Moreover, the unit pixel BP is repeatedly disposed in the arrow-X direction and the arrow-Y direction.

Components other than the above-described components are components the same or substantially the same as the components of the solid-state imaging device 1 according to the fifth embodiment.

### [Workings and Effects]

The solid-state imaging device 1 according to the first modification example of the tenth embodiment makes it possible to achieve workings and effects similar to the workings and effects achievable by the solid-state imaging device 1 according to the fifth embodiment.

### [Second Modification Example]

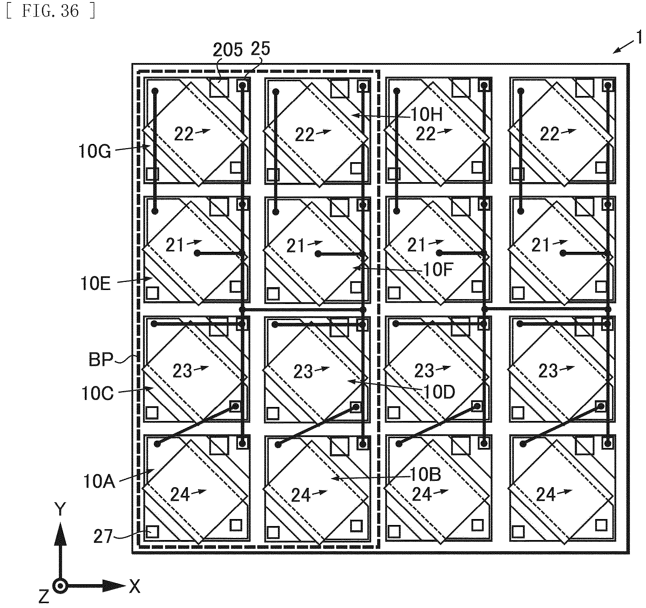

FIG. 36 illustrates an example of a specific planar configuration of the pixels 10 and the pixel circuits 20 of the solid-state imaging device 1 according to a second modification example of the tenth embodiment.

In the solid-state imaging device 1 according to the second modification example, the unit pixel BP is constructed by a total of eight pixels 10, i.e., the pixel 10A to a pixel 10H arranged in the arrow-X direction and the arrow-Y direction, as illustrated in FIG. 36.

The pixel 10A and the pixel 10B are disposed to be adjacent to each other in the arrow-X direction. The reset transistor 24 is disposed at a position corresponding to each of the pixel 10A and the pixel 10B.

The pixel 10C and the pixel 10D are disposed to be adjacent to each other in the arrow-X direction, and are further disposed to be adjacent to the pixel 10A and the pixel 10B in the arrow-Y direction. The FD conversion gain switching transistor 23 is disposed at a position corresponding to each of the pixel 10C and the pixel 10D.

The pixel 10E and the pixel 10F are disposed to be adjacent to each other in the arrow-X direction, and are further disposed to be adjacent to the pixel 10C and the pixel 10D in the arrow-Y direction. The amplification transistor 21 is disposed at a position corresponding to each of the pixel 10E and the pixel 10F.

The pixel 10G and the pixel 10H are disposed to be adjacent to each other in the arrow-X direction, and are further disposed to be adjacent to the pixel 10E and the pixel 10F in the arrow-Y direction. The selection transistor 22 is disposed at a position corresponding to each of the pixel 10G and the pixel 10H.

Each of the reset transistor 24, the FD conversion gain switching transistor 23, the amplification transistor 21, and the selection transistor 22 is disposed to allow the direction of the gate length Lg to coincide with the diagonal D1-D1 (see FIG. 2).

That is, each of the pixel 10A to the pixel 10H constructing the unit pixel BP is repeatedly disposed in the arrow-X direction. Moreover, the unit pixel BP is repeatedly disposed in the arrow-X direction and the arrow-Y direction.

Components other than the above-described components are components the same or substantially the same as the components of the solid-state imaging device 1 according to the fifth embodiment.

### [Workings and Effects]

The solid-state imaging device 1 according to the second modification example of the tenth embodiment makes it possible to achieve workings and effects similar to the workings and effects achievable by the solid-state imaging device 1 according to the fifth embodiment.

### [Third Modification Example]

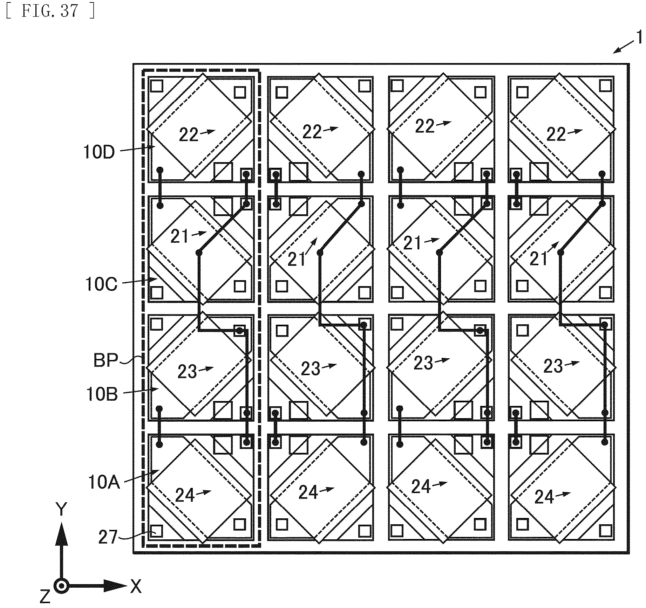

FIG. 37 illustrates an example of a specific planar configuration of the pixels 10 and the pixel circuits 20 of the solid-state imaging device 1 according to a third modification example of the tenth embodiment.

In the solid-state imaging device 1 according to the third modification example, the unit pixel BP is constructed by a total of four pixels 10, i.e., the pixel 10A, the pixel 10B, the pixel 10C, and the pixel 10D arranged in the arrow-Y direction, in a similar manner to the solid-state imaging device 1 according to the first modification example, as illustrated in FIG. 37.

The reset transistor 24 is disposed at the position corresponding to the pixel 10A.

The FD conversion gain switching transistor 23 is disposed at the position corresponding to the pixel 10B. The FD conversion gain switching transistor 23 is formed in a shape in line symmetry with the reset transistor 24.

The amplification transistor 21 is disposed at the position corresponding to the pixel 10C. The amplification transistor 21 is formed in a shape in line symmetry with the FD conversion gain switching transistor 23.

The selection transistor 22 is disposed at the position corresponding to the pixel 10D. The selection transistor 22 is formed in a shape in line symmetry with the amplification transistor 21.

That is, each of the pixel 10A, the pixel 10B, the pixel 10C, and the pixel 10D constructing the unit pixel BP is formed in a shape in line symmetry with a corresponding one thereof. Moreover, the unit pixels BP are formed in a shape in line symmetry with each other in the arrow-X direction and the arrow-Y direction.

Components other than the above-described components are components the same or substantially the same as the components of the solid-state imaging device 1 according to the fifth embodiment.

### [Workings and Effects]

The solid-state imaging device 1 according to the third modification example of the tenth embodiment makes it possible to achieve workings and effects similar to the workings and effects achievable by the solid-state imaging device 1 according to the fifth embodiment.

### < 11. Eleventh Embodiment>

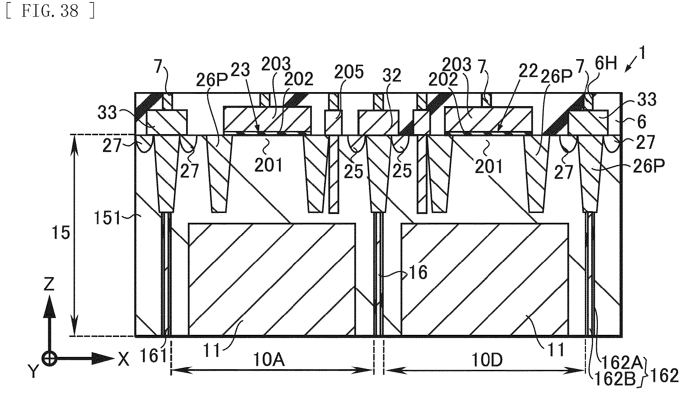

Description is given of the solid-state imaging device 1 according to the eleventh embodiment of the present disclosure with reference to FIG. 38.

### [Configuration of Solid-State Imaging Device 1]

FIG. 38 illustrates a vertical cross-sectional configuration of a portion of the pixels 10 and the pixel circuit 20 (a vertical cross-sectional configuration corresponding to FIG. 4 described above).

The solid-state imaging device 1 according to the eleventh embodiment includes an element separation region 26P instead of the element separation region 26 of the solid-state imaging device 1 according to the first embodiment, as illustrated in FIG. 38. The element separation region 26P is formed by a semiconductor region formed to be of the same p-type as the base 15 and having higher impurity density than the impurity density of the p-type semiconductor region 151 of the base 15.

The element separation region 26P is formed through, for example, an ion implantation method or a solid phase diffusion method.

In the eleventh embodiment, the element separation region 26P is also formed in a portion of the pixel separation region 16 on the side of the second surface, and the pixel separation region 16 includes the element separation region 26P.

Components other than the above-described components are components the same or substantially the same as the components of the solid-state imaging device 1 according to the first embodiment.

### [Workings and Effects]

The solid-state imaging device 1 according to the eleventh embodiment makes it possible to achieve workings and effects similar to the workings and effects achievable by the solid-state imaging device 1 according to the first embodiment.

In addition, the solid-state imaging device 1 includes the element separation region 26P, as illustrated in FIG. 38. There is no necessity to form, in the element separation region 26P, the second trench 261 and the second embedded member 262 of the element separation region 26. This makes it possible to easily construct the solid-state imaging device 1.

### <12. Twelfth Embodiment>

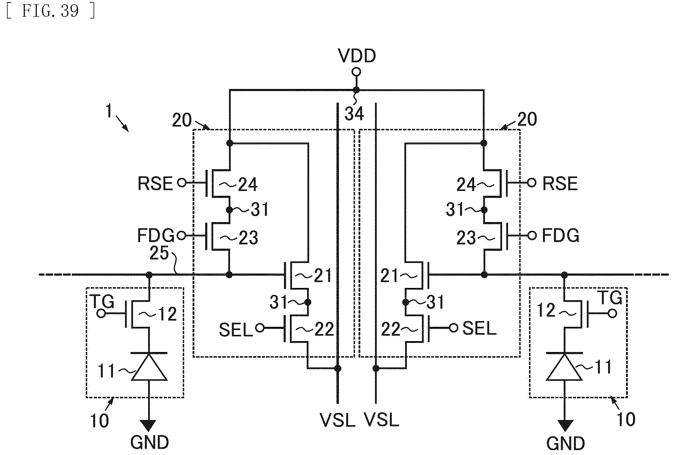

Description is given of the solid-state imaging device 1 according to the twelfth embodiment of the present disclosure with reference to FIGs. 39 to 48.

### [Configuration of Solid-State Imaging Device 1]

### (1) Circuit Configuration of Pixel 10 and Pixel Circuit 20 of Solid-State Imaging Device 1

FIG. 39 illustrates an example of a circuit configuration of the pixels 10 and the pixel circuits 20 constructing the solid-state imaging device 1 according to the twelfth embodiment.

A basic configuration of the pixels 10 and the pixel circuits 20 of the solid-state imaging device 1 is the same as the configuration of the pixels 10 and the pixel circuits 20 of the solid-state imaging device 1 according to the first embodiment, as illustrated in FIG. 39.

In the twelfth embodiment, the power supply voltage terminal VDD is shared that is to be coupled to each of the amplification transistor 21 and the reset transistor 24 of the pixel circuit 20 constructing a unit pixel BP 1. Further, the power supply voltage terminal VDD is shared that is to be coupled to each of the amplification transistor 21 and the reset transistor 24 of the pixel circuit 20 constructing a unit pixel BP2 disposed to be adjacent to the unit pixel BP1. Furthermore, the power supply voltage terminal VDD is shared in each of the unit pixel BP1 and the unit pixel BP2.

### (2) Layout Configuration and Vertical Cross-Sectional Configuration of Pixel 10 and Pixel Circuit 20

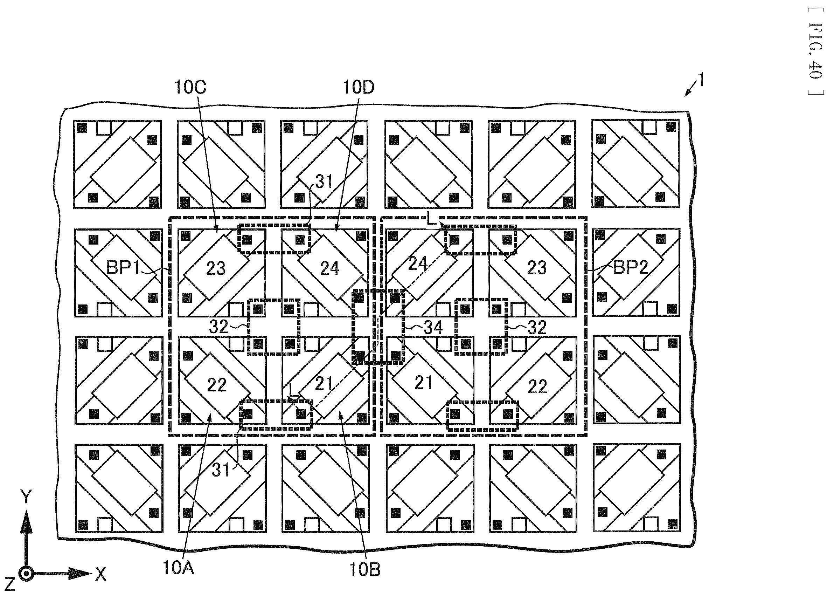

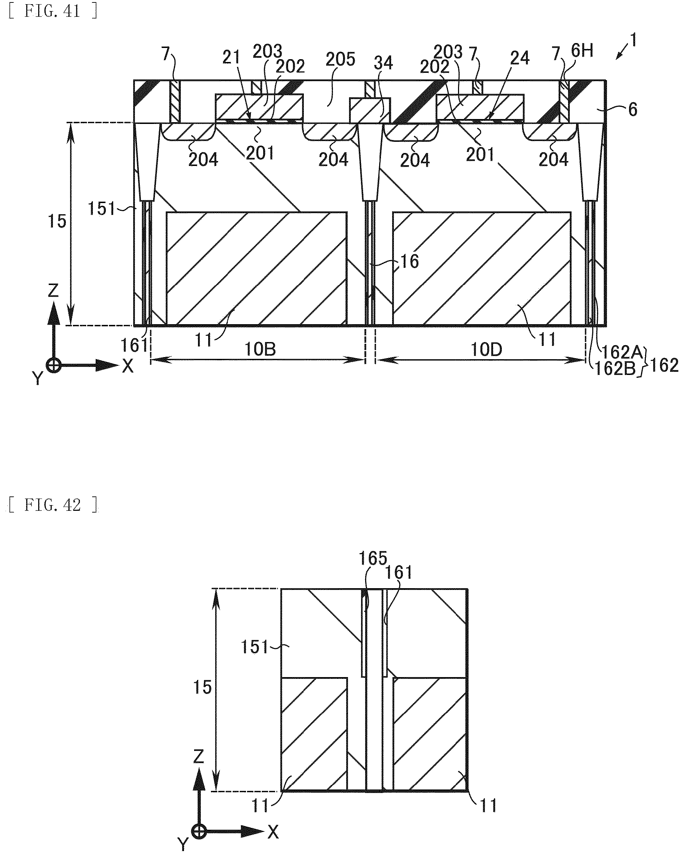

FIG. 40 illustrates an example of a specific planar configuration of the pixels 10 and the pixel circuits 20. FIG. 41 illustrates a vertical cross-sectional configuration of a portion of the pixels 10 and the pixel circuits 20 (a cross-section sectioned along a section line L-L illustrated in FIG. 40).

In the solid-state imaging device 1, one pixel circuit 20 is disposed for four pixels 10, in a similar manner to the solid-state imaging device 1 according to the first embodiment, as illustrated in FIGs. 40 and 41. To give detailed description, the four pixels 10 are two pixels, i.e., the pixel 10A and the pixel 10B, and two pixels, i.e., the pixel 10C and the pixel 10D. The pixel 10A and the pixel 10B are adjacent to each other in the arrow-X direction. The pixel 10C and the pixel 10D are adjacent to the pixel 10A and the pixel 10B in the arrow-Y direction, and are adjacent to each other in the arrow-X direction. The four pixels, i.e., the pixel 10A, the pixel 10B, the pixel 10C, and the pixel 10D, configure the unit pixel BP1.

The reset transistor 24 of the pixel circuit 20 is disposed at the position corresponding to the pixel 10D. The reset transistor 24 is disposed in the region partitioned by the pixel separation region 16 to allow the direction of the gate length Lg to coincide with the diagonal D1-D1 (see FIG. 2).

The amplification transistor 21 of the pixel circuit 20 is disposed at the position corresponding to the pixel 10B. The amplification transistor 21 is disposed in the region partitioned by the pixel separation region 16 to allow the direction of the gate length Lg to coincide with the diagonal D2-D2.

The selection transistor 22 of the pixel circuit 20 is disposed at the position corresponding to the pixel 10A. The selection transistor 22 is disposed in the region partitioned by the pixel separation region 16 to allow the direction of the gate length Lg to coincide with the diagonal D1-D1 (see FIG. 2).

The FD conversion gain switching transistor 23 of the pixel circuit 20 is disposed at the position corresponding to the pixel 10C. The FD conversion gain switching transistor 23 is disposed in the region partitioned by the pixel separation region 16 to allow the direction of the gate length Lg to coincide with the diagonal D2-D2.

In the unit pixel BP 1, the amplification transistor 21 is formed in a shape in line symmetry with the selection transistor 22 centering around the pixel separation region 16 between the pixel 10A and the pixel 10B. The reset transistor 24 is formed in a shape in line symmetry with the FD conversion gain switching transistor 23 centering around the pixel separation region 16 between the pixel 10C and the pixel 10BD. Further, the reset transistor 24 and the FD conversion gain switching transistor 23 are formed in a shape in line symmetry with the amplification transistor 21 and the selection transistor 22 centering around the pixel separation region 16 between the pixel 10A and the pixel 10C and between the pixel 10B and the pixel 10D.

Meanwhile, the unit pixel BP2 is disposed to be adjacent to the unit pixel BP1 in the arrow-X direction. The unit pixel BP2 is formed in a shape in line symmetry with the unit pixel BP1 centering around the pixel separation region 16 between the unit pixel BP1 and the unit pixel BP2.

Such a configuration allows the pixel 10B of the unit pixel BP1 and the pixel 10B of the unit pixel BP2 to be disposed close to each other. In addition, the pixel 10D of the unit pixel BP1 and the pixel 10D of the unit pixel BP2 are disposed close to each other. That is, each of the main electrodes 204 of the amplification transistor 21 and the reset transistor 24 of the unit pixel BP 1 and the main electrodes 204 of the amplification transistor 21 and the reset transistor 24 of the unit pixel BP2 is gathered at one location.

Further, the four main electrodes 204 gathered at the one location are shared and electrically coupled to each other through a shared coupling section 34.

The shared coupling section 34 is electrically coupled directly to the front surfaces of the main electrodes 204, in a similar manner to each of the shared coupling section 31 and the shared coupling section 32 of the solid-state imaging device 1 according to the first embodiment described above.

To give detailed description, one end of the shared coupling section 34 is coupled to, for example, the main electrode 204 of the amplification transistor 21 of the unit pixel BP1. Another end of the shared coupling section 34 is coupled, across the pixel separation region 16, to the respective main electrodes 204 of the reset transistor 24 of the unit pixel BP 1, and of the amplification transistor 21 and the reset transistor 24 of the unit pixel BP2. The shared coupling section 34 is coupled through the wiring 7 to the power supply voltage terminal VDD (see FIG. 39).

It is to be noted that, although description is omitted here because the description has been already given, the shared coupling section 31, the shared coupling section 32, and the shared coupling section 33 allow for coupling between the main electrodes 204, between the FD regions 25, and between the base coupling sections 27, respectively.

Components other than the above-described components are components the same or substantially the same as the components of the solid-state imaging device 1 according to the first embodiment.

### [Manufacturing Method of Solid-State Imaging Device 1]

FIGs. 42 to 48 illustrate an example of the manufacturing method of the solid-state imaging device 1 for each of the steps.

First, the base 15 is prepared.

The first trench 161 is formed in the base 15 in a formation region of the pixel separation region 16, as illustrated in FIG. 42. For example, anisotropic etching such as RIE is used to form the first trench 161.

Here, a mask 165 is formed on an inner wall of the first trench 161 on the side of the second surface. The mask 165 is used as a mask adapted to resist impurity introduction. For example, a silicon nitride film is used as the mask 165.

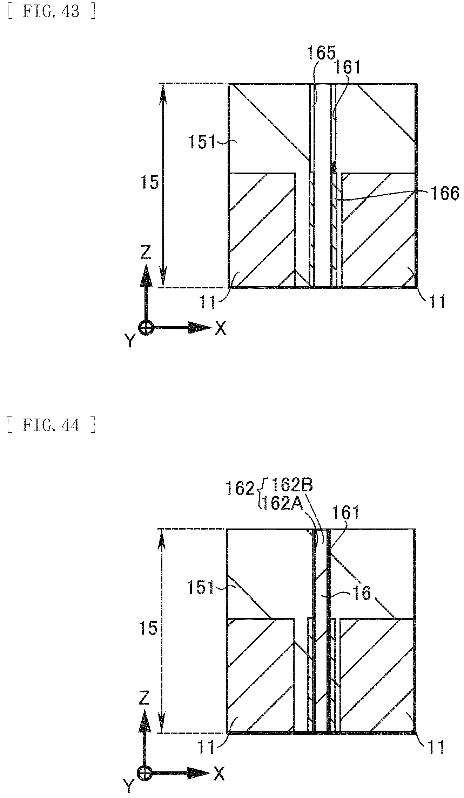

The mask 165 is used to introduce, for example, a p-type impurity into the base 15 from the inner wall of the first trench 161, thereby forming a pinning region 166, as illustrated in FIG. 43.

Thereafter, the mask 165 is removed.

The first embedded member 162 is embedded in the first trench 161 to form the pixel separation region 16, as illustrated in FIG. 44.

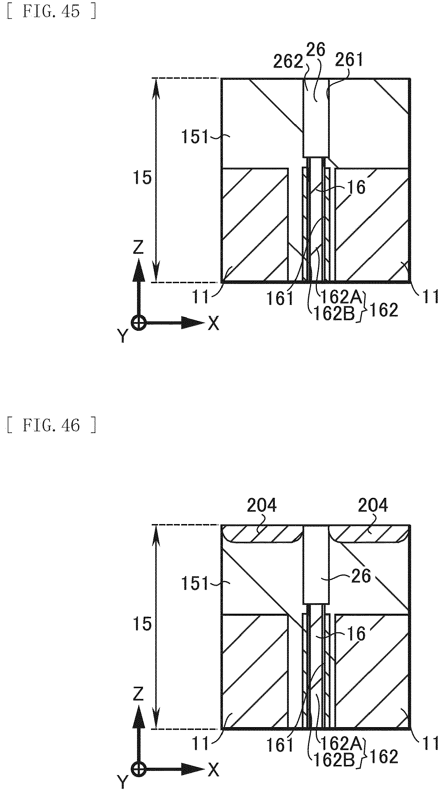

The element separation region 26 is formed, as illustrated in FIG. 45. The element separation region 26 is formed between respective ones of the transistor 200, the FD region 25, and the base coupling section 27. Here, the element separation region 26 is also formed in a portion of the pixel separation region 16 on the side of the second surface.

The element separation region 26 is formed by forming the second trench 261 from the upper surface to the side of the lower surface of the base 15 and embedding the second embedded member 262 in the second trench 261. The second trench 261 is formed to be shallower than the first trench 161. For example, anisotropic etching such as RIE is used to form the second trench 261. For example, a CVD method is used to form the second embedded member 262.

The unillustrated gate insulating film 202 and gate electrode 203 are sequentially formed on the second surface of the base 15 in the region of which the periphery is surrounded by the pixel separation region 16 and the element separation region 26 (see FIG. 8). Subsequently, the main electrodes 204 of the transistor 200 are formed, as illustrated in FIG. 46. The formation of the main electrodes 204 completes the transistor 200.

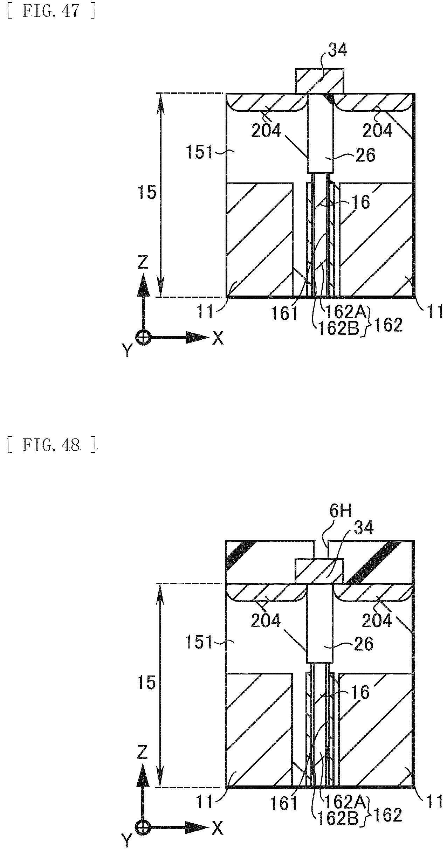

The shared coupling section 34 that couples the main electrodes 204 of the transistors 200 to each other is formed over the pixel separation region 16, as illustrated in FIG. 47. The shared coupling section 34 is formed through the same step as the step of forming the shared coupling section 31 and the shared coupling section 32, of which illustration is omitted here.

Each of the interlayer insulating film 6 and the coupling hole 6H is sequentially formed. The wiring 7 is formed, as illustrated in FIG. 48. The wiring 7 illustrated in FIG. 48 couples the shared coupling section 34 to the power supply voltage terminal VDD.

When the series of steps ends, the solid-state imaging device 1 according to the twelfth embodiment is completed, and the manufacturing method ends.

### [Workings and Effects]

The solid-state imaging device 1 according to the twelfth embodiment makes it possible to achieve workings and effects similar to the workings and effects achievable by the solid-state imaging device 1 according to the first embodiment.

In addition, the solid-state imaging device 1 includes the pixel 10, the transistor 200, the pixel separation region 16, and the shared coupling section 34, as illustrated in FIGs. 40 and 41.

The pixel 10 includes the photoelectric conversion element 11 that is disposed on the side of the first surface of the base 15 and that converts light into electric charge. The side of the first surface is the light incident side. Here, the pixel 10 is each of the "first pixel" and the "second pixel" according to the present technology. The "first pixel" is, for example, the pixel 10B or the pixel 10D of the unit pixel BP1. The "second pixel" is, for example, the pixel 10A or the pixel 10C of the unit pixel BP2.

The pixel separation region 16 is disposed between the pixels 10, and is formed in the thickness direction of the base 15. The pixel separation region 16 electrically and optically separates the pixels 10 from each other.

The transistor 200 is disposed on the side of the second surface of the base 15 at the position corresponding to the pixel 10. The direction of the gate length Lg is oblique to the arrangement direction of the pixels 10. The transistor 200 processes the converted electric charge. Here, the transistor 200 is each of the "first transistor" and the "second transistor" according to the present technology. For example, in a case where the "first transistor" is disposed at the position corresponding to the pixel 10B of the unit pixel BP1, the "first transistor" is the amplification transistor 21. In a case where the "second transistor" is disposed at the position corresponding to the pixel 10A of the unit pixel BP2, the "second transistor" is the amplification transistor 21. Moreover, in a case where the "first transistor" is disposed at the position corresponding to the pixel 10D of the unit pixel BP1, the "first transistor" is the reset transistor 24. In a case where the "second transistor" is disposed at the position corresponding to the pixel 10D of the unit pixel BP2, the "second transistor" is the reset transistor 24.

The shared coupling section 34 electrically couples the main electrodes 204 of the transistors 200 to each other directly, and supplies the main electrodes 204 with a power supply voltage.

Such a configuration makes it possible to supply the main electrodes 204 of the plurality of transistors 200 with the power supply voltage at one location, without forming the coupling hole and the wiring over the pixel separation region 16. This makes it possible to reduce the coupling location between the main electrode 204 and the power supply voltage terminal VDD, thus enabling the area sufficient to dispose the transistor 200 to be secured in the pixel 10. Here, four coupling locations become one coupling location.

In addition, for example, the area sufficient to dispose the transistor 200 is secured in the pixel 10. This enables the transistor 200 having excellent noise resistance to be constructed, making it possible to improve the electrical reliability of the solid-state imaging device 1.

In addition, in the solid-state imaging device 1, the shared coupling section 34 is coupled through the wiring 7 to the power supply voltage terminal VDD, at a position overlapping with the pixel separation region 16, as illustrated in FIGs. 40 and 41. This makes it possible to increase a spaced distance between the wiring 7 and the transfer gate electrode 205 or the FD region 25, helping to weaken electric field intensity from the wiring 7 to the transfer gate electrode 205 or the FD region 25.

Moreover, in the solid-state imaging device 1 according to the twelfth embodiment, the shared coupling section 34 is coupled to the front surfaces of the main electrodes 204 of the transistors 200, in a similar manner to the solid-state imaging device 1 according to the first embodiment.

### < 13. Thirteenth Embodiment>

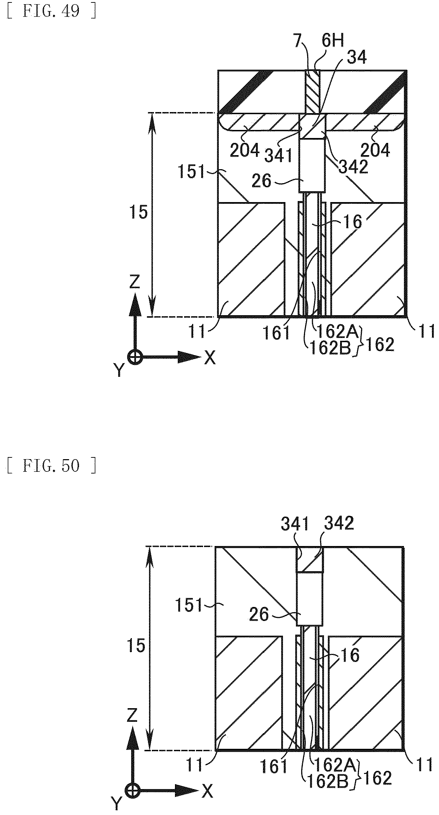

Description is given of the solid-state imaging device 1 according to the thirteenth embodiment of the present disclosure with reference to FIGs. 49 to 51.

### [Configuration of Solid-State Imaging Device 1]

FIG. 49 illustrates a vertical cross-sectional configuration of a portion of the pixels 10 and the pixel circuit 20 (a vertical cross-sectional configuration corresponding to FIG. 48 described above).

The solid-state imaging device 1 according to the thirteenth embodiment has a configuration in which a structure similar to that of the shared coupling section 31 and the shared coupling section 32 of the solid-state imaging device 1 according to the eighth embodiment is used for the structure of the shared coupling section 34 of the solid-state imaging device 1 according to the twelfth embodiment, as illustrated in FIG. 49.

To give detailed description, the shared coupling section 34 has a shared trench 341 and includes a coupling conductor 342. The shared trench 341 has a configuration similar to that of the shared trench 311 of the shared coupling section 31 of the solid-state imaging device according to the eighth embodiment. The coupling conductor 342 has a configuration similar to that of the coupling conductor 312 thereof.

It is to be noted that, although illustration is omitted, each of the shared coupling section 31, the shared coupling section 32, and the shared coupling section 33 is formed to have the same configuration as that of the shared coupling section 34.

Components other than the above-described components are components the same or substantially the same as the components of the solid-state imaging device 1 according to the eighth embodiment.

### [Manufacturing Method of Solid-State Imaging Device 1]

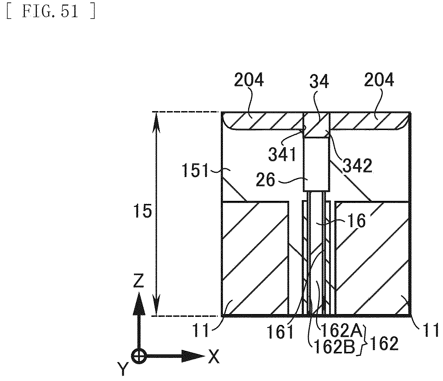

FIGs. 50 and 51 illustrate an example of the manufacturing method of the solid-state imaging device 1 for each of the steps.

After the step illustrated in FIG. 45 of the manufacturing method of the solid-state imaging device 1 according to the twelfth embodiment described above, the shared trench 341 is formed in a portion of the pixel separation region 16 on the side of the second surface (see FIG. 50). The shared trench 341 is formed through the same step as that of the shared trench 311 of the unillustrated shared coupling section 31.

The coupling conductor 342 is formed in the shared trench 341, as illustrated in FIG. 50. The coupling conductor 341 is formed through the same step as that of the coupling conductor 312 of the unillustrated shared coupling section 31.

An n-type impurity is introduced into the coupling conductor 342 to form the shared coupling section 34, as illustrated in FIG. 51. The shared coupling section 34 is formed through the same step as that of the shared coupling section 31.

Each of the interlayer insulating film 6 and the coupling hole 6H is sequentially formed. The wiring 7 is formed, as illustrated in FIG. 49 described above. The wiring 7 illustrated in FIG. 49 couples the shared coupling section 34 to the power supply voltage terminal VDD.

When the series of steps ends, the solid-state imaging device 1 according to the thirteenth embodiment is completed, and the manufacturing method ends.

### [Workings and Effects]

The solid-state imaging device 1 according to the thirteenth embodiment makes it possible to achieve workings and effects similar to the workings and effects achievable by the solid-state imaging device 1 according to the twelfth embodiment.

Further, the solid-state imaging device 1 according to the thirteenth embodiment makes it possible to achieve workings and effects achieved by combining the solid-state imaging device 1 according to the twelfth embodiment and the solid-state imaging device 1 according to the eighth embodiment.

### <14. Fourteenth Embodiment>

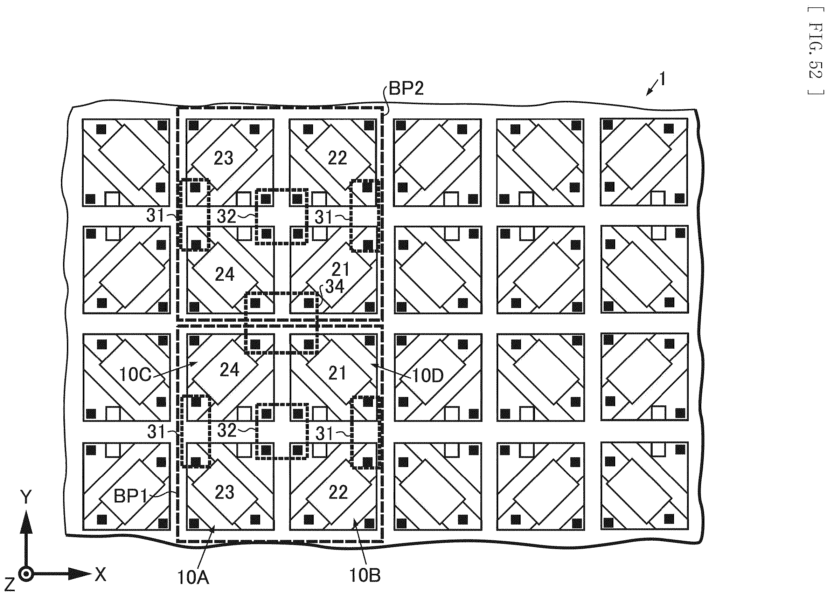

Description is given of the solid-state imaging device 1 according to the eleventh embodiment of the present disclosure with reference to FIG. 52.

### [Configuration of Solid-State Imaging Device 1]

FIG. 52 illustrates an example of a specific planar configuration of the pixels 10 and the pixel circuits 20.

In the solid-state imaging device 1, one pixel circuit 20 is disposed for four pixels 10, in a similar manner to the solid-state imaging device 1 according to the twelfth embodiment, as illustrated in FIG. 52. To give detailed description, the four pixels 10 are two pixels, i.e., the pixel 10A and the pixel 10B, and two pixels, i.e., the pixel 10C and the pixel 10D. The pixel 10A and the pixel 10B are adjacent to each other in the arrow-X direction. The pixel 10C and the pixel 10D are adjacent to the pixel 10A and the pixel 10B in the arrow-Y direction, and are adjacent to each other in the arrow-X direction. The four pixels, i.e., the pixel 10A, the pixel 10B, the pixel 10C, and the pixel 10D, configure the unit pixel BP1.

The reset transistor 24 of the pixel circuit 20 is disposed at the position corresponding to the pixel 10C. The reset transistor 24 is disposed in the region partitioned by the pixel separation region 16 to allow the direction of the gate length Lg to coincide with the diagonal D2-D2 (see FIG. 2).

The amplification transistor 21 of the pixel circuit 20 is disposed at the position corresponding to the pixel 10D. The amplification transistor 21 is disposed in the region partitioned by the pixel separation region 16 to allow the direction of the gate length Lg to coincide with the diagonal D1-D1.

The FD conversion gain switching transistor 23 of the pixel circuit 20 is disposed at the position corresponding to the pixel 10A. The FD conversion gain switching transistor 23 is disposed in the region partitioned by the pixel separation region 16 to allow the direction of the gate length Lg to coincide with the diagonal D1-D1.

The selection transistor 22 of the pixel circuit 20 is disposed at the position corresponding to the pixel 10B. The selection transistor 22 is disposed in the region partitioned by the pixel separation region 16 to allow the direction of the gate length Lg to coincide with the diagonal D2-D2 (see FIG. 2).

In the unit pixel BP1, the selection transistor 22 is formed in a shape in line symmetry with the FD conversion gain switching transistor 23 centering around the pixel separation region 16 between the pixel 10A and the pixel 10B. The amplification transistor 21 is formed in a shape in line symmetry with the reset transistor 24 centering around the pixel separation region 16 between the pixel 10C and the pixel 10D. Further, the reset transistor 24 and the amplification transistor 21 are formed in a shape in line symmetry with the FD conversion gain switching transistor 23 and the selection transistor 22 centering around the pixel separation region 16 between the pixel 10A and the pixel 10C and between the pixel 10B and the pixel 10BD.

Meanwhile, the unit pixel BP2 is disposed to be adjacent to the unit pixel BP1 in the arrow-Y direction. The unit pixel BP2 is formed in a shape in line symmetry with the unit pixel BP1 centering around the pixel separation region 16 between the unit pixel BP1 and the unit pixel BP2.

Components other than the above-described components are components the same or substantially the same as the components of the solid-state imaging device 1 according to the twelfth embodiment.

### [Workings and Effects]

The solid-state imaging device 1 according to the fourteenth embodiment makes it possible to achieve workings and effects similar to the workings and effects achievable by the solid-state imaging device 1 according to the twelfth embodiment.

### <15. Fifteenth Embodiment>

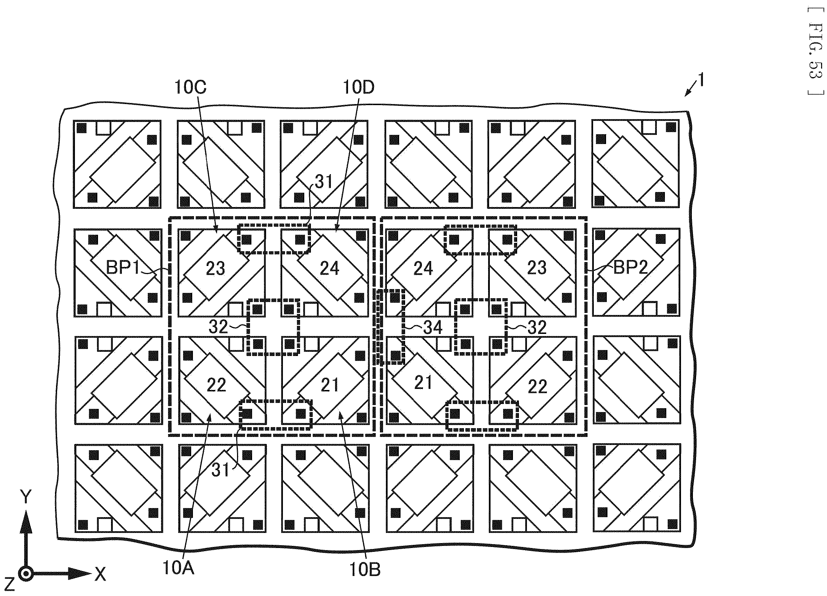

Description is given of the solid-state imaging device 1 according to the fifteenth embodiment of the present disclosure with reference to FIG. 53.

### [Configuration of Solid-State Imaging Device 1]

FIG. 53 illustrates an example of a specific planar configuration of the pixels 10 and the pixel circuits 20.

The solid-state imaging device 1 has a configuration in which the shared coupling section 34 is disposed across two pixels 10, in the solid-state imaging device 1 according to the twelfth embodiment, as illustrated in FIG. 53. To give detailed description, the shared coupling section 34 electrically couples to each other the main electrode 204 of the amplification transistor 21 disposed at the position corresponding to the pixel 10B of the unit pixel BP2 and the main electrode 204 of the reset transistor 24 disposed at the position corresponding to the pixel 10D of the same unit pixel BP2. That is, the shared coupling section 34 is formed in a rectangular shape elongated in the arrow-Y direction in a plan view.

The wiring 7 is configured to be coupled to each of the main electrode 204 of the amplification transistor 21 disposed at the position corresponding to the pixel 10B of the unit pixel BP1 and the main electrode 204 of the reset transistor 24 disposed at the position corresponding to the pixel 10D of the same unit pixel BP1.

Components other than the above-described components are components the same or substantially the same as the components of the solid-state imaging device 1 according to the twelfth embodiment.

### [Workings and Effects]

The solid-state imaging device 1 according to the fifteenth embodiment makes it possible to achieve workings and effects similar to the workings and effects achievable by the solid-state imaging device 1 according to the twelfth embodiment.

### <16. Sixteenth Embodiment>

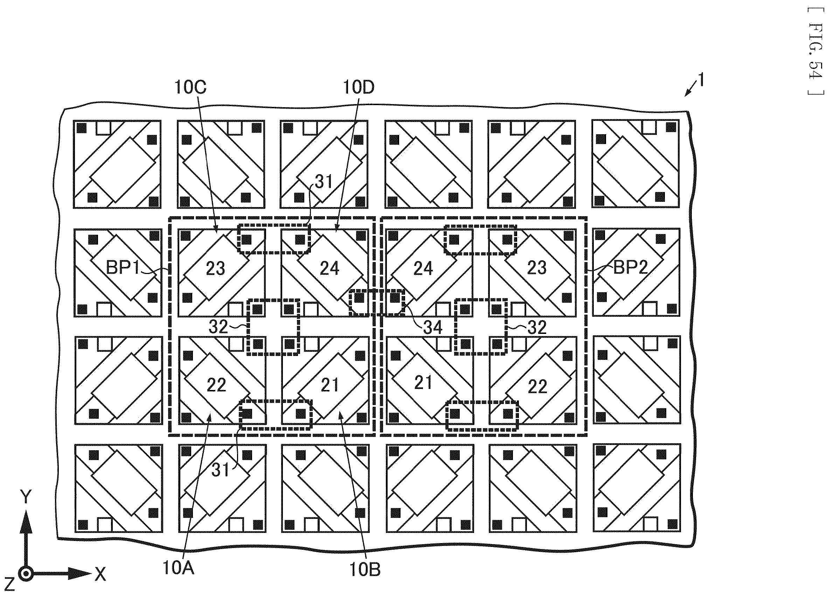

Description is given of the solid-state imaging device 1 according to the sixteenth embodiment of the present disclosure with reference to FIG. 54.

### [Configuration of Solid-State Imaging Device 1]

FIG. 54 illustrates an example of a specific planar configuration of the pixels 10 and the pixel circuits 20.

The solid-state imaging device 1 has a configuration in which the shared coupling section 34 is disposed across two pixels 10, in the solid-state imaging device 1 according to the twelfth embodiment, as illustrated in FIG. 54. To give detailed description, the shared coupling section 34 electrically couples to each other the main electrode 204 of the reset transistor 24 disposed at the position corresponding to the pixel 10D of the unit pixel BP 1 and the main electrode 204 of the reset transistor 24 disposed at the position corresponding to the pixel 10D of the unit pixel BP2. That is, the shared coupling section 34 is formed in a rectangular shape elongated in the arrow-X direction in a plan view.

The wiring 7 is configured to be coupled to each of the main electrode 204 of the amplification transistor 21 disposed at the position corresponding to the pixel 10B of the unit pixel BP1 and the main electrode 204 of the amplification transistor 21 disposed at the position corresponding to the pixel 10B of the unit pixel BP2.

Components other than the above-described components are components the same or substantially the same as the components of the solid-state imaging device 1 according to the twelfth embodiment.

### [Workings and Effects]

The solid-state imaging device 1 according to the sixteenth embodiment makes it possible to achieve workings and effects similar to the workings and effects achievable by the solid-state imaging device 1 according to the twelfth embodiment.

Further, in the solid-state imaging device 1, the main electrodes 204 of the two adjacent reset transistors 24 are coupled to each other through the shared coupling section 34, as illustrated in FIG. 54. In addition, the main electrodes 204 of the two adjacent amplification transistors 21 are coupled to each other through the wiring 7. This makes it possible to supply a power supply voltage from two types of the power supply voltage terminals VDD having different voltages.

### <17. Seventeenth Embodiment>

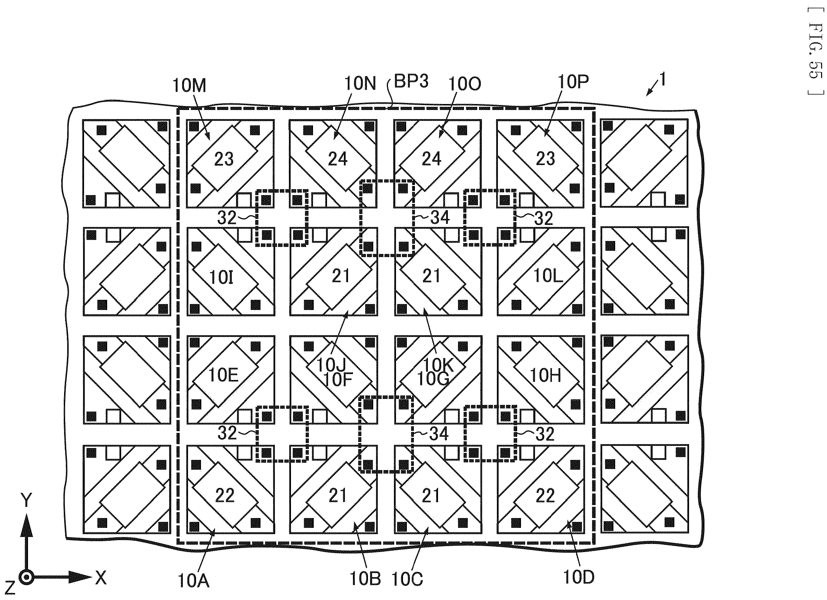

Description is given of the solid-state imaging device 1 according to the seventeenth embodiment of the present disclosure with reference to FIGs. 55 to 57.

### [Configuration of Solid-State Imaging Device 1]

FIG. 55 illustrates an example of a specific planar configuration of the pixels 10 and the pixel circuits 20.

In the solid-state imaging device 1, two pixel circuits 20 are disposed for sixteen pixels 10, as illustrated in FIG. 55.

To give detailed description, the sixteen pixels 10 are the pixel 10A to a pixel 10P. Four pixels, i.e., the pixel 10A to the pixel 10D, are adjacent to each other in the arrow-X direction. Four pixels, i.e., the pixel 10E to the pixel 10H, are adjacent to each other in the arrow-X direction, and are adjacent to the pixel 10A to the pixel 10D in the arrow-Y direction. Four pixels, i.e., the pixel 10I to the pixel 10L, are adjacent to each other in the arrow-X direction, and are adjacent to the pixel 10E to the pixel 10H in the arrow-Y direction. Four pixels, i.e., the pixel 10M to the pixel 10P, are adjacent to each other in the arrow-X direction, and are adjacent to the pixel 10I to the pixel 10L in the arrow-Y direction. The sixteen pixels, i.e., the pixel 10A to the pixel 10P, configure a unit pixel BP3. The unit pixel BP3 illustrated in FIG. 55 is a basic arrangement developable into some modification examples.

The selection transistor 22 of the pixel circuit 20 is disposed at a position corresponding to each of the pixel 10A and the pixel 10D. The selection transistor 22 and the like are disposed to allow the direction of the gate length Lg to coincide with the diagonal D1-D1 or the diagonal D2-D2, in a similar manner to the selection transistor 22 and the like of the solid-state imaging device 1 according to the twelfth embodiment (see FIG. 2).

The amplification transistor 21 of the pixel circuit 20 is disposed at a position corresponding to each of the pixel 10B and the pixel 10C.

The amplification transistor 21 or the selection transistor 22 of the pixel circuit 20 is disposed at a position corresponding to each of the pixel 10E to the pixel 10H, the pixel 10I, and the pixel 10L.

The amplification transistor 21 of the pixel circuit 20 is disposed at a position corresponding to each of the pixel 10J and the pixel 10K.

The FD conversion gain switching transistor 23 of the pixel circuit 20 is disposed at a position corresponding to each of the pixel 10M and the pixel 10P.

The reset transistor 24 of the pixel circuit 20 is disposed at a position corresponding to each of the pixel 10N and the pixel 10O.

The unit pixels BP3 having such a configuration are sequentially arranged in a shape in line symmetry with each other in the arrow-X direction and the arrow-Y direction.

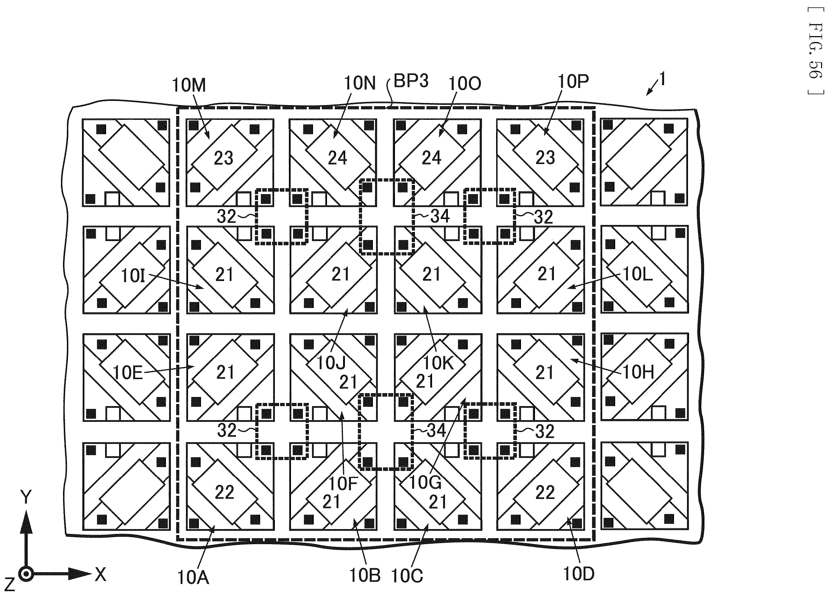

FIG. 56 illustrates an example of a specific planar configuration of the pixels 10 and the pixel circuits 20.

In the unit pixel BP3, the amplification transistor 21 of the pixel circuit 20 is disposed at the position corresponding to each of the pixel 10E to the pixel 10H, the pixel 10I, and the pixel 10L.

The solid-state imaging device 1 having such a configuration allows the main electrodes 204 of the amplification transistors 21 disposed at respective positions corresponding to the pixel 10B, the pixel 10C, the pixel 10F, and the pixel 10G to be gathered at one location. This enables the plurality of main electrodes 204 to be coupled to the power supply voltage terminal VDD through the shared coupling section 34 and the wiring 7.

In addition, the main electrodes 204 of the amplification transistors 21 disposed at respective positions corresponding to the pixel 10J and the pixel 10K and the main electrodes 204 of the reset transistors 24 disposed at respective positions corresponding to the pixel 10N and the pixel 10O are gathered at one location. This enables the plurality of main electrodes 204 to be coupled to the power supply voltage terminal VDD through the shared coupling section 34 and the wiring 7.

Components other than the above-described components are components the same or substantially the same as the components of the solid-state imaging device 1 according to the twelfth embodiment.

### [Workings and Effects]

The solid-state imaging device 1 according to the seventeenth embodiment makes it possible to achieve workings and effects similar to the workings and effects achievable by the solid-state imaging device 1 according to the twelfth embodiment.

### [Modification Example]

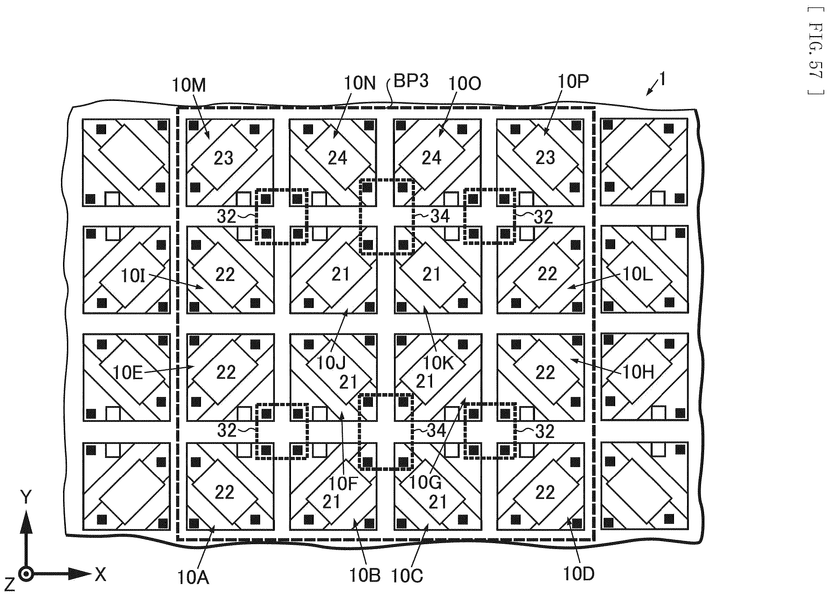

FIG. 57 illustrates an example of a specific planar configuration of the pixels 10 and the pixel circuits 20 of the solid-state imaging device 1 according to a modification example of the seventeenth embodiment.

In the unit pixel BP3 of the solid-state imaging device 1 according to the modification example, the selection transistor 22 of the pixel circuit 20 is disposed at a position corresponding to each of the pixel 10E, the pixel 10H, the pixel 10I, and the pixel 10L, as illustrated in FIG. 57. In addition, the amplification transistor 21 of the pixel circuit 20 is disposed at a position corresponding to each of the pixel 10F and the pixel 10G.

The solid-state imaging device 1 having such a configuration allows the main electrodes 204 of the amplification transistors 21 disposed at respective positions corresponding to the pixel 10B, the pixel 10C, the pixel 10F, and the pixel 10G to be gathered at one location. This enables the plurality of main electrodes 204 to be coupled to the power supply voltage terminal VDD through the shared coupling section 34 and the wiring 7.

In addition, the main electrodes 204 of the amplification transistors 21 disposed at respective positions corresponding to the pixel 10J and the pixel 10K and the main electrodes 204 of the reset transistors 24 disposed at respective positions corresponding to the pixel 10N and the pixel 10O are gathered at one location. This enables the plurality of main electrodes 204 to be coupled to the power supply voltage terminal VDD through the shared coupling section 34 and the wiring 7.

Components other than the above-described components are components the same or substantially the same as the components of the solid-state imaging device 1 according to the seventeenth embodiment.

### [Workings and Effects]

The solid-state imaging device 1 according to the modification example of the seventeenth embodiment makes it possible to achieve workings and effects similar to the workings and effects achievable by the solid-state imaging device 1 according to the seventeenth embodiment.

### < 18. Eighteenth Embodiment>

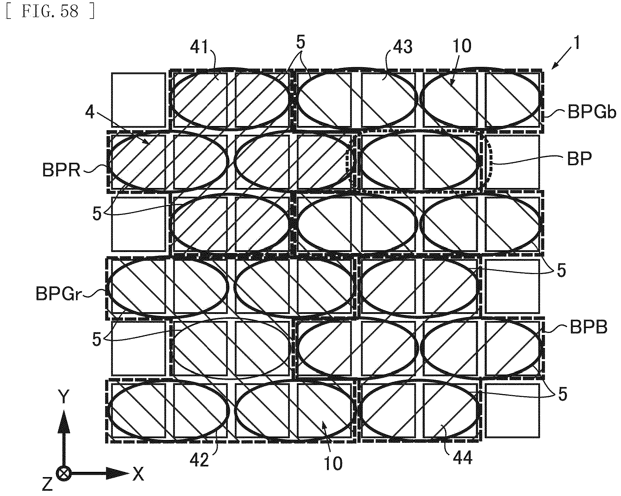

Description is given of the solid-state imaging device 1 according to the eighteenth embodiment of the present disclosure with reference to FIGs. 58 to 60.

### [Configuration of Solid-State Imaging Device 1]

### (1) Layout Configuration of Pixel 10 and Pixel Circuit 20 of Solid-State Imaging Device 1

FIG. 58 illustrates an example of a specific planar layout configuration of the pixels 10, the pixel circuits 20, a color filter 4, and optical lenses 5.

In the solid-state imaging device 1 according to the eighteenth embodiment, two pixels 10 configure the unit pixel BP. The two pixels 10 are adjacent to each other in the arrow-X direction, and share the FD region 25. The unit pixels BP are arranged in the arrow-X direction, and are arranged at a position of being adjacent to each other in the arrow-Y direction and being shifted by one pixel 10 in the arrow-X direction.

### (2) Layout Configuration of Pixel 10, Pixel Circuit 20, and Color Filter 4

The color filter 4 is disposed at the pixels 10. Although description using a vertical cross-section is omitted, the color filter 4 is disposed on the side of the first surface of the base 15.

In the eighteenth embodiment, the color filter 4 includes a red filter 41, a green filter 42, a green filter 43, and a blue filter 44.

In the color filter 4, each of the red filter 41 and the green filter 43 is alternately arranged in the arrow-X direction. Further, the green filter 42 is arranged to be adjacent to the red filter 41 in the arrow-Y direction and on a side opposite thereto. Furthermore, the blue filter 44 is arranged to be adjacent to the green filter 43 in the arrow-Y direction and on a side opposite thereto. That is, each of the green filter 42 and the blue filter 44 is alternately arranged in the arrow-X direction.

### (3) Planar Layout Configuration of Red Filter 41 and Blue Filter 44

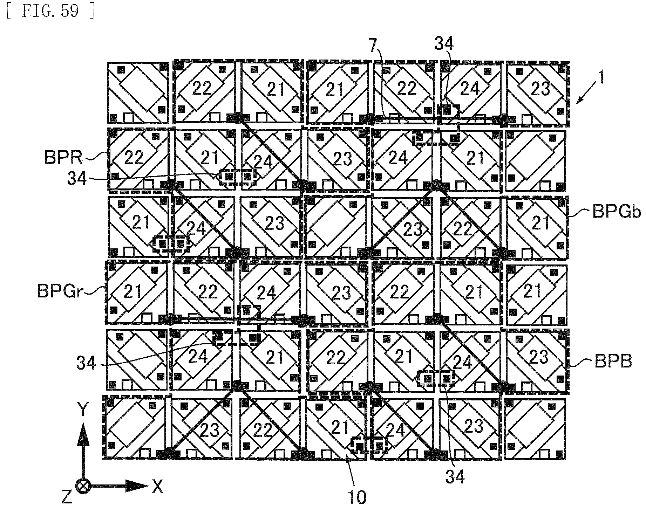

FIG. 59 illustrates an example of a planar layout configuration of the pixels 10 and the pixel circuits 20.

In the eighteenth embodiment, a total of eight pixels 10 are constructed as one unit pixel BPR, and the red filter 41 is disposed at the unit pixel BPR, as illustrated in FIGs. 58 and 59.

Here, in the eighteenth embodiment, the amplification transistor 21 is disposed at the position corresponding to the pixel 10A. The selection transistor 22 is disposed at the position corresponding to the pixel 10B. The FD conversion gain switching transistor 23 is disposed at the position corresponding to the pixel 10C. The reset transistor 24 is disposed at the position corresponding to the pixel 10D.

To give detailed description, the unit pixel BPR includes: the pixel 10D and the pixel 10C arranged to be adjacent to each other in the arrow-X direction; the pixel 10B, the pixel 10A, the pixel 10D, and the pixel 10C arranged to be adjacent thereto in the arrow-Y direction and to be adjacent to each other in the arrow-X direction; and the pixel 10B and the pixel 10A arranged to be adjacent thereto in the arrow-Y direction and to be adjacent to each other in the arrow-X direction.

Similarly, a total of eight pixels 10 are constructed as one unit pixel BPB, and the blue filter 44 is disposed at the unit pixel BPB.

The unit pixel BPB includes: the pixel 10D and the pixel 10C arranged to be adjacent to each other in the arrow-X direction; the pixel 10B, the pixel 10A, the pixel 10D, and the pixel 10C arranged to be adjacent thereto in the arrow-Y direction and to be adj acent to each other in the arrow-X direction; and the pixel 10B and the pixel 10A arranged to be adjacent thereto in the arrow-Y direction and to be adjacent to each other in the arrow-X direction.

### (4) Planar Layout Configuration of Green Filter 42 and Green Filter 43

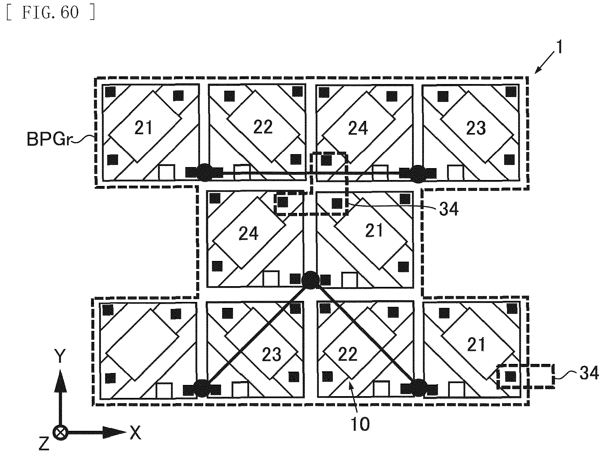

FIG. 60 illustrates an example of a planar layout configuration of the pixels 10 at which the green filter 43 is disposed.

In the eighteenth embodiment, a total of ten pixels 10 are constructed as one unit pixel BPGb, and the green filter 43 is disposed at the unit pixel BPGb, as illustrated in FIGs. 58 to 60.

The unit pixel BPGb includes: the pixel 10, the pixel 10C, the pixel 10B, and the pixel 10A arranged to be adjacent to each other in the arrow-X direction; the pixel 10D and the pixel 10A arranged to be adjacent thereto in the arrow-Y direction and to be adjacent to each other in the arrow-X direction; and the pixel 10A, the pixel 10B, the pixel 10D, and the pixel 10C arranged to be adjacent thereto in the arrow-Y direction and to be adjacent to each other in the arrow-X direction.

Similarly, a total of ten pixels 10 are constructed as one unit pixel BPGr, and the green filter 42 is disposed at the unit pixel BPGr.

The unit pixel BPGr includes the pixel 10, the pixel 10C, the pixel 10B, and the pixel 10A arranged to be adjacent to each other in the arrow-X direction; the pixel 10D and the pixel 10A arranged to be adjacent thereto in the arrow-Y direction and to be adjacent to each other in the arrow-X direction; and the pixel 10A, the pixel 10B, the pixel 10D, and the pixel 10C arranged to be adjacent thereto in the arrow-Y direction and to be adjacent to each other in the arrow-X direction.

### (5) Layout Configuration of Optical Lens 5

The optical lens 5 is disposed on the first surface of the base 15 with the color filter 4 interposed therebetween, as illustrated in FIG. 58. The optical lens 5 is formed to have a length corresponding to two pixels 10 in the arrow-X direction, and is formed to have a length corresponding to one pixel 10 in the arrow-Y direction. That is, the optical lens 5 is formed in an elliptical shape having a different aspect ratio in a plan view.

One optical lens 5 is disposed to correspond to each of the unit pixels BP.

### (6) Layout Configuration of Shared Coupling Section 34

In the unit pixel BPR, the respective main electrodes 204 of the amplification transistor 21 and the reset transistor 24 are shared by the shared coupling section 34 in the two pixels, i.e., the pixel 10A and the pixel 10D adjacent to each other in the arrow-X direction, as illustrated in FIG. 59.

Similarly, in the unit pixel BPB, the respective main electrodes 204 of the amplification transistor 21 and the reset transistor 24 are shared by the shared coupling section 34 in the two pixels, i.e., the pixel 10A and the pixel 10D adjacent to each other in the arrow-X direction.

The shared coupling section 34 is coupled through the wiring 7 to the power supply voltage terminal VDD.

Meanwhile, in the unit pixel BPGb, the respective main electrodes 204 of the amplification transistor 21 and the reset transistors 24 are shared by the shared coupling section 34 in the two pixels, i.e., the pixel 10D and the pixel 10A adjacent to each other in the arrow-X direction, and the one pixel, i.e., the pixel 10D adjacent thereto in the arrow-Y direction. That is, the shared coupling section 34 is disposed across a total of three pixels 10.

Similarly, in the unit pixel BPGr, the respective main electrodes 204 of the amplification transistor 21 and the reset transistors 24 are shared by the shared coupling section 34 in the two pixels, i.e., the pixel 10D and the pixel 10A adjacent to each other in the arrow-X direction, and the one pixel, i.e., the pixel 10D adjacent thereto in the arrow-Y direction.

The shared coupling section 34 is coupled through the wiring 7 to the power supply voltage terminal VDD.

Components other than the above-described components are components the same or substantially the same as the components of the solid-state imaging device 1 according to the twelfth embodiment.

### [Workings and Effects]

The solid-state imaging device 1 according to the eighteenth embodiment makes it possible to achieve workings and effects similar to the workings and effects achievable by the solid-state imaging device 1 according to the twelfth embodiment.

### <19. Example of Practical Application to Mobile Body>

A technique according to the present disclosure (the present technology) is applicable to various products. For example, the technique according to the present disclosure may be achieved as an apparatus to be mounted on any type of mobile body such as an automobile, an electric vehicle, a hybrid electric vehicle, a motorcycle, a bicycle, a personal mobility, an airplane, a drone, a vessel, or a robot.

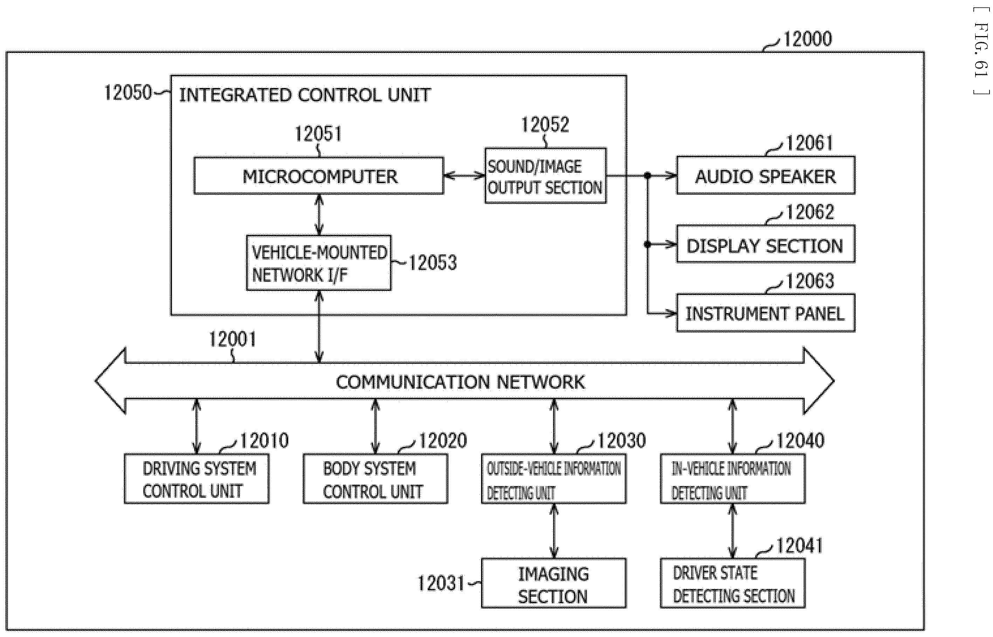

FIG. 61 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 61, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 61, an audio speaker 12061, a display section 12062, and an instrument panel 12063 are illustrated as the output device. The display section 12062 may, for example, include at least one of an on-board display and a head-up display.

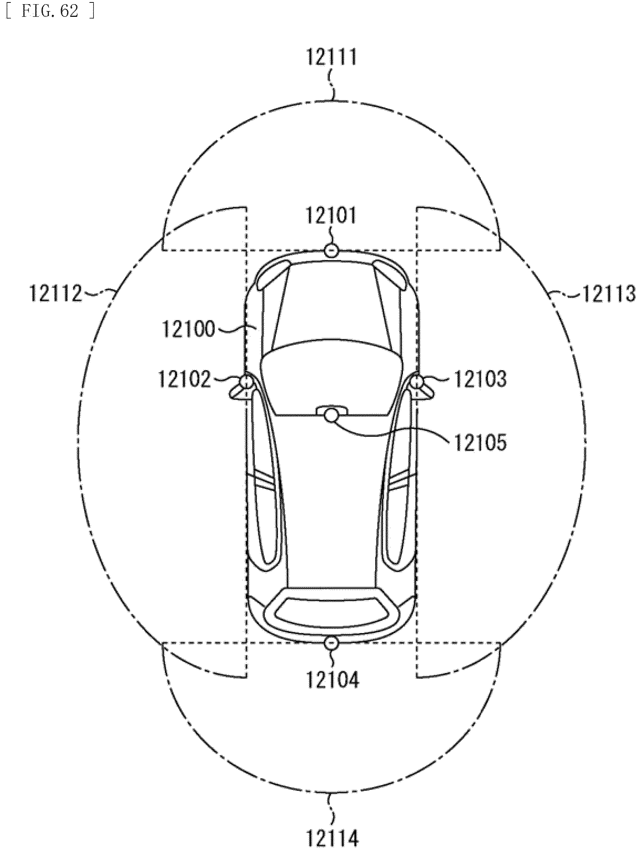

FIG. 62 is a diagram depicting an example of the installation position of the imaging section 12031.

In FIG. 62, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 62 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of an example of the vehicle control system to which the technique according to the present disclosure is applicable. The technique according to the present disclosure is applicable to the imaging section 12031, of the configurations described above. Applying the technique according to the present disclosure to the imaging section 12031 enables achievement of the imaging section 12031 having a simpler configuration.

### <20. Other Embodiments>

The present technology is not limited to the above-described embodiments, and may be modified in a variety of ways without departing from the gist thereof.

For example, solid-state imaging devices according to two or more embodiments may be combined among the solid-state imaging devices according to the first embodiment to the eighteenth embodiment described above.

Further, for example, it is possible to appropriately change the number of sets of the pixels constructing the unit pixel or an arrangement layout of the unit pixels in the solid-state imaging device according to the eighteenth embodiment, in the present technology.

Furthermore, it is possible to widely apply the present technology not only to an imaging application but also to a light receiving device, a photoelectric conversion device, a photodetector, or the like used for a sensing application or the like. Moreover, the solid-state imaging device may use not only incident light of visible light but also incident light of infrared light, ultraviolet light, electromagnetic waves, or the like. In addition, the present technology may have a configuration in which a band pass filter or the like is optionally provided above the photoelectric conversion element on the light incident side to receive desired incident light.

A solid-state imaging device according to a first embodiment of the present disclosure includes a first pixel, a pixel separation region, a first transistor, and a first floating diffusion region, a first transfer gate electrode, or a first base coupling section.

The first pixel includes a first photoelectric conversion element that is disposed on a side of a first surface of a base and that converts light into electric charge. The side of the first surface is a light incident side. The pixel separation region is formed in a thickness direction of the base. The pixel separation region extends in a first direction and a second direction intersecting the first direction to surround a periphery of a side surface of the first pixel as viewed from a side of a second surface of the base. The pixel separation region electrically and optically separates the first pixel from another region. The side of the second surface is a side opposite to the first surface. The first transistor is disposed on the second surface of the base at a position corresponding to the first pixel. The base has a periphery surrounded by the pixel separation region. The first transistor has a direction of a gate length being oblique to the first direction or the second direction. The first transistor processes the converted electric charge. The first floating diffusion region, the first transfer gate electrode, or the first base coupling section is disposed at the position corresponding to the first pixel, and is disposed in a direction of a gate width of the first transistor that is on the second surface of the base. The first transfer gate electrode is a gate electrode of a first transfer transistor that transfers the electric charge from the first pixel to the first floating diffusion region. The first base coupling section supplies the base with a voltage.

A solid-state imaging device according to a second embodiment of the present disclosure includes a first pixel, a pixel separation region, a first transistor, a second transistor, and a first floating diffusion region, a first transfer gate electrode, or a first base coupling section.

The first pixel includes a first photoelectric conversion element that is disposed on a side of a first surface of a base and that converts light into electric charge. The side of the first surface is a light incident side. The pixel separation region is formed in a thickness direction of the base. The pixel separation region extends in a first direction and a second direction intersecting the first direction to surround a periphery of a side surface of the first pixel as viewed from a side of a second surface of the base. The pixel separation region electrically and optically separates the first pixel from another region. The side of the second surface is a side opposite to the first surface. The first transistor is disposed on the second surface of the base at a position corresponding to the first pixel. The base has a periphery surrounded by the pixel separation region. The first transistor has a direction of a gate length being oblique to the first direction or the second direction. The first transistor processes the converted electric charge. The second transistor is disposed on the second surface of the base at the position corresponding to the first pixel. The base has the periphery surrounded by the pixel separation region. The second transistor has the direction of the gate length being oblique to the first direction or the second direction. The second transistor is electrically coupled in series to the first transistor. The first floating diffusion region, the first transfer gate electrode, or the first base coupling section is disposed at the position corresponding to the first pixel, and is disposed in a direction of a gate width of the first transistor and the second transistor that are on the second surface of the base. The first transfer gate electrode is a gate electrode of a first transfer transistor that transfers the electric charge from the first pixel to the first floating diffusion region. The first base coupling section supplies the base with a voltage.

A solid-state imaging device according to a third embodiment of the present disclosure includes a pixel, a pixel separation region, a transistor, and a floating diffusion region, a transfer gate electrode, or a first base coupling section.

A plurality of the pixels is each arranged to include a photoelectric conversion element that is disposed on a side of a first surface of a base and that converts light into electric charge. The side of the first surface is a light incident side. The pixel separation region is formed in a thickness direction of the base, and surrounds a periphery of a side surface of each of the plurality of the pixels. The pixel separation region electrically and optically separates the plurality of the pixels from each other. The transistor is disposed on a second surface of the base at a position corresponding to each of the pixels. The base has a periphery surrounded by the pixel separation region. The transfer has a direction of a gate length being oblique to an arrangement direction of the pixels. The transistor processes the converted electric charge. The floating diffusion region, the transfer gate electrode, or the first base coupling section is disposed at the position corresponding to each of the pixels, and is disposed in a direction of a gate width of the transistor that is on the second surface of the base. The transfer gate electrode is a gate electrode of a transfer transistor that transfers the electric charge from the pixel to the floating diffusion region. The first base coupling section supplies the base with a voltage.

A solid-state imaging device according to a fourth embodiment of the present disclosure includes a first pixel, a second pixel, a pixel separation region, a first transistor, a second transistor, and a shared coupling section.

The first pixel includes a first photoelectric conversion element that is disposed on a side of a first surface of a base and that converts light into electric charge. The side of the first surface is a light incident side. The second pixel is adjacent to the first pixel. The second pixel includes a second photoelectric conversion element that is disposed on the side of the first surface of the base and that converts light into electric charge. The pixel separation region is disposed between the first pixel and the second pixel, and is formed in a thickness direction of the base. The pixel separation region electrically and optically separates the first pixel and the second pixel from each other. The first transistor is disposed on a second surface of the base at a position corresponding to the first pixel. The first transistor has a direction of a gate length being oblique to an arrangement direction of the first pixel and the second pixel. The first transistor processes the converted electric charge. The second transistor is disposed on the second surface of the base at a position corresponding to the second pixel. The second transistor has the direction of the gate length being oblique to the arrangement direction of the first pixel and the second pixel. The second transistor processes the converted electric charge. The shared coupling section is electrically coupled directly to one of a pair of main electrodes of the first transistor and one of a pair of main electrodes of the second transistor. The shared coupling section supplies a power supply voltage to the one of the pair of main electrodes of the first transistor and the one of the pair of main electrodes of the second transistor.

The solid-state imaging devices according to the first embodiment to the fourth embodiment of the present disclosure make it possible to increase an area in which the transistor is disposed and improve performance of the transistor.

### <Configuration of Present Technology>

The present technology has the following configuration. According to the present technology of the following configuration, a solid-state imaging device makes it possible to increase an area in which a transistor is disposed and improve performance of the transistor.
(1) A solid-state imaging device including:
   a first pixel including a first photoelectric conversion element that is disposed on a side of a first surface of a base and converts light into electric charge, the side of the first surface being a light incident side;
   a pixel separation region formed in a thickness direction of the base, the pixel separation region extending in a first direction and a second direction intersecting the first direction to surround a periphery of a side surface of the first pixel as viewed from a side of a second surface of the base, the pixel separation region electrically and optically separating the first pixel from another region, the side of the second surface being a side opposite to the first surface;
   a first transistor disposed on the side of the second surface of the base at a position corresponding to the first pixel, the base having a periphery surrounded by the pixel separation region, the first transistor having a direction of a gate length being oblique to the first direction or the second direction; and
   a first floating diffusion region, a first transfer gate electrode, or a first base coupling section disposed at the position corresponding to the first pixel, the first floating diffusion region, the first transfer gate electrode, or the first base coupling section being disposed in a direction of a gate width of the first transistor that is on the side of the second surface of the base, the first transfer gate electrode being of a first transfer transistor that transfers the electric charge from the first pixel to the first floating diffusion region, the first base coupling section supplying the base with a voltage.
(2) The solid-state imaging device according to (1), in which the first floating diffusion region, the first transfer gate electrode, or the first base coupling section is disposed with respect to the first transistor with an element separation region interposed therebetween.
(3) The solid-state imaging device according to (2), in which the pixel separation region has a first trench formed from the second surface of the base to the side of the first surface of the base, and includes a first embedded member embedded in the first trench.
(4) The solid-state imaging device according to (3), in which the element separation region has a second trench formed from the second surface of the base to the side of the first surface of the base and having a depth shallower than a depth of the first trench, and includes a second embedded member embedded in the second trench.
(5) The solid-state imaging device according to any one of (1) to (4), in which
   the first pixel is partitioned by the pixel separation region, and is formed in a rectangular shape as viewed from the side of the second surface,
   a pair of main electrodes of the first transistor is disposed to coincide with a diagonal of the rectangular shape of the first pixel, and
   the first floating diffusion region, the first transfer gate electrode, or the first base coupling section is disposed to coincide with another diagonal intersecting the diagonal, or is disposed along the other diagonal.
(6) The solid-state imaging device according to any one of (1) to (5), in which the direction of the gate length of the first transistor is inclined at 45 degrees with respect to the first direction or the second direction.
(7) The solid-state imaging device according to any one of (1) to (5), further including:
   a second pixel adjacent to the first pixel in the first direction with the pixel separation region interposed therebetween, the second pixel including a second photoelectric conversion element that is disposed on the side of the first surface of the base and converts light into electric charge;
   a second transistor disposed on the side of the second surface of the base at a position corresponding to the second pixel, the base having the periphery surrounded by the pixel separation region, the second transistor being formed in a shape in line symmetry with the first transistor centering around the pixel separation region between the first pixel and the second pixel; and
   a second floating diffusion region, a second transfer gate electrode, or a second base coupling section formed at the position corresponding to the second pixel, the second floating diffusion region, the second transfer gate electrode, or the second base coupling section being formed in a shape in line symmetry with the first floating diffusion region, the first transfer gate electrode, or the first base coupling section centering around the pixel separation region between the first pixel and the second pixel, the second transfer gate electrode being of a second transfer transistor that transfers the electric charge from the second pixel to the second floating diffusion region, the second base coupling section supplying the base with the voltage.
(8) The solid-state imaging device according to (7), in which at least one of: one of a pair of main electrodes of the first transistor and one of a pair of main electrodes of the second transistor; the first floating diffusion region and the second floating diffusion region; or the first base coupling section and the second base coupling section is shared by a shared coupling section disposed across the pixel separation region and providing electrical and direct coupling therebetween.
(9) The solid-state imaging device according to (8), in which
   one end of the shared coupling section is directly coupled to a side surface of the one of the main electrodes of the first transistor, a side surface of the first floating diffusion region, or a side surface of the first base coupling section, and
   another end of the shared coupling section is directly coupled to a side surface of the one of the main electrodes of the second transistor, a side surface of the second floating diffusion region, or a side surface of the second base coupling section.
(10) The solid-state imaging device according to (8) or (9), in which the shared coupling section is embedded in a shared trench formed from the second surface of the pixel separation region toward the first surface of the pixel separation region.
(11) The solid-state imaging device according to (8), in which
   one end of the shared coupling section is directly coupled to a front surface of the one of the main electrodes of the first transistor, a front surface of the first floating diffusion region, or a front surface of the first base coupling section, and
   another end of the shared coupling section is directly coupled to a front surface of the one of the main electrodes of the second transistor, a front surface of the second floating diffusion region, or a front surface of the second base coupling section.
(12) The solid-state imaging device according to any one of (8) to (11), in which the shared coupling section includes a gate electrode material.
(13) The solid-state imaging device according to (7), further including:
   a third pixel adjacent to the first pixel in the second direction with the pixel separation region interposed therebetween, the third pixel including a third photoelectric conversion element that is disposed on the side of the first surface of the base and converts light into electric charge;
   a third transistor disposed on the side of the second surface of the base at a position corresponding to the third pixel, the base having the periphery surrounded by the pixel separation region, the third transistor being formed in a shape in line symmetry with the first transistor centering around the pixel separation region between the first pixel and the third pixel; and
   a third floating diffusion region, a third transfer gate electrode, or a third base coupling section formed at the position corresponding to the third pixel, the third floating diffusion region, the third transfer gate electrode, or the third base coupling section being formed in a shape in line symmetry with the first floating diffusion region, the first transfer gate electrode, or the first base coupling section centering around the pixel separation region between the first pixel and the third pixel, the third transfer gate electrode being of a third transfer transistor that transfers the electric charge from the third pixel to the third floating diffusion region, the third base coupling section supplying the base with the voltage.
(14) The solid-state imaging device according to (7) or (13), further including:
   a fourth pixel adjacent to the third pixel in the first direction with the pixel separation region interposed therebetween, the fourth pixel including a fourth photoelectric conversion element that is disposed on the side of the first surface of the base and converts light into electric charge;
   a fourth transistor disposed on the side of the second surface of the base at a position corresponding to the fourth pixel, the base having the periphery surrounded by the pixel separation region, the fourth transistor being formed in a shape in line symmetry with the third transistor centering around the pixel separation region between the third pixel and the fourth pixel; and
   a fourth floating diffusion region, a fourth transfer gate electrode, or a fourth base coupling section formed at the position corresponding to the fourth pixel, the fourth floating diffusion region, the fourth transfer gate electrode, or the fourth base coupling section being formed in a shape in line symmetry with the third floating diffusion region, the third transfer gate electrode, or the third base coupling section centering around the pixel separation region between the third pixel and the fourth pixel, the fourth transfer gate electrode being of a fourth transfer transistor that transfers the electric charge from the fourth pixel to the fourth floating diffusion region, the fourth base coupling section supplying the base with the voltage.
(15) The solid-state imaging device according to (14), in which the first transistor, the second transistor, the third transistor, and the fourth transistor each include one of an amplification transistor, a selection transistor, a floating diffusion conversion gain switching transistor, or a reset transistor, the amplification transistor, the selection transistor, the floating diffusion conversion gain switching transistor, and the reset transistor constructing a pixel circuit.
(16) The solid-state imaging device according to (7), in which the first transistor and the second transistor include amplification transistors electrically coupled in parallel to each other and constructing a pixel circuit.
(17) The solid-state imaging device according to (1), further including:
   a second pixel adjacent to the first pixel in the first direction with the pixel separation region interposed therebetween, the second pixel including a second photoelectric conversion element that is disposed on the side of the first surface of the base and converts light into electric charge;
   a second transistor disposed on the side of the second surface of the base at a position corresponding to the second pixel, the base having the periphery surrounded by the pixel separation region, the second transistor being formed in the same shape as the first transistor; and
   a second floating diffusion region, a second transfer gate electrode, or a second base coupling section formed at the position corresponding to the second pixel, the second floating diffusion region, the second transfer gate electrode, or the second base coupling section being formed in the same shape as the first floating diffusion region, the first transfer gate electrode, or the first base coupling section, the second transfer gate electrode being of a second transfer transistor that transfers the electric charge from the second pixel to the second floating diffusion region, the second base coupling section supplying the base with the voltage.
(18) The solid-state imaging device according to (15), in which at least one of the first transistor, the second transistor, the third transistor, or the fourth transistor has a fin structure in which ends of a gate electrode in the direction of the gate width are extended from the second surface of the base to the side of the first surface of the base.
(19) The solid-state imaging device according to any one of (1) to (18), in which
   a planar shape of the first transfer gate electrode as viewed from the side of the second surface is a circular shape, an elliptical shape, a triangular shape, a rectangular shape, or a polygonal shape having five or more corners, and
   a plurality of the first transfer gate electrodes is disposed.
(20) The solid-state imaging device according to (2), in which the element separation region includes a semiconductor region formed to be of the same electrically conductive type as the base and having higher impurity density than impurity density of the base.
(21) A solid-state imaging device including:
   a first pixel including a first photoelectric conversion element that is disposed on a side of a first surface of a base and converts light into electric charge, the side of the first surface being a light incident side;
   a pixel separation region formed in a thickness direction of the base, the pixel separation region extending in a first direction and a second direction intersecting the first direction to surround a periphery of a side surface of the first pixel as viewed from a side of a second surface of the base, the pixel separation region electrically and optically separating the first pixel from another region, the side of the second surface being a side opposite to the first surface;
   a first transistor disposed on the side of the second surface of the base at a position corresponding to the first pixel, the base having a periphery surrounded by the pixel separation region, the first transistor having a direction of a gate length being oblique to the first direction or the second direction;
   a second transistor disposed on the side of the second surface of the base at the position corresponding to the first pixel, the base having the periphery surrounded by the pixel separation region, the second transistor having a direction of a gate length being oblique to the first direction or the second direction, the second transistor being electrically coupled in series to the first transistor; and
   a first floating diffusion region, a first transfer gate electrode, or a first base coupling section disposed at the position corresponding to the first pixel, the first floating diffusion region, the first transfer gate electrode, or the first base coupling section being disposed in a direction of a gate width of the first transistor and the second transistor that are on the side of the second surface of the base, the first transfer gate electrode being of a first transfer transistor that transfers the electric charge from the first pixel to the first floating diffusion region, the first base coupling section supplying the base with a voltage.
(22) A solid-state imaging device including:
   a plurality of pixels each arranged to include a photoelectric conversion element that is disposed on a side of a first surface of a base and converts light into electric charge, the side of the first surface being a light incident side;
   a pixel separation region formed in a thickness direction of the base and surrounding a periphery of a side surface of each of the plurality of pixels, the pixel separation region electrically and optically separating the plurality of pixels from each other;
   a transistor disposed on a side of the second surface of the base at a position corresponding to each of the pixels, the base having a periphery surrounded by the pixel separation region, the transistor having a direction of a gate length being oblique to an arrangement direction of the pixels; and
   a floating diffusion region, a transfer gate electrode, or a first base coupling section disposed at the position corresponding to each of the pixels, the floating diffusion region, the transfer gate electrode, or the first base coupling section being disposed in a direction of a gate width of the transistor that is on the side of the second surface of the base, the transfer gate electrode being of a transfer transistor that transfers the electric charge from each of the pixels to the floating diffusion region, the first base coupling section supplying the base with a voltage.
(23) A solid-state imaging device including:
   a first pixel including a first photoelectric conversion element that is disposed on a side of a first surface of a base and converts light into electric charge, the side of the first surface being a light incident side;
   a second pixel being adjacent to the first pixel, and including a second photoelectric conversion element that is disposed on the side of the first surface of the base and converts light into electric charge;
   a pixel separation region disposed between the first pixel and the second pixel, and formed in a thickness direction of the base, the pixel separation region electrically and optically separating the first pixel and the second pixel from each other;
   a first transistor disposed on a side of the second surface of the base at a position corresponding to the first pixel, the first transistor having a direction of a gate length being oblique to an arrangement direction of the first pixel and the second pixel;
   a second transistor disposed on the side of the second surface of the base at a position corresponding to the second pixel, the second transistor having a direction of a gate length being oblique to the arrangement direction of the first pixel and the second pixel; and
   a shared coupling section electrically coupled directly to one of a pair of main electrodes of the first transistor and one of a pair of main electrodes of the second transistor, the shared coupling section supplying a power supply voltage to the one of the pair of main electrodes of the first transistor and the one of the pair of main electrodes of the second transistor.
(24) The solid-state imaging device according to (23), in which
   one end of the shared coupling section is coupled to a side surface of the one of the main electrodes of the first transistor, and
   another end of the shared coupling section is coupled to a side surface of the one of the main electrodes of the second transistor.
(25) The solid-state imaging device according to (23) or (24), in which the shared coupling section is embedded in a shared trench formed from the second surface of the pixel separation region toward the first surface of the pixel separation region.
(26) The solid-state imaging device according to (23), in which
   one end of the shared coupling section is coupled to a front surface of the one of the main electrodes of the first transistor, and
   another end of the shared coupling section is coupled to a front surface of the one of the main electrodes of the second transistor.
(27) The solid-state imaging device according to any one of (23) to (26), in which
   the second transistor is formed in a shape in line symmetry with the first transistor centering around the pixel separation region between the first pixel and the second pixel, and
   the one of the main electrodes of the first transistor and the one of the main electrodes of the second transistor are closer to each other than another one of the main electrodes of the first transistor and another one of the main electrodes of the second transistor are, and the one of the main electrodes of the first transistor and the one of the main electrodes of the second transistor are coupled to each other through the shared coupling section.
(28) The solid-state imaging device according to any one of (23) to (27), in which the first transistor and the second transistor respectively include an amplification transistor and a reset transistor, the amplification transistor and the reset transistor constructing a pixel circuit.
(29) The solid-state imaging device according to any one of (23) to (28), further including:
   a third pixel being adjacent to the first pixel or the second pixel, and including a third photoelectric conversion element that is disposed on the side of the first surface of the base and converts light into electric charge;
   the pixel separation region disposed between the third pixel and the first pixel or the second pixel; and
   a third transistor disposed on the side of the second surface of the base at a position corresponding to the third pixel, the third transistor having a direction of a gate length being oblique to the arrangement direction of the first pixel and the second pixel, in which
   the shared coupling section is electrically coupled directly to the one of the main electrodes of the first transistor, the one of the main electrodes of the second transistor, and one of a pair of main electrodes of the third transistor, the shared coupling section supplying the power supply voltage to the one of the main electrodes of the first transistor, the one of the main electrodes of the second transistor, and the one of the pair of main electrodes of the third transistor.
(30) The solid-state imaging device according to any one of (7) to (11) and (23) to (29), in which another one of a plurality of the first pixels and another one of a plurality of the second pixels adjacent to one of the plurality of the first pixels and one of the plurality of the second pixels in a direction intersecting an arrangement direction of the one of the plurality of the first pixels and the one of the plurality of the second pixels are arranged to be shifted by one pixel in the arrangement direction with respect to the one of the plurality of the first pixels and the one of the plurality of the second pixels.

The present application claims the benefit of Japanese Priority Patent Application JP2022-020875 filed with the Japan Patent Office on February 14, 2022, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A solid-state imaging device comprising:
a first pixel including a first photoelectric conversion element that is disposed on a side of a first surface of a base and converts light into electric charge, the side of the first surface being a light incident side;
a pixel separation region formed in a thickness direction of the base, the pixel separation region extending in a first direction and a second direction intersecting the first direction to surround a periphery of a side surface of the first pixel as viewed from a side of a second surface of the base, the pixel separation region electrically and optically separating the first pixel from another region, the side of the second surface being a side opposite to the first surface;
a first transistor disposed on the side of the second surface of the base at a position corresponding to the first pixel, the base having a periphery surrounded by the pixel separation region, the first transistor having a direction of a gate length being oblique to the first direction or the second direction; and
a first floating diffusion region, a first transfer gate electrode, or a first base coupling section disposed at the position corresponding to the first pixel, the first floating diffusion region, the first transfer gate electrode, or the first base coupling section being disposed in a direction of a gate width of the first transistor that is on the side of the second surface of the base, the first transfer gate electrode being of a first transfer transistor that transfers the electric charge from the first pixel to the first floating diffusion region, the first base coupling section supplying the base with a voltage.

2. The solid-state imaging device according to claim 1, wherein the first floating diffusion region, the first transfer gate electrode, or the first base coupling section is disposed with respect to the first transistor with an element separation region interposed therebetween.

3. The solid-state imaging device according to claim 2, wherein the pixel separation region has a first trench formed from the second surface of the base to the side of the first surface of the base, and includes a first embedded member embedded in the first trench.

4. The solid-state imaging device according to claim 3, wherein the element separation region has a second trench formed from the second surface of the base to the side of the first surface of the base and having a depth shallower than a depth of the first trench, and includes a second embedded member embedded in the second trench.

5. The solid-state imaging device according to claim 1, wherein
the first pixel is partitioned by the pixel separation region, and is formed in a rectangular shape as viewed from the side of the second surface,
a pair of main electrodes of the first transistor is disposed to coincide with a diagonal of the rectangular shape of the first pixel, and
the first floating diffusion region, the first transfer gate electrode, or the first base coupling section is disposed to coincide with another diagonal intersecting the diagonal, or is disposed along the other diagonal.

6. The solid-state imaging device according to claim 1, wherein the direction of the gate length of the first transistor is inclined at 45 degrees with respect to the first direction or the second direction.

7. The solid-state imaging device according to claim 1, further comprising:
a second pixel adjacent to the first pixel in the first direction with the pixel separation region interposed therebetween, the second pixel including a second photoelectric conversion element that is disposed on the side of the first surface of the base and converts light into electric charge;
a second transistor disposed on the side of the second surface of the base at a position corresponding to the second pixel, the base having the periphery surrounded by the pixel separation region, the second transistor being formed in a shape in line symmetry with the first transistor centering around the pixel separation region between the first pixel and the second pixel; and
a second floating diffusion region, a second transfer gate electrode, or a second base coupling section formed at the position corresponding to the second pixel, the second floating diffusion region, the second transfer gate electrode, or the second base coupling section being formed in a shape in line symmetry with the first floating diffusion region, the first transfer gate electrode, or the first base coupling section centering around the pixel separation region between the first pixel and the second pixel, the second transfer gate electrode being of a second transfer transistor that transfers the electric charge from the second pixel to the second floating diffusion region, the second base coupling section supplying the base with the voltage.

8. The solid-state imaging device according to claim 7, wherein at least one of: one of a pair of main electrodes of the first transistor and one of a pair of main electrodes of the second transistor; the first floating diffusion region and the second floating diffusion region; or the first base coupling section and the second base coupling section is shared by a shared coupling section disposed across the pixel separation region and providing electrical and direct coupling therebetween.

9. The solid-state imaging device according to claim 8, wherein
one end of the shared coupling section is directly coupled to a side surface of the one of the main electrodes of the first transistor, a side surface of the first floating diffusion region, or a side surface of the first base coupling section, and
another end of the shared coupling section is directly coupled to a side surface of the one of the main electrodes of the second transistor, a side surface of the second floating diffusion region, or a side surface of the second base coupling section.

10. The solid-state imaging device according to claim 9, wherein the shared coupling section is embedded in a shared trench formed from the second surface of the pixel separation region toward the first surface of the pixel separation region.

11. The solid-state imaging device according to claim 8, wherein
one end of the shared coupling section is directly coupled to a front surface of the one of the main electrodes of the first transistor, a front surface of the first floating diffusion region, or a front surface of the first base coupling section, and
another end of the shared coupling section is directly coupled to a front surface of the one of the main electrodes of the second transistor, a front surface of the second floating diffusion region, or a front surface of the second base coupling section.

12. The solid-state imaging device according to claim 8, wherein the shared coupling section includes a gate electrode material.

13. The solid-state imaging device according to claim 7, further comprising:
a third pixel adjacent to the first pixel in the second direction with the pixel separation region interposed therebetween, the third pixel including a third photoelectric conversion element that is disposed on the side of the first surface of the base and converts light into electric charge;
a third transistor disposed on the side of the second surface of the base at a position corresponding to the third pixel, the base having the periphery surrounded by the pixel separation region, the third transistor being formed in a shape in line symmetry with the first transistor centering around the pixel separation region between the first pixel and the third pixel; and
a third floating diffusion region, a third transfer gate electrode, or a third base coupling section formed at the position corresponding to the third pixel, the third floating diffusion region, the third transfer gate electrode, or the third base coupling section being formed in a shape in line symmetry with the first floating diffusion region, the first transfer gate electrode, or the first base coupling section centering around the pixel separation region between the first pixel and the third pixel, the third transfer gate electrode being of a third transfer transistor that transfers the electric charge from the third pixel to the third floating diffusion region, the third base coupling section supplying the base with the voltage.

14. The solid-state imaging device according to claim 13, further comprising:
a fourth pixel adjacent to the third pixel in the first direction with the pixel separation region interposed therebetween, the fourth pixel including a fourth photoelectric conversion element that is disposed on the side of the first surface of the base and converts light into electric charge;
a fourth transistor disposed on the side of the second surface of the base at a position corresponding to the fourth pixel, the base having the periphery surrounded by the pixel separation region, the fourth transistor being formed in a shape in line symmetry with the third transistor centering around the pixel separation region between the third pixel and the fourth pixel; and
a fourth floating diffusion region, a fourth transfer gate electrode, or a fourth base coupling section formed at the position corresponding to the fourth pixel, the fourth floating diffusion region, the fourth transfer gate electrode, or the fourth base coupling section being formed in a shape in line symmetry with the third floating diffusion region, the third transfer gate electrode, or the third base coupling section centering around the pixel separation region between the third pixel and the fourth pixel, the fourth transfer gate electrode being of a fourth transfer transistor that transfers the electric charge from the fourth pixel to the fourth floating diffusion region, the fourth base coupling section supplying the base with the voltage.

15. The solid-state imaging device according to claim 14, wherein the first transistor, the second transistor, the third transistor, and the fourth transistor each comprise one of an amplification transistor, a selection transistor, a floating diffusion conversion gain switching transistor, or a reset transistor, the amplification transistor, the selection transistor, the floating diffusion conversion gain switching transistor, and the reset transistor constructing a pixel circuit.

16. The solid-state imaging device according to claim 7, wherein the first transistor and the second transistor comprise amplification transistors electrically coupled in parallel to each other and constructing a pixel circuit.

17. The solid-state imaging device according to claim 1, further comprising:
a second pixel adjacent to the first pixel in the first direction with the pixel separation region interposed therebetween, the second pixel including a second photoelectric conversion element that is disposed on the side of the first surface of the base and converts light into electric charge;
a second transistor disposed on the side of the second surface of the base at a position corresponding to the second pixel, the base having the periphery surrounded by the pixel separation region, the second transistor being formed in a same shape as the first transistor; and
a second floating diffusion region, a second transfer gate electrode, or a second base coupling section formed at the position corresponding to the second pixel, the second floating diffusion region, the second transfer gate electrode, or the second base coupling section being formed in a same shape as the first floating diffusion region, the first transfer gate electrode, or the first base coupling section, the second transfer gate electrode being of a second transfer transistor that transfers the electric charge from the second pixel to the second floating diffusion region, the second base coupling section supplying the base with the voltage.

18. The solid-state imaging device according to claim 15, wherein at least one of the first transistor, the second transistor, the third transistor, or the fourth transistor has a fin structure in which ends of a gate electrode in the direction of the gate width are extended from the second surface of the base to the side of the first surface of the base.

19. The solid-state imaging device according to claim 1, wherein
a planar shape of the first transfer gate electrode as viewed from the side of the second surface is a circular shape, an elliptical shape, a triangular shape, a rectangular shape, or a polygonal shape having five or more corners, and
a plurality of the first transfer gate electrodes is disposed.

20. The solid-state imaging device according to claim 2, wherein the element separation region comprises a semiconductor region formed to be of a same electrically conductive type as the base and having higher impurity density than impurity density of the base.

21. A solid-state imaging device comprising:
a first pixel including a first photoelectric conversion element that is disposed on a side of a first surface of a base and converts light into electric charge, the side of the first surface being a light incident side;
a pixel separation region formed in a thickness direction of the base, the pixel separation region extending in a first direction and a second direction intersecting the first direction to surround a periphery of a side surface of the first pixel as viewed from a side of a second surface of the base, the pixel separation region electrically and optically separating the first pixel from another region, the side of the second surface being a side opposite to the first surface;
a first transistor disposed on the side of the second surface of the base at a position corresponding to the first pixel, the base having a periphery surrounded by the pixel separation region, the first transistor having a direction of a gate length being oblique to the first direction or the second direction;
a second transistor disposed on the side of the second surface of the base at the position corresponding to the first pixel, the base having the periphery surrounded by the pixel separation region, the second transistor having a direction of a gate length being oblique to the first direction or the second direction, the second transistor being electrically coupled in series to the first transistor; and
a first floating diffusion region, a first transfer gate electrode, or a first base coupling section disposed at the position corresponding to the first pixel, the first floating diffusion region, the first transfer gate electrode, or the first base coupling section being disposed in a direction of a gate width of the first transistor and the second transistor that are on the side of the second surface of the base, the first transfer gate electrode being of a first transfer transistor that transfers the electric charge from the first pixel to the first floating diffusion region, the first base coupling section supplying the base with a voltage.

22. A solid-state imaging device comprising:
a plurality of pixels each arranged to include a photoelectric conversion element that is disposed on a side of a first surface of a base and converts light into electric charge, the side of the first surface being a light incident side;
a pixel separation region formed in a thickness direction of the base and surrounding a periphery of a side surface of each of the plurality of pixels, the pixel separation region electrically and optically separating the plurality of pixels from each other;
a transistor disposed on a side of the second surface of the base at a position corresponding to each of the pixels, the base having a periphery surrounded by the pixel separation region, the transistor having a direction of a gate length being oblique to an arrangement direction of the pixels; and
a floating diffusion region, a transfer gate electrode, or a first base coupling section disposed at the position corresponding to each of the pixels, the floating diffusion region, the transfer gate electrode, or the first base coupling section being disposed in a direction of a gate width of the transistor that is on the side of the second surface of the base, the transfer gate electrode being of a transfer transistor that transfers the electric charge from each of the pixels to the floating diffusion region, the first base coupling section supplying the base with a voltage.

23. A solid-state imaging device comprising:
a first pixel including a first photoelectric conversion element that is disposed on a side of a first surface of a base and converts light into electric charge, the side of the first surface being a light incident side;
a second pixel being adjacent to the first pixel, and including a second photoelectric conversion element that is disposed on the side of the first surface of the base and converts light into electric charge;
a pixel separation region disposed between the first pixel and the second pixel, and formed in a thickness direction of the base, the pixel separation region electrically and optically separating the first pixel and the second pixel from each other;
a first transistor disposed on a side of the second surface of the base at a position corresponding to the first pixel, the first transistor having a direction of a gate length being oblique to an arrangement direction of the first pixel and the second pixel;
a second transistor disposed on the side of the second surface of the base at a position corresponding to the second pixel, the second transistor having a direction of a gate length being oblique to the arrangement direction of the first pixel and the second pixel; and
a shared coupling section electrically coupled directly to one of a pair of main electrodes of the first transistor and one of a pair of main electrodes of the second transistor, the shared coupling section supplying a power supply voltage to the one of the pair of main electrodes of the first transistor and the one of the pair of main electrodes of the second transistor.

24. The solid-state imaging device according to claim 23, wherein
one end of the shared coupling section is coupled to a side surface of the one of the main electrodes of the first transistor, and
another end of the shared coupling section is coupled to a side surface of the one of the main electrodes of the second transistor.

25. The solid-state imaging device according to claim 24, wherein the shared coupling section is embedded in a shared trench formed from the second surface of the pixel separation region toward the first surface of the pixel separation region.

26. The solid-state imaging device according to claim 23, wherein
one end of the shared coupling section is coupled to a front surface of the one of the main electrodes of the first transistor, and
another end of the shared coupling section is coupled to a front surface of the one of the main electrodes of the second transistor.

27. The solid-state imaging device according to claim 23, wherein
the second transistor is formed in a shape in line symmetry with the first transistor centering around the pixel separation region between the first pixel and the second pixel, and
the one of the main electrodes of the first transistor and the one of the main electrodes of the second transistor are closer to each other than another one of the main electrodes of the first transistor and another one of the main electrodes of the second transistor are, and the one of the main electrodes of the first transistor and the one of the main electrodes of the second transistor are coupled to each other through the shared coupling section.

28. The solid-state imaging device according to claim 23, wherein the first transistor and the second transistor respectively comprise an amplification transistor and a reset transistor, the amplification transistor and the reset transistor constructing a pixel circuit.

29. The solid-state imaging device according to claim 23, further comprising:
a third pixel being adjacent to the first pixel or the second pixel, and including a third photoelectric conversion element that is disposed on the side of the first surface of the base and converts light into electric charge;
the pixel separation region disposed between the third pixel and the first pixel or the second pixel; and
a third transistor disposed on the side of the second surface of the base at a position corresponding to the third pixel, the third transistor having a direction of a gate length being oblique to the arrangement direction of the first pixel and the second pixel, wherein
the shared coupling section is electrically coupled directly to the one of the main electrodes of the first transistor, the one of the main electrodes of the second transistor, and one of a pair of main electrodes of the third transistor, the shared coupling section supplying the power supply voltage to the one of the main electrodes of the first transistor, the one of the main electrodes of the second transistor, and the one of the pair of main electrodes of the third transistor.

30. The solid-state imaging device according to claim 7, wherein another one of a plurality of the first pixels and another one of a plurality of the second pixels adjacent to one of the plurality of the first pixels and one of the plurality of the second pixels in a direction intersecting an arrangement direction of the one of the plurality of the first pixels and the one of the plurality of the second pixels are arranged to be shifted by one pixel in the arrangement direction with respect to the one of the plurality of the first pixels and the one of the plurality of the second pixels.
